(19) Europäisches Patentamt
European Patent Office
Office européen des brevets

(11) EP 2 674 442 A2

(12) **EUROPEAN PATENT APPLICATION**

(43) Date of publication:
**18.12.2013 Bulletin 2013/51**

(51) Int Cl.:
***C08F 214/18*** *(2006.01)* ***G02B 1/11*** *(2006.01)*
***H01L 51/52*** *(2006.01)*

(21) Application number: **13171611.0**

(22) Date of filing: **12.06.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.06.2012 JP 2012132439**

(71) Applicants:
- **Toyo Ink SC Holdings Co., Ltd.**
  **Chuo-ku, Tokyo 104-8377 (JP)**
- **Toyocolor Co., Ltd.**
  **Chuo-ku, Tokyo 104-8381 (JP)**

(72) Inventors:
- **Kida, Kana**
  **TOKYO 104-8377 (JP)**
- **Iwata, Tohru**
  **TOKYO 104-8377 (JP)**
- **Chisaka, Jiro**
  **TOKYO 104-8377 (JP)**
- **Hirano, Akira**
  **Tokyo 104-8381 (JP)**
- **Kondo, Keiichi**
  **Tokyo 104-8381 (JP)**

(74) Representative: **Regimbeau**
**20, rue de Chazelles**
**75847 Paris Cedex 17 (FR)**

(54) **Resin composition for light scattering layer, light scattering layer, and organic electroluminescence device**

(57) Provided is a resin composition for light scattering layer for use in forming a light scattering layer of an organic EL device, including: a binder composition including at least one type of resin (A); and light scattering particles (B). In a resin composition for light scattering layer of the invention, the light scattering particles (B) have an average particle diameter of 200 nm to 500 nm in the resin composition and have a content of 20 vol% or less of particles with a particle diameter of 600 nm or more with respect to a total amount of the light scattering particles (B); and a refractive index difference between the binder composition and the light scattering particles (B) is 0.1 or more.

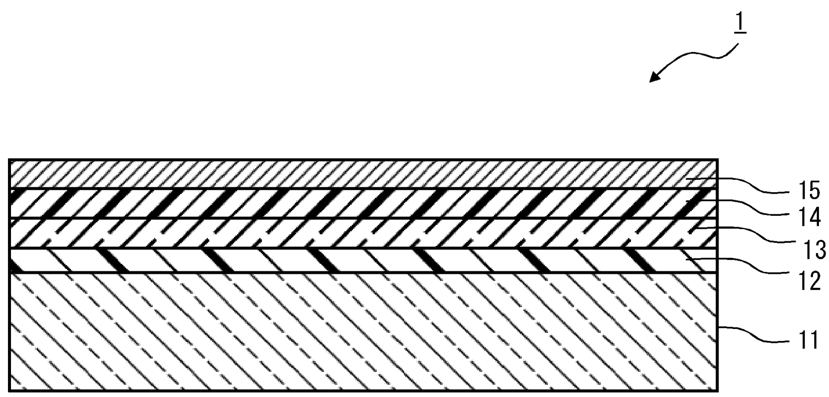


Fig. 1

EP 2 674 442 A2

## Description

INCORPORATION BY REFERENCE

This application is based upon and claims the benefit of priority from Japanese patent application No. 2012-132439, filed on June 12th, 2012, the disclosure of which is incorporated herein in its entirety by reference.

BACKGROUND OF THE INVENTION

1. Field of the Invention

The present invention relates to a resin composition for light scattering layer, which is used to improve the luminous efficiency of an organic electroluminescence (hereinafter referred to also as "EL") device, a light scattering layer formed of the resin composition for light scattering layer, and an organic EL device including the light scattering layer.

2. Description of Related Art

An organic EL device is a spontaneous light emitting element which utilizes the principle that a fluorescent substance or the like emits light by energy of recombination of holes injected from an anode and electrons injected from a cathode when an electric field is applied. In recent years, the organic EL device has been actively studied and developed in applications for lighting devices, display devices, and the like.

The term "organic EL device" herein described refers to general devices using organic EL devices such as an organic EL lighting device and an organic EL display device.

For example, as compared with a CRT and an LCD of related art, the organic EL display device has advantages in terms of visibility and view angle, and has excellent features such as weight saving, thinning of layers, and flexibility. However, in general, the refractive index of an organic layer including a luminous layer is 1.6 to 2.1 which is higher than that of the air. For this reason, total reflection or interference is liable to occur at an interface of emitted light, and the light extraction efficiency is less than 20%, and thus most light is lost.

The organic EL device has a basic structure in which a translucent electrode, at least one organic layer including a luminous layer, and a back electrode are sequentially laminated on a translucent substrate.

In an active matrix type organic EL device, for example, a TFT substrate on which a plurality of pixel electrodes constituting the above-mentioned back electrode and TFTs (thin-film transistors) serving as switching elements are formed in a matrix shape is laminated on the above-mentioned organic layer.

Light emitted from the organic layer is output directly, or by being reflected by the back electrode formed of aluminum or the like, from the translucent substrate. In this case, it is preferable to efficiently extract the generated light to the translucent substrate side. However, the light is totally reflected depending on an incident angle to an interface between adjacent layers having different refractive indexes, and the light becomes guided light which travels while being totally reflected in a plane direction within the element. Then, the light is absorbed inside the element and attenuates, which makes it difficult to extract the light to the outside. The ratio of this guided light is determined by relative refractive indexes of adjacent layers. In the case of a general organic EL device, the relation of refractive indexes n is expressed as, for example, air (n=1.0)/translucent substrate (n=1.5)/translucent electrode (n=2.0)/organic layer (n=1.7)/back electrode. In this case, the ratio of light which is guided within the element without being emitted to the air is about 81%. This indicates that only about 19% of the total amount of luminescence can be effectively used.

As a method for improving the light extraction efficiency, formation of a light scattering layer is proposed (for example, see Japanese Unexamined Patent Application Publication Nos. 2004-296429, 2005-190931, and 2009-110930). Japanese Unexamined Patent Application Publication No. 2004-296429 discloses an EL device having a configuration in which a translucent layer having a refractive index equal to or greater than that of a luminous layer is formed on a light extraction surface of a translucent electrode, and a light scattering layer is substantially formed adjacent to the light extraction surface of the translucent layer, or inside the translucent layer. Japanese Unexamined Patent Application Publication Nos. 2005-190931 and 2009-110930 provide a number of proposals on the features such as characteristics of light scattering particles of a light scattering layer, a refractive index difference between a light scattering particle and a binder composition, and a refractive index of a binder composition.

Depending on the intended use, such as a use for a lighting device or a display device, for example, various organic EL devices are used, such as an organic EL device using a luminous layer that emits white light, an organic EL device using a luminous layer of one type that emits light of a specific color such as blue, and an organic EL device using a plurality of types of luminous layers that emit light of different colors such as three primary colors. However, in general, the ratio of improvement in light extraction by the light scattering layer depends on a wavelength. Accordingly, the above-mentioned methods disclosed in Japanese Unexamined Patent Application Publication Nos. 2004-296429,

2005-190931, and 2009-110930 have a problem that the color tone varies when the methods are used in a wide wavelength range.

Particularly, in a color display device using an organic EL device, a light scattering layer or the like is formed to improve the view angle characteristic and color purity (for example, Japanese Unexamined Patent Application Publication No. H11-329742). However, this method has a problem that the luminance varies in each color pixel, which results in impairing the white balance. Japanese Unexamined Patent Application Publication No. 2007-109575 discloses a method of adjusting the extraction efficiency by changing the thickness of a light scattering layer for each color of EL devices. However, this method requires complicated processes, and thus is impractical.

In the organic EL device, adhesive properties between layers are an important factor that determines the performance of the element. In particular, the adhesive property between a base material and a translucent electrode is especially important. When a light scattering layer is formed on a translucent substrate, the term "base material" herein described refers to a translucent substrate on which a light scattering layer is formed.

For example, in the process of forming a translucent electrode, high temperature processing for lowering a resistance value of each electrode, and etching processing for forming an electrode pattern are carried out. Further, prior to lamination of an organic layer on the formed translucent electrode, cleaning is performed using a solvent for removing impurities. In this case, when the adhesive property between the base material and the translucent electrode is low, fine cracking or peeling occurs in the translucent electrode. As a result, when the organic EL device is caused to emit light, a dark spot, luminance unevenness, or shortening of lifetime is caused.

The evenness of the base material is also an important factor. When the unevenness of the surface of the base material is large, film thickness unevenness occurs or fine protrusions are formed in the translucent electrode formed on the base material, and a portion in which a large current flows locally is generated. As a result, a short circuit or shortening of lifetime may be caused.

When a material obtained by forming a light scattering layer of related art on a translucent substrate is used as the base material, the adhesive property between the base material and the translucent electrode and the evenness of the base material are not sufficient, which may cause the above-mentioned problems.

## SUMMARY OF THE INVENTION

The present invention has an object to provide a resin composition for light scattering layer which is used for a light scattering layer disposed between a translucent electrode and a translucent substrate to improve the light extraction efficiency of an organic EL device, has a small wavelength dependence on the improvement ratio of the light extraction efficiency, and can be used in a wide wavelength range, a light scattering layer formed using the resin composition for light scattering layer, and an organic EL device including the light scattering layer.

The present invention has another object to provide a resin composition for light scattering layer which is used for a light scattering layer disposed between a translucent electrode and a translucent substrate to improve the light extraction efficiency of an organic EL device and which is capable of achieving an organic EL device having a high light extraction efficiency without inducing fine cracking, protrusion, or peeling in the translucent electrode in the process of producing a laminated structure, a light scattering layer formed using the resin composition for light scattering layer, and an organic EL device including the light scattering layer.

As a result of intensive study for solving the above-mentioned problems, the present inventors have achieved the present invention.

A first resin composition for light scattering layer of the present invention is a resin composition for light scattering layer for use in forming a light scattering layer of an organic electroluminescence (EL) device, including: a binder composition including at least one type of resin (A); and light scattering particles (B), in which the light scattering particles (B) have an average particle diameter of 200 nm to 500 nm in the resin composition for light scattering layer, and have a content of 20 vol% or less of particles with a particle diameter of 600 nm or more with respect to a total amount of the light scattering particles (B), and a refractive index difference between the binder composition and the light scattering particles (B) is 0.1 or more.

A second resin composition for light scattering layer of the present invention is a resin composition for light scattering layer for use in forming a light scattering layer of an organic electroluminescence (EL) device, including: a binder composition including at least one type of resin (A); and light scattering particles (B), in which the resin (A) includes a double bond and/or a cross-linkable group, and has a mass average molecular weight (Mw) of equal to or more than 5000 and less than 20000, the light scattering particles (B) have an average particle diameter of 200 nm to 1.0 $\mu$m in the resin composition for light scattering layer, and a refractive index between the binder composition and the light scattering particles (B) is 0.1 or more.

In the first and second resin compositions for light scattering layer of the present invention, the binder composition preferably has a refractive index of 1.65 or more.

In the first and second resin composition for light scattering layer of the present invention, the binder composition

preferably further includes metallic oxide fine particles (C) having an average primary particle diameter of 100 nm or less.

The metallic oxide fine particles (C) preferably include at least one type of metallic oxide particles selected from the group consisting of $ZrO_2$ and $TiO_2$.

In the first and second resin compositions for light scattering layer of the present invention, the light scattering particles (B) preferably have a coefficient of variation of 30% or less.

In the first and second resin compositions for light scattering layer of the present invention, the resin (A) preferably has a double bond equivalent of 400 g/mol to 1600 g/mol.

In the first and second resin compositions for light scattering layer of the present invention, the resin (A) preferably includes a cyclic skeleton in a main chain and/or a side chain.

In the first and second resin compositions for light scattering layer of the present invention, the resin (A) preferably includes an alkali-soluble group.

In the first and second resin compositions for light scattering layer of the present invention, the binder composition preferably further includes an ethylenically unsaturated monomer (D) having a double bond equivalent of 80 g/mol to 140 g/mol.

In the first and second resin compositions for light scattering layer of the present invention, the binder composition preferably further includes a silane compound (E) represented by the following general formula (1), the silane compound (E) including one of a urethane skeleton and an amide skeleton.

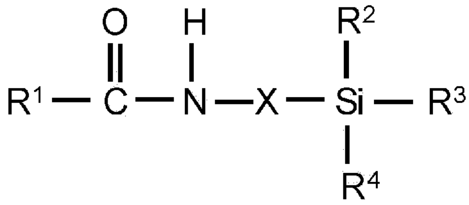

(1)

[In the general formula (1), $R^1$ represents one of an alkoxy group having a carbon number of 1 to 20, an aryloxy group having a carbon number of 6 to 20, an alkyl group having a carbon number of 1 to 20, an aryl group having a carbon number of 6 to 20, an aralkyl group having a carbon number of 7 to 30, and an alkaryl group having a carbon number of 7 to 30;

X represents one of an alkylene group having a carbon number of 1 to 20, an arylene group having a carbon number of 1 to 20, and an alkoxylene group having a carbon number of 1 to 20; and

$R^2$, $R^3$, and $R^4$ are independent from each other and represent one of an alkoxy group having a carbon number of 1 to 20, an aryloxy group having a carbon number of 6 to 20, an alkyl group having a carbon number of 1 to 20, an aryl group having a carbon number of 6 to 20, an aralkyl group having a carbon number of 7 to 30, an alkaryl group having a carbon number of 7 to 30, a siloxane group including a substituent, a halogen atom, a hydroxy group, and a hydrogen atom.]

The silane compound (E) preferably has a mass average molecular weight (Mw) of equal to or more than 200 and less than 5000, and has a content of equal to or more than 3 mass% and less than 50 mass% in 100% by mass of total solids of the resin composition for light scattering layer.

In the first and second resin compositions for light scattering layer of the present invention, the binder composition preferably further includes an oxime ester-based photopolymerization initiator (F).

A light scattering layer of the present invention is formed using the above-described first and second resin compositions for light scattering layer of the present invention.

An organic electroluminescence (EL) device of the present invention has a configuration in which the above-described light scattering layer of the present invention, a first electrode having translucency, at least one organic layer including a luminous layer, and a second electrode having light reflectivity are sequentially laminated on a translucent substrate.

The organic EL device of the present invention can be applied to a lighting device, a display device, or the like.

According to the present invention, it is possible to provide a resin composition for light scattering layer which is used for a light scattering layer disposed between a translucent electrode and a translucent substrate to improve the light extraction efficiency of an organic EL device, has a small wavelength dependence on the improvement ratio of the light extraction efficiency, and can be used in a wide wavelength range, a light scattering layer formed using the resin composition for light scattering layer, and an organic EL device including the light scattering layer.

According to the present invention, it is also possible to provide a resin composition for light scattering layer which is used for a light scattering layer disposed between a translucent electrode and a translucent substrate to improve the light extraction efficiency of an organic EL device and which is capable of achieving an organic EL device having a high light extraction efficiency without inducing fine cracking, protrusion, or peeling in the translucent electrode in the

process of producing a laminated structure, a light scattering layer formed using the resin composition for light scattering layer, and an organic EL device including the light scattering layer.

The above and other objects, features and advantages of the present invention will become more fully understood from the detailed description given hereinbelow and the accompanying drawings which are given by way of illustration only, and thus are not to be considered as limiting the present invention.

BRIEF DESCRIPTION OF THE DRAWINGS

Fig. 1 is a schematic sectional view of an organic EL device having a bottom emission structure according to an exemplary embodiment of the present invention; and

Fig. 2 is a schematic sectional view of a thin-film printer.

DETAILED DESCRIPTION

Exemplary embodiments of the present invention will be described in detail below. The constituent elements described below are examples (representative examples) of exemplary embodiments of the present invention, and the present invention is not limited to these contents without departing from the gist of the present invention.

<First Resin Composition for Light Scattering Layer>

A first resin composition for light scattering layer of the present invention is a resin composition for light scattering layer for use in forming a light scattering layer of an organic EL device. The resin composition for light scattering layer includes a binder composition including at least one type of resin (A), and light scattering particles (B). The light scattering particles (B) have an average particle diameter of 200 nm to 500 nm in the resin composition for light scattering layer, and have a content of 20 vol% or less of particles with a particle diameter of 600 nm or more with respect to a total amount of the light scattering particles (B). A refractive index difference between the binder composition and the light scattering particles (B) is 0.1 or more.

<Light Scattering Particles (B)>

First, the light scattering particles (B) will be described.

The light scattering particles (B) are not particularly limited as long as the light scattering particles scatter light, which is guided by total reflection inside the organic EL device, and have a light extraction effect. The light scattering particles (B) may be organic particles or inorganic particles.

Examples of organic particles to be used include polymethyl methacrylate beads, acrylic-styrene copolymer beads, melamine resin beads, polycarbonate beads, polystyrene beads, cross-linked polystyrene beads, polyvinyl chloride beads, and benzoguanamine-melamine-formaldehyde condensate beads. Examples of inorganic particles to be used include $SiO_2$, $ZrO_2$, $TiO_2$, $Al_2O_3$, $In_2O_3$, ZnO, $SnO_2$, and $Sb_2O_3$. These may be used alone, or two or more types of them may be used in combination.

In the first resin composition for light scattering layer of the present invention, the light scattering particles (B) have an average particle diameter of 200 nm to 500 nm in the resin composition for light scattering layer, and have a content of 20 vol% or less of particles with a particle diameter of 600 nm or more with respect to a total amount of the light scattering particles (B).

When the average particle diameter of the light scattering particles (B) is less than 200 nm, a sufficient scattering effect is not achieved and there is an adverse effect on the refractive index of the binder resin. For this reason, the average particle diameter of less than 200 nm is not preferable in some cases. When the average particle diameter is larger than 500 nm, the scattering angle becomes small even when the scattering intensity (haze value) is high, and scattering effective for total reflection cannot be obtained, so that the extraction efficiency is lowered and the color tone is liable to change due to a large variation of the light extraction efficiency depending on the wavelength. For this reason, the average particle diameter of larger than 500 nm is not preferable in some cases. More preferably, the average particle diameter is 250 nm to 500 nm.

As described above, in the first resin composition for light scattering layer of the present invention, the average particle diameter of the light scattering particles (B) in the resin composition for light scattering layer is most preferably 200 nm to 500 nm.

Note that the light scattering particles (B) may have an average particle diameter of 200 nm to 1.0 $\mu$m. In this case, the effect of reducing the wavelength dependence is smaller than that specified above, but the effect of reducing

the wavelength dependence can be obtained. In addition, a light scattering layer having excellent surface evenness and excellent adhesive properties with respect to adjacent layers can be formed.

When the content of particles with a particle diameter of 600 nm or more with respect to the total amount of the light scattering particles (B) is more than 20 vol%, the variation of the light extraction efficiency depending on the wavelength becomes large, and the color tone is liable to change. For this reason, the content of more than 20 vol% is not preferable in some cases. Further, since the surface roughness of the light scattering layer increases, film thickness unevenness, a protrusion, or the like of the translucent electrode occurs, which may cause luminance unevenness and shortening of lifetime. The content of particles with a particle diameter of 600 nm or more is more preferably 15 vol% or less.

The terms "average particle diameter" and "particle diameter" of the light scattering particles (B) herein described refer to a dispersed particle diameter in the composition for light scattering layer, in which a particle diameter of secondary particles due to aggregation is also taken into consideration, unlike an average primary particle diameter which is described later. These can be obtained by observation with an optical microscope, or by a dynamic light-scattering method. The reason for discriminating the "average particle diameter" and "particle diameter" from the average primary particle diameter is that even in the case of using scattered particles having the same average primary particle diameter, the average particle diameter and the particle size distribution may vary depending on the dispersed state of the light scattering particles (B) in the composition for light scattering layer.

The term "average particle diameter" refers to a value of a dispersed particle diameter in 50 vol% of measurement sample. The content of particles with a particle diameter of 600 nm or more is represented by vol% of a particle diameter of 600 nm or more in the dispersed particle diameter of the measurement sample. These can be measured by "Nanotrac UPA", which is manufactured by Nikkiso Co., Ltd., in the dynamic light-scattering method.

As the particle size distribution of the light scattering particles (B), the coefficient of variation is preferably 30% or less. The "coefficient of variation" is expressed in percentage of the value obtained by dividing a standard deviation of a particle diameter by an average particle diameter, and is an index indicating a magnitude of a variation with respect to the average particle diameter.

When the coefficient of variation is greater than 30%, the variation of the light extraction efficiency depending on the wavelength becomes large and the color tone is liable to change. For this reason, the coefficient of variation of greater than 30% is not preferable in some cases. More preferably, the coefficient of variation is 20% or less.

For the light scattering particles (B), a fluid dispersion which is preliminarily dispersed in a solvent is preferably used.

As a dispersion method, a method using a dispersant depending on the surface state of the light scattering particles (B) is used, and a method using a dispersion device is preferably used.

Examples of the dispersion device to be used include a paint conditioner (manufactured by Red Devil, Inc.), a ball mill, a sand mill ("Dynomill" manufactured by Shinmaru Enterprises Co., Ltd., etc.), an attritor, a pearl mill ("DCP mill" manufactured by Eirich Co., Ltd., etc.), a co-ball mill, a homomixer, a homogenizer ("Clearmix" manufactured by M Technique Co., Ltd., etc.), a wet-type jet mill ("Genus PY" manufactured by Genus Co., Ltd., "Nanomizer" manufactured by NANOMIZER Inc.), a micro-bead mill ("SUPER APEX MILL" and "ULTRA APEX MILL" manufactured by Kotobuki Industries Co., Ltd.).

When media are used in the dispersion device, glass beads, zirconia beads, alumina beads, magnetic beads, polystyrene beads, and the like are preferably used.

Two or more types of dispersion devices, or two or more types of media of different sizes may be used to carry out the dispersion stepwise.

In the case of using inorganic particles, the average particle diameter and the particle size distribution of the light scattering particles (B) can be adjusted to a suitable range by appropriately adjusting the dispersion conditions such as a dispersion device, a dispersion medium, a dispersion time, and a dispersant. In the case of using organic particles, the average particle diameter and the particle size distribution of the light scattering particles (B) can be adjusted depending on the synthesis conditions such as a polymerization temperature and a polymerization composition, or the dispersion conditions such as a dispersion device, a dispersion medium, a dispersion time, and a dispersant.

The amount of the light scattering particles (B) to be used is preferably 1 to 20 mass% in the resin composition for light scattering layer, and more preferably, 1 to 10 mass%. When the used amount is less than 1 mass%, there is a possibility that a sufficient scattering effect cannot be obtained. When the used amount exceeds 20 mass%, the particles are liable to aggregate and the surface roughness of the light scattering layer may increase.

<Refractive Index Difference>

In the first resin composition for light scattering layer of the present invention, the refractive index difference between the binder composition including at least one type of resin (A) and the light scattering particles (B) is 0.1 or more.

The term "binder composition including at least one type of resin (A)" herein described refers to a portion of the resin composition for light scattering layer excluding the light scattering particles (B). For example, when the resin

composition for light scattering layer is a mixture composition of component (A) : component (B) : component (C) : component (E) : component (F) = 35:10:40:10:5 (mass ratio), the binder composition is a mixture composition of component (A) : component (C) : component (E) : component (F) =35:40:10:5 (mass ratio). When the refractive index difference is 0.1 or more, the light guided by total reflection inside the EL device is scattered at the interface between the binder composition and the light scattering particles (B), which improves the light extraction efficiency. As the refractive index difference increases, the light extraction efficiency is improved.

The refractive index of the translucent substrate is about 1.5 and the refractive index of the translucent electrode is about 1.8 to 2.0. Accordingly, the refractive index of the binder composition is preferably 1.5 to 2.0. A refractive index of 1.65 or more is particularly desirable, because the refractive index of the binder composition is close to that of the translucent electrode and more light can be guided, and because the wavelength dependence on the light extraction efficiency is small, for example.

The refractive index of the binder composition is determined by the composition ratio of the components to be used. As described later, metallic oxide particles (C), which can be arbitrarily added, function as a refractive index adjustor of the binder composition. In the case of using organic particles, the refractive index of the light scattering particles (B) is generally 1.5 to 1.8. In the case of using inorganic particles, the refractive index of the light scattering particles (B) is generally 1.3 to 2.5. Accordingly, the refractive index difference can be set to be equal to or more than 0.1 by appropriately selecting the binder composition and the light scattering particles (B).

Examples of refractive index values are given below.

As the resin (A), for example, epoxy resin: 1.53 to 1.57, and acrylate resin: 1.49 to 1.59.

As the metallic oxide particles (C), for example, titanium oxide ($TiO_2$): 2.5, zirconium oxide ($ZrO_2$): 2.2, zinc oxide (ZnO): 1.9, and tin oxide ($SnO_2$): 2.0.

The refractive index of the binder composition including the resin (A) and the metallic oxide particles (C) as needed is preferably 1.5 to 2.0.

As the light scattering particles (B), for example, methacrylic acid ester copolymer beads: 1.45 to 1.60, acrylic-styrene copolymer beads: 1.5 to 1.6, melamine resin beads: 1.65, $SiO_2$: 1.45, $ZrO_2$: 2.2, and $TiO_2$: 2.5. Trifluoroethyl methacrylate copolymer beads: 1.46 and $TiO_2$: 2.5, which are capable of increasing the refractive index difference with respect to the binder composition, are preferably used.

The term "a refractive index of a binder composition" herein described refers to a value measured with an Abbe refractometer.

<Resin (A)>

The resin (A) is not particularly limited, as long as the resin has translucency with respect to light of a predetermined wavelength band, which is emitted from the luminous layer, such as visible light, near infrared rays, or near ultraviolet rays. Thermoplastic resins, and curable resins having a heat curing property, a photo (electromagnetic wave)-curing property due to visible light, ultraviolet rays, infrared rays, or the like, or an electron beam curing property due to electron beam irradiation, for example, are suitably used. Examples of the resins include polycarbonate (PC), polystyrene (PS), polyether, polyester, polyarylate, polyamide, phenol-formaldehyde resin (phenol resin), poly(diethylene glycol bis(allyl carbonate)), acrylonitrile-styrene copolymer (AS resin), methyl methacrylate-styrene copolymer (MS resin), poly-4-methylpentene, norbornene-based polymer, urethane resin, epoxy resin, acrylic resin, and silicone resin. These may be used alone, or two or more types of them may be mixed, as needed, at an arbitrary ratio.

The resin (A) preferably includes a double bond and/or a cross-linkable group and has a mass average molecular weight (Mw) of equal to or more than 5000 and less than 20000.

Roughly speaking, an organic EL device is manufactured by sequentially laminating a translucent electrode, an organic layer including a luminous layer, and a back electrode on a translucent substrate. In this case, the adhesive properties between the layers are an important factor that determines the performance of the organic EL device. In particular, the adhesive property between the base material and the translucent electrode is especially important. For example, in the process of forming the translucent electrode, high-temperature processing for lowering the resistance value of the electrode and etching processing for forming an electrode pattern are carried out. Further, prior to lamination of the organic layer on the formed translucent electrode, cleaning is performed using a solvent for removing impurities. In this case, when the adhesive property between the base material and the translucent electrode is low, fine cracking or peeling occurs in the translucent electrode. As a result, when the organic EL device is caused to emit light, a dark spot, luminance unevenness, or shortening of lifetime is caused.

When the characteristics of the resin (A) fall within the above-mentioned range, there is an advantageous effect of reducing the cure shrinkage of the composition for light scattering layer and suppressing occurrence of fine cracking or peeling in the translucent electrode, during the process in which the translucent electrode is laminated on the light scattering layer and necessary processing such as heating, etching, and solvent cleaning is carried out.

The term "mass average molecular weight (Mw)" herein described refers to a value measured by gel permeation

chromatography. For example, the mass average molecular weight (Mw) can be measured by gel permeation chromatography GPC-101 manufactured by Showa Denko K.K.

When the mass average molecular weight (Mw) of the resin (A) is less than 5000, the chemical resistance of the light scattering layer is insufficient, which may cause peeling of the light scattering layer or the translucent electrode during the solvent cleaning processing prior to lamination of the organic layer. When the mass average molecular weight (Mw) is 20000 or more, the viscosity is high, so that the light scattering particles (B) or the metallic oxide fine particles (C) aggregate and the surface roughness of the light scattering layer becomes large. This may cause a short circuit or shortening of lifetime, and may result in formation of fine protrusions, during formation of the translucent electrode.

The 5% decomposition temperature of the resin (A) is preferably 200°C or higher.

The term "5% decomposition temperature" herein described refers to a temperature obtained when a mass of 5% is reduced by heating, and represents a value measured by thermogravimetry. For example, the 5% decomposition temperature can be measured by a differential thermal/thermogravimetric simultaneous measurement apparatus EXSTER TG/DTA6300 manufactured by Seiko Instruments Inc. When the 5% decomposition temperature of the resin (A) is lower than 200°C, the heat resistance is low and heating is insufficient in the process of laminating the translucent electrode. This may make it difficult to lower the resistance value of the electrode.

In terms of the translucency and etchant resistance, the resin (A) preferably includes a cyclic skeleton in a main chain or a side chain. The term "cyclic skeleton" herein described refers to a heterocyclic ring including an aliphatic ring, an aromatic ring, and an O atom and/or an N atom.

Specific examples of the cyclic skeleton include:

aliphatic rings such as a hydrogenated bisphenol A skeleton, a cyclohexyl skeleton, a norbornene skeleton, and an adamantane skeleton;
aromatic rings such as a phenyl group, a phenylene group, indene, a bisphenol A skeleton, and a fluorene skeleton; and
ester resin, urethane resin, epoxy resin, and acrylic resin which include one or two types of cyclic skeletons selected from heterocyclic rings including an O atom and/or an N atom, such as a tetrahydrofuran skeleton, a furan skeleton, a tetrahydropyran skeleton, a pyran skeleton, an isocyanurate skeleton, and an oxazolidone skeleton.

Among these examples, acrylic resin is suitably used in terms of heat resistance and light resistance.

The amount of the resin (A) to be used for the first resin composition for light scattering layer of the present invention is preferably 5 to 70 mass% in the resin composition for light scattering layer, and more preferably, 10 to 60 mass%. When the amount is less than 5 mass%, the amount of ethylenically unsaturated monomer (D), which is described later, increases in the composition for light scattering layer. Accordingly, the cure shrinkage may be increased, and fine cracking or peeling is more likely to occur in the translucent electrode in some cases. When the amount exceeds 70 mass%, a sufficient etchant resistance cannot be maintained in some cases.

The resin (A) includes a double bond and/or a cross-linkable group, which improves the heat resistance and the chemical resistance.

Examples of the double bond include a unsaturated group such as a (meth)acrylate group and a maleimide group. As a cross-linkable group, a thermal cross-linkable group, an ultraviolet ray or electron beam cross-linkable group is preferably included. Examples of a thermal cross-linkable site include a hydroxyl group, an epoxy group, an oxetanyl group, an acid (carboxyl) group, and an isocyanate group. Examples of an ultraviolet ray or electron beam cross-linkable site include an epoxy group and an oxetanyl group. One or two or more types of them can be used.

The resin (A) preferably includes an unsaturated group such as a (meth)acrylate group and a maleimide group, and preferably has a double bond equivalent of 400 g/mol to 1600 g/mol. When the double bond equivalent of the resin (A) is less than 400 g/mol, the cure shrinkage of the resin increases, which may cause fine cracking or peeling in the translucent electrode. On the other hand, when the double bond equivalent exceeds 1600 g/mol, the etching resistance may be insufficient due to insufficient cross-linking, or peeling may occur in the light scattering layer or the translucent electrode in the process of solvent cleaning prior to lamination of the organic layer.

The method of obtaining polyacrylate suitable as the resin (A) in the first resin composition for light scattering layer of the present invention is not particularly limited.

For example, it is possible to employ a method in which a functional group in a copolymer obtained by polymerizing an unsaturated monomer component including an ethylenically unsaturated monomer including one or two or more types of functional groups selected from the group consisting of a hydroxyl group, an epoxy group, an acid (carboxyl) group, and an isocyanate group is denatured with an ethylenically unsaturated monomer having a functional group capable of reacting with this functional group. A combination of a functional group of copolymer and a functional group of ethylenically unsaturated monomer used for denaturation is not particularly limited. Examples of the combination include a combination of a hydroxyl group and an isocyanate group, a combination of a hydroxyl group and an epoxy group, and a combination of an epoxy group and an acid (carboxyl) group.

(Ethylenically unsaturated monomer including a hydroxyl group)

Examples of ethylenically unsaturated monomer including a hydroxyl group include hydroxyalkyl(meth)acrylates such as 2-hydroxyethyl(meth)acrylate, 2- or 3-hydroxypropyl(meth)acrylate, 2-, 3- or 4-hydroxybutyl(meth)acrylate, glycerol (meth)acrylate, and cyclohexane dimethanol mono(meth)acrylate.

(Ethylenically unsaturated monomer including an epoxy group)

Examples of ethylenically unsaturated monomer including an epoxy group include glycidyl(meth)acrylate, β-methylglycidyl(meth)acrylate, β-propylglycidyl(meth)acrylate, β-methylglycidyl-α-ethylacrylate, 3-methyl-3,4-epoxybutyl (meth)acrylate, 4-methyl-4,5-epoxypentyl(meth)acrylate, 5-methyl-5,6-epoxyhexyl(meth)acrylate, and glycidyl vinyl ether. Among them, glycidyl(meth)acrylate is preferable.

(Ethylenically unsaturated monomer including an acid (carboxyl) group)

Examples of ethylenically unsaturated monomer including an acid radical include:

ethylenically unsaturated monomer (unsaturated monobasic acid) including a carboxyl group of monocarboxylic acid or the like of α-position haloalkyl, alkoxyl, halogen, nitro, or cyano substituted products of (meth)acrylic acid, itaconic acid, crotonic acid, o-, m-, p-vinyl benzoic acid, and (meth)acrylic acid; and
polybasic acid anhydrides such as tetrahydrophthalic acid anhydride, phthalic anhydride, hexahydrophthalic anhydride, succinic anhydride, and maleic anhydride.

Among them, (meth)acrylic acid is preferable.

(Unsaturated monomer including an isocyanate group)

Examples of ethylenically unsaturated monomer including an isocyanate group include 2-(meth)acryloyloxyethyl isocyanate and 1,1-bis[(meth)acryloyloxy]ethyl isocyanate.
Other ethylenically unsaturated monomer components constituting the resin (A) are not particularly limited, as long as they includes an ethylene unsaturated group. Examples of the other ethylenically unsaturated monomer components include (meth)acrylic acid esters, N-vinyl pyrolidone, styrenes, acrylamides, other vinyl compounds, and macromonomers.
Among them, as described above, it is preferable to copolymerize an ethylenically unsaturated monomer including a cyclic skeleton in a main chain or a side chain of the resin (A).
Examples of ethylenically unsaturated monomer including a cyclic skeleton in a main chain include:

cyclic dienes such as indene, benzofuran, norbornene, and cyclohexene; and
monomers having a 5- or 6-membered ring in a main chain due to the advancement of an intramolecular cyclization reaction during copolymerization with methacrylic acid esters such as vinylcyclopropane.

Examples of ethylenically unsaturated monomer including a cyclic skeleton in a side chain include:

aliphatic ring-containing (meth)acrylates such as isobornyl(meth)acrylate, cyclohexyl(meth)acrylate, dicyclopentenyloxyethyl(meth)acrylate, dicyclopentanyl(meth)acrylate, and 1-adamantane(meth)acrylate; and
aromatic ring-containing (meth)acrylates such as benzyl(meth)acrylate, phenyl(meth)acrylate, phenoxyethyl(meth) acrylate, and paracumyl EO modified(meth)acrylate;
styrene and a derivative thereof, and styrenes such as methylstyrene; and
heterocyclic ring-containing (meth)acrylates including an O atom and/or an N atom such as tetrahydrofurfuryl(meth) acrylate, cyclic trimethylolpropane formal (meth)acrylate, (2-ethyl-2-methyl-1 ,3-dioxolan-4-yl) (meth)acrylate, (2-isobutyl-2-methyl-1,3-dioxolan-4-yl) (meth)acrylate, (1,4-dioxaspiro[4,5]deca-2-yl) (meth)acrylate, pentamethylpiperidyl (meth)acrylate, and oxazolidone (meth)acrylate.

These can be used alone, or two or more types of them can be mixed at an arbitrary ratio as needed.
The ratio of ethylenically unsaturated monomer including a cyclic skeleton in a main chain or a side chain is not particularly limited, but is preferably 5 to 50 mass% with respect to 100 mass% in total of the monomer constituting the resin (A). When the amount of the ethylenically unsaturated monomer including the cyclic skeleton in the main chain or the side chain is extremely large, it is difficult to control the polymerization, which may make it difficult to obtain a

desired molecular weight. On the other hand, when the amount is extremely small, there is a possibility that the etchant resistance becomes insufficient.

Examples of ethylenically unsaturated monomers, which can be copolymerized, other than the ethylenically unsaturated monomer including a cyclic skeleton in a main chain or a side chain include:

(meth)acrylic acid esters such as methyl(meth)acrylate, ethyl(meth)acrylate, propyl(meth)acrylate, isopropyl(meth) acrylate, butyl(meth)acrylate, isobutyl(meth)acrylate, tert-butyl(meth)acrylate, 2-ethylhexyl(meth)acrylate, and 2-hydroxyethyl(meth)acrylate;
acrylamides such as (meth)acrylamide, methylol(meth)acrylamide, alkoxymethylol(meth)acrylamide, diacetone (meth)acrylamide; and
vinyl compounds such as (meth)acrylonitrile, ethylene, propylene, butylene, vinyl chloride, and vinyl acetate.

These can be used alone, or two or more types of them can be mixed at an arbitrary ratio as needed.

The 5% decomposition temperature and the double bond equivalent of the resin (A) can be controlled by the type and composition of ethylenically unsaturated monomer used for copolymerization and denaturation. The mass average molecular weight (Mw) can be control depending on the polymerization conditions such as the type and amount of polymerization initiator.

It is possible to impart given physical properties to the resin (A) depending on the type and composition of the ethylenically unsaturated monomer to be used.

For example, in the case of imparting a development property to the resin (A), an acid radical, such as a carboxyl group, is introduced to exhibit the alkali solubility. The method of introducing an acid radical is not particularly limited. Examples of the method include a method of denaturing a copolymer including an ethylenically unsaturated monomer including the above-mentioned acid radical so that the acid radical remains, and a method of denaturing a copolymer including an ethylenically unsaturated monomer including the above-mentioned hydroxyl group by using the above-mentioned polybasic acid anhydrides.

In the case of imparting the development property, the acid value of the resin (A) is preferably equal to or more than 30 mg KOH/g and less than 200 mg KOH/g. When the acid value is less than 30 mg KOH/g, a sufficient development property cannot be secured. When the acid value is equal to or more than 200 mg KOH/g, the hydrolysis of a silane compound (E), which is described later, is promoted, which may deteriorate adhesive properties of the light scattering layer over time.

The term "adhesive properties of the light scattering layer" herein described (hereinafter, also referred to simply as "adhesive properties") refers to adhesive properties of the light scattering layer with respect to the translucent substrate and the translucent electrode.

In the synthesis of the resin (A), copolymerization and denaturation of the ethylenically unsaturated monomer are generally carried out for 2 to 10 hours at a temperature of 50 to 150°C under an inert gas flow and under the presence of a polymerization initiator. As a method of polymerization reaction is not particularly limited and various conventionally-known polymerization methods can be employed. In particular, a solution polymerization method is preferably employed.

The polymerization temperature and the polymerization concentration defined in the following formula vary depending on the type and ratio of monomer components to be used, and a target molecular weight of polymers. Preferably, the polymerization temperature is 40 to 150°C and the polymerization concentration is 5 to 50%, and more preferably, the polymerization temperature is 60 to 130°C and the polymerization concentration is 10 to 40%.

$$\text{polymerization concentration (\%)} = [\text{total mass of monomer components} / (\text{total mass of monomer components} + \text{solvent mass})] \times 100$$

As the polymerization initiator for use in synthesizing the resin (A), organic peroxide, an azo compound, and the like can be used.

Examples of the organic peroxide include benzoyl peroxide, cumene hydroperoxide, t-butyl hydroperoxide, diisopropyl peroxycarbonate, di-t-butyl peroxide, and t-butyl peroxybenzoate.

Examples of the azo compound include azo compounds such as 2,2'-azobisisobutyronitrile.

The polymerization initiator is preferably used within the range of 1 to 20 parts by mass with respect to 100 parts by mass of the ethylenically unsaturated monomer.

Examples of the solvent for use in synthesizing the resin (A) include water, water-miscible organic solvent, acetate ester, ketones, xylene, and ethylbenzene.

Examples of the water-miscible organic solvent include alcoholic solvent such as ethyl alcohol, isopropyl alcohol, and n-propyl alcohol, and mono- or di-alkyl ether of ethylene glycol or diethylene glycol.

Examples of the acetate ester include ethyl cellosolve acetate and propylene glycol monomethyl ether acetate.

Examples of the ketones include cyclohexanone and methyl isobutyl ketone.

<Metallic Oxide Fine Particles (C)>

The binder composition may include the metallic oxide fine particles (C) in addition to the resin (A). This makes it possible to adjust the binder composition to have an arbitrary refractive index.

The metallic oxide fine particles (C) used in the present invention desirably has a refractive index of 1.8 to 2.8 in a visible light range.

The term "refractive index of metallic oxide fine particles (C)" herein described refers to a refractive index of a bulk of material constituting metallic oxide fine particles. The refractive index of the bulk material can be measured by an Abbe refractometer or a V-block refractometer.

Specific examples of the metallic oxide fine particles (C) include particles including at least one type of material selected from the group consisting of titanium oxide ($TiO_2$), zirconium oxide ($ZrO_2$), cerium oxide ($CeO_2$), hafnium oxide ($HfO_2$), niobium pentoxide ($Nb_2O_5$), tantalum pentoxide ($Ta_2O_5$), indium oxide ($In_2O_3$), tin oxide ($SnO_2$), indium tin oxide (ITO), and zinc oxide (ZnO).

It is preferable that the particles have no strong aggregation so as to maintain the translucency of the light scattering layer. Accordingly, the average primary particle diameter of the metallic oxide fine particles (C) is preferably 100 nm or less. The average primary particle diameter is specified to be equal to or less than 100 nm, thereby obtaining a transparent binder composition in the visible light range.

The term "average primary particle diameter" herein described refers to the diameter of each particle in which an aggregation is not taken into consideration. For example, the average primary particle diameter is an average value of diameters of 50 particles observed with a transmission electron microscope (TEM), a scanning-type electron microscope (SEM), or the like.

The metallic oxide fine particles (C) can be directly used as powder, or dispersion liquid obtained by dispersing the particles in a solvent in advance can also be used. Especially, the dispersion liquid is preferably used so as to maintain the dispersed state in which the average particle diameter is equal to or less than 200 nm.

As a dispersion method, a method using a dispersant, which is selected depending on the surface state of the metallic oxide fine particles (C), and a dispersion device is preferably used, as with the light scattering particles (B).

As the metallic oxide fine particles (C), titanium oxide ($TiO_2$), zirconium oxide ($ZrO_2$), zinc oxide (ZnO), and tin oxide ($SnO_2$) are preferably used. In terms of the translucency, dispersibility, weatherability, light resistance, and the like, titanium oxide ($TiO_2$) and zirconium oxide ($ZrO_2$) are particularly preferable.

The binder composition containing the resin (A) and the metallic oxide fine particles (C) preferably has a light transmittance of 80% or more at an optical path length of 1 mm in a visible light wavelength range, and more particularly, 85% or more. This light transmittance varies depending on the content of the metallic oxide fine particles (C) in the binder composition.

The refractive index of the metallic oxide fine particles (C) is generally 1.8 to 2.5. Dispersion of the metallic oxide fine particles (C) in the binder composition makes it possible to improve the refractive index of the entire light scattering layer as compared with the refractive index of about 1.4 to 1.5 of the resin (A).

The amount of the metallic oxide fine particles (C) used in the first resin composition for light scattering layer of the present invention is preferably 70 mass% or less in the resin composition for light scattering layer, and more preferably, 50 mass% or less. When the amount exceeds 70 mass%, the particles may aggregate, or the coating film may become fragile due to a reduction in the amount of the resin (A).

The binder composition may further include a polyfunctional monomer. The binder composition including the polyfunctional monomer has an excellent etchant resistance. Especially, in terms of maintenance of the transmittance, a balance between a crosslink density and adhesive properties, for example, the ethylenically unsaturated monomer (D) particularly preferably has a double bond equivalent of 80 g/mol to 140 g/mol.

<Ethylenically Unsaturated Monomer (D)>

Examples of the ethylenically unsaturated monomer (D) having a double bond equivalent of 80 g/mol to 140 g/mol include:

tri(meth)acrylates such as 1 ,6-hexanediol di(meth)acrylate, 1,4-butanediol di(meth)acrylate, ethylene glycol di (meth)acrylate, diethylene glycol di(meth)acrylate, pentaerythritol triacrylate, and trimethylolpropane tri(meth)acrylate;

aliphatic polyfunctional(meth)acrylates such as pentaerythritol tetraacrylate, ditrimethylolpropane tetraacrylate, and dipentaerythritol(monohydroxy)pentaacrylate;

polyfunctional-type cycloaliphatic (meth)acrylates such as dicyclopentadienyl di(meth)acrylate;

Other examples include polyurethane ether (meth)acrylate, polyester (meth)acrylate, and epoxy (meth)acrylate which have two or more functions with a double bond equivalent of 80 g/mol to 140 g/mol.

These can be used alone, or two or more types of them can be mixed at an arbitrary ration as needed.

The amount of the ethylenically unsaturated monomer (D) used for the first resin composition for light scattering layer of the present invention is preferably 15 to 40 mass% in the resin composition for light scattering layer. When the amount is less than 15 mass%, a sufficient etchant resistance cannot be obtained in some cases. When the amount exceeds 40 mass%, the cure shrinkage increases, which may cause fine cracking in the translucent substrate or the translucent electrode, or may cause peeling due to deterioration of the adhesive properties between the translucent substrate or the translucent electrode and the light scattering layer.

<Silane Compound (E)>

Preferably, the binder composition further includes the silane compound (E) which includes an urethane skeleton or an amide skeleton and which is represented by the following general formula (1).

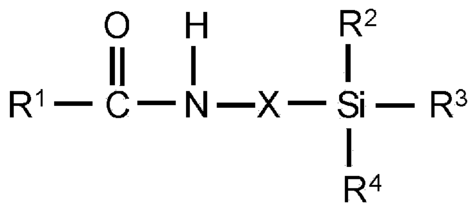

(1)

[In the general formula (1), $R^1$ represents one of an alkoxy group having a carbon number of 1 to 20, an aryloxy group having a carbon number of 6 to 20, an alkyl group having a carbon number of 1 to 20, an aryl group having a carbon number of 6 to 20, an aralkyl group having a carbon number of 7 to 30, and an alkaryl group having a carbon number of 7 to 30;

X represents one of an alkylene group having a carbon number of 1 to 20, an arylene group having a carbon number of 1 to 20, and an alkoxylene group having a carbon number of 1 to 20; and

$R^2$, $R^3$, and $R^4$ are independent from each other and represent one of an alkoxy group having a carbon number of 1 to 20, an aryloxy group having a carbon number of 6 to 20, an alkyl group having a carbon number of 1 to 20, an aryl group having a carbon number of 6 to 20, an aralkyl group having a carbon number of 7 to 30, an alkaryl group having a carbon number of 7 to 30, a siloxane group including a substituent, a halogen atom, a hydroxy group, and a hydrogen atom.]

The inclusion of the silane compound (E) represented by the general formula (1) improves the adhesive properties between the translucent substrate or translucent electrode and the light scattering layer.

Examples of the silane compound (E) represented by the general formula (1) include (3-carbamate ethyl) propyltriethoxysilane, (3-carbamate ethyl)propyltrimethoxysilane, (3-carbamate ethyl)propyltripropoxysilane, (3-carbamate propyl)propyltriethoxysilane, (3-carbamate propyl)propyltrimethoxysilane, (3-carbamate propyl)propyltripropoxysilane, (3-carbamate butyl)propyltriethoxysilane, (3-carbamate butyl)propyltrimethoxysilane, (3-carbamate butyl)propyltripropoxysilane, (3-carbamate butyl)butyltripropoxysilane, (3-carbamate butyl)propylmethyldiethoxysilane, (3-carbamate pentyl)propyltriethoxysilane, (3-carbamate hexyl)propyltriethoxysilane, (3-carbamate octyl)pentyltributoxysilane, (3-carbamate ethyl)propylsilyltrichloride, (3-carbamate ethyl)propyltrimethylsilane, (3-carbamate ethyl)propyldimethylsilane, (3-carbamate ethyl)propyltributylsilane, (3-carbamate ethyl)ethyl-p-xylenetriethoxysilane, and (3-carbamate ethyl)-p-phenylenetriethoxysilane.

The silane compound (E) represented by the general formula (1) may be added to the composition for light scattering layer, in the form of a silanol compound which is a hydrolysate, or in the form of a polyorganosiloxane compound which is a condensate.

The mass average molecular weight (Mw) of the silane compound (E) used in the present invention is preferably equal to or more than 200 and less than 5000. When the mass average molecular weight (Mw) of the silane compound (E) is less than 200, sufficient adhesive properties cannot be obtained in some cases. When the mass average molecular weight (Mw) is 5000 or more, the etchant resistance deteriorates. Accordingly, the mass average molecular weight (Mw) of less than 200 and the mass average molecular weight (Mw) of 5000 or more are not preferable in some cases.

The amount of the silane compound (E) used for the first resin composition for light scattering layer of the

present invention is preferably equal to or more than 3 mass% and less than 50 mass% in the resin composition for light scattering layer, and more preferably, 10 to 40 mass%. When the amount is less than 3 mass%, sufficient adhesive properties cannot be obtained, and when the amount exceeds 50 mass%, the transmittance deteriorates in some cases.

For example, an isocyanate group-containing silane compound such as 3-isocyanate propyltrimethoxysilane, 3-isocyanatopropyltriethoxysilane, and 3-isocyanate propyltripropoxysilane may react with a solvent, resin, monomer, and water in the resin composition for light scattering layer, and may cause white turbidity or may be turned into a gel. Furthermore, the cured coating film cannot develop the adhesive properties with stability in some cases.

On the other hand, the silane compound (E) represented by the general formula (1) has no highly-reactive portion such as an isocyanate group. Accordingly, the silane compound (E) is thermally and chemically stable, has excellent temporal stability in the resin composition for light scattering layer, and is capable of stably exhibiting satisfactory adhesive properties.

<Photopolymerization Initiator>

The first resin composition for light scattering layer of the present invention can be thermally polymerized without blending a polymerization initiator. However, a photopolymerization initiator may be added to the binder composition, in the case of curing the first resin composition for light scattering layer with UV light in a short period of time, or in the case of forming a light scattering layer by a photolithography method as a photosensitive resin composition for light scattering layer of a solvent development type or an alkaline development type, for example.

Examples of the photopolymerization initiator to be used include:

acetophenone-based photopolymerization initiators such as 4-phenoxydichloroacetophenone, 4-t-butyl-dichloroacetophenone, diethoxyacetophenone, 1-(4-isopropylphenyl)-2-hydroxy-2-methylpropane-1-one, 1-hydroxycyclohexyl phenyl ketone, 2-benzyl-2-dimethylamino-1-(4-morpholinophenyl)-butane-1-one, and 2-methyl-1-[4-(methylthio)phenyl]-2-morpholinopropane-1-one;
oxime ester-based photopolymerization initiators such as 1,2-octanedione-1-[4-(phenylthio)phenyl]-2-(o-benzoyl oxime), and ethanone,1-[9-ethyl-6-(2-methylbenzoyl)-9H-carbazole-3-yl]-,1-(o-acetyl oxime);
benzoin-based photopolymerization initiators such as benzoin, benzoinmethyl ether, benzoinethyl ether, benzoinisopropyl ether, and benzyldimethylketal;
benzophenone-based photopolymerization initiators such as benzophenone, benzoyl benzoic acid, benzoyl benzoic acid methyl, 4-phenyl benzophenone, hydroxy benzophenone, acrylic benzophenone, and 4-benzoyl-4'-methyldiphenyl sulfide;
thioxanthone-based photopolymerization initiators such as thioxanthone, 2-chlorthioxanthone, 2-methyl thioxanthone, isopropylthioxanthone, and 2,4-diisopropylthioxanthone;
triazine-based photopolymerization initiators such as 2,4,6-trichloro-s-triazine, 2-phenyl-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-piperonyl-4,6-bis(trichloromethyl)-s-triazine, 2,4-bis(trichloromethyl)-6-styryls-triazine, 2-(naphtho-1-yl)-4,6-bis(trichloromethyl)-s-triazine, 2-(4-methoxynaphtho-1-yl)-4,6-bis(trichloromethyl)-s-triazine, 2,4-trichloromethyl-(piperonyl)-6-triazine, and 2,4-trichloromethyl(4'-methoxystyryl)-6-triazine;
borate-based photopolymerization initiators;
carbazole-based photopolymerization initiators; and
imidazole-based photopolymerization initiators.

These can be used alone, or two or more types of them may be used in combination.

Among them, the oxime ester-based photopolymerization initiator (F) is preferably used, because the oxime ester-based photopolymerization initiator (F) has high sensitivity, which leads to a reduction in loadings and an increase in transmittance of the light scattering layer. More preferably, 1,2-octanedione-1-[4-(phenylthio)phenyl]-2-(o-benzoyl oxime) is used, because it does not turn yellow during a hearing process, which makes it possible to provide a light scattering layer having high transmittance.

The photopolymerization initiator is preferably used in an amount of 1 to 30 mass% in the resin composition for light scattering layer, and more preferably, in an amount of 1 to 10 mass% in terms of transmittance.

The binder composition may further include, as a sensitizer, $\alpha$-asiloxy ester, acylphosphine oxide, methylphenyl glyoxylate, benzyl, 9,10-phenanthrenequinone, camphorquinone, ethylanthraquinone, 4,4'-diethylisophthalophenone, 3,3',4,4'-tetra(t-butylperoxycarbonyl)benzophenone, diethylthioxanthone, 4,4'-diethylaminobenzophenone, and the like.

The sensitizer can be used in an amount of 0.1 to 150 parts by mass with respect to 100 parts by mass of photopolymerization initiator.

The binder composition may further include, as needed, a monofunctional monomer, an ultraviolet light absorber, an antioxidant, a heat stabilizer, a light stabilizer, an antistatic agent, a surfactant, a storage stabilizer, a leveling agent,

and the like.

<Heat-reactive Compound (G)>

A heat-reactive compound (G) can be further added to the resin composition for light scattering layer of the present invention so as to impart coating durability. The heat-reactive compound (G) is a compound which is nonresponsive at room temperature, but exhibits a crosslinking reaction property, a polymerization reaction property, a condensation polymerization reaction property, or a polyaddition reaction property at a temperature of 100°C or higher (preferably, 150°C or higher). The molecular weight of the heat-reactive compound (G) is not particularly limited, but is preferably 50 to 2000, and more preferably, 100 to 1000.

Examples of the heat-reactive compound (G) include a melamine compound, a benzoguanamine compound, a carbodiimide compound, an epoxy compound, an oxetane compound, a phenol compound, a benzoxazine compound, a blocked carboxylic acid compound, a blocked isocyanate compound, an acrylate-based monomer, and a silane coupling agent. One or two or more types of them can be used. Among them, a melamine compound and/or a benzoguanamine compound is preferably used.

The melamine compound and the benzoguanamine compound preferably include an imino group, a methylol group, or an alkoxymethyl group, and particularly preferably include an alkoxyalkyl group. When a melamine compound and/or a benzoguanamine compound including an alkoxyalkyl group is used, the preservation stability of the resin composition for light scattering layer of the present invention is remarkably improved.

Examples of the melamine compound including an alkoxyalkyl group include hexamethoxymethylol melamine and hexabutoxymethylol melamine.

Examples of the benzoguanamine compound including an alkoxyalkyl group include tetramethoxymethylol benzoguanamine and tetrabutoxymethylol benzoguanamine.

Specific examples of commercially available melamine compounds include:

Nikalacs MW-30M, MW-30, MW-22, MS-21, MS-11, MW-24X, MS-001, MX-002, MX-730, MX-750, MX-708, MX-706, MX-042, MX-035, MX-45, MX-500, MX-520, MX-43, MX-417, MX-410, and MX-302 manufactured by Sanwa Chemical Co., Ltd.; and

Cymels 300, 301 , 303, 350, 370, 325, 327, 703, 712, 01 , 285, 232, 235, 236, 238, 211, 254, 204, 202, and 207, and Mycoats 506, 508, 212, and 715 manufactured by Japan Cytecs Industries Inc.

Among them, Nikalacs MW-30M, MW-30, MW-22, MS-21, MX-45, MX-500, MX-520, MX-43, and MX-302 manufactured by Sanwa Chemical Co., Ltd. and Cymels 300, 301, 303, 350, 285, 232, 235, 236, and 238, and Mycoats 506 and 508 manufactured by Japan Cytecs Industries Inc. are preferably used, for example. These are alkoxyalkyl group-containing melamine compounds.

Specific examples of commercially available benzoguanamine compounds include:

Nikalacs BX-4000, SB-401, BX-37, SB-355, SB-303, SB301, BL-60, SB-255, SB-203, and SB-201 manufactured by Sanwa Chemical Co., Ltd.; and

Cymel 1123, Mycoats 105, 106, and 112 manufactured by Japan Cytecs Industries Inc.

Among them, Nikalacs BX-4000 and SB-401 manufactured by Sanwa Chemical Co., Ltd. and Cymel 1123 manufactured by Japan Cytecs Industries Inc. are preferably used, for example. These are alkoxyalkyl group-containing benzoguanamine compounds.

Examples of the epoxy compound include polyol glycidyl ether such as bisphenol fluorene diglycidyl ether, biscresol fluorene diglycidyl ether, bisphenoxyethanol fluorene diglycidyl ether, neopentyl glycol diglycidyl ether, 1,6-hexanediol diglycidyl ether, glycerol polyglycidyl ether, trimethylolpropane polyglycidyl ether, pentaerythritol polyglycidyl ether, diglycerol polyglycidyl ether, sorbitol polyglycidyl ether, diglycidyl terephthalate, diglycidyl o-phthalate, ethylene glycol diglycidyl ether, diethylene glycol diglycidyl ether, polyethylene glycol diglycidyl ether, and polypropylene glycol diglycidyl ether, or polyglycidylisocyanurate.

Examples of the phenol compound include a Novolak-type phenol compound obtained by allowing phenols and aldehydes to react with each other under an acid catalyst, and a resol-type phenol compound obtained by allowing phenols and aldehydes to react with each other under a basic catalyst.

Examples of phenols include orthocresol, paracresol, para-phenyl phenol, para-nonyl phenol, 2,3-xylenol, phenol, metacresol, 3,5-xylenol, resorcinol, catechol, hydroquinone, bisphenol A, bisphenol F, bisphenol B, bisphenol E, bisphenol H, and bisphenol S.

Examples of aldehydes include formaldehyde and acetaldehyde.

One or two or more types of phenols and aldehydes can be used.

Examples of the isocyanate compound used for the blocked isocyanate compound include:

diisocyanate such as hexamethyle diisocyanate, isophorone diisocyanate, toluidine isocyanate, diphenylmethane-4,4'-diisocyanate, diphenylmethane-2,4'-diisocyanate, bis(4-isocyanate cyclohexyl)methane, and tetramethyl xylylene diisocyanate;
an isocyanurate body of the above-mentioned diisocyanate;
a trimethylolpropane adduct type or biuret type isocyanate compound;
a prepolymer (a low polymer obtained from diisocyanate and polyol) including an isocyanate residue; and
uretdione including an isocyanate residue.

One or two or more types of them can be used.
Examples of a block agent used for the blocked isocyanate compound include phenol (having a dissociation temperature of 180°C or higher), ε-caprolactam (having a dissociation temperature of 160 to 180°C), oxime (having a dissociation temperature of 130 to 160°C), and activated methylene (100 to 120°C). One or two or more types of them can be used.

<Production Method>

The method of producing the first resin composition for light scattering layer of the present invention is not particularly limited, as long as the method is employed to uniformly mix particles and resin. Commonly-used known methods may be employed.
Examples of the method include a method of separately preparing each component constituting the first resin composition for light scattering layer of the present invention and thereafter mixing or kneading the components, and a method of polymerizing the resin (A) under the condition in which the prepared light scattering particles (B) and the metallic oxide fine particles (C) as needed exit, and mixing the other components.
From the standpoint of dispersion stability, it is preferable to employ a method of uniformly mixing the dispersion liquid of the light scattering particles (B), the dispersion liquid of the metallic oxide fine particles (C) as needed, the solution obtained by dissolving the resin (A), and the other components.
The first resin composition for light scattering layer of the present invention is used to form a light scattering layer disposed between a translucent electrode and a translucent substrate so as to improve the light extraction efficiency of the organic EL device. The use of the first resin composition for light scattering layer of the present invention makes it possible to form the light scattering layer which has a small wavelength dependence on the ratio of improvement of the light extraction efficiency and which can be used in a wide wavelength range.

"Second Resin Composition for Light Scattering Layer"

A second resin composition for light scattering layer of the present invention is a resin composition for light scattering layer for use in forming a light scattering layer of an organic EL device, and includes a binder composition including at least one type of resin (A) and light scattering particles (B).
The resin (A) includes a double bond and/or a cross-linkable group, and has a mass average molecular weight (Mw) of equal to or more than 5000 and less than 20000.
The light scattering particles (B) have an average particle diameter of 200 nm to 1.0 μm in the resin composition for light scattering layer, and the refractive index difference between the binder composition and the light scattering particles (B) is 0.1 or more.

<Resin (A)>

First, the resin (A) will be described.
The resin (A) used in the second resin composition for light scattering layer of the present invention includes a double bond and/or a cross-linkable group and has a mass average molecular weight (Mw) of equal to or more than 5000 and less than 20000. The resin (A) produces an effect of reducing cure shrinkage in the composition for the light scattering layer and suppressing fine cracking or peeling which occurs in the translucent electrode.
When the mass average molecular weight (Mw) of the resin (A) is less than 5000, the chemical resistance of the light scattering layer is insufficient, which may cause peeling of the light scattering layer or the translucent electrode during the solvent cleaning process prior to lamination of the organic layer. When the mass average molecular weight (Mw) is 20000 or more, the viscosity is high, so that the light scattering particles (B) or the metallic oxide fine particles (C) aggregate and the surface roughness of the light scattering layer becomes large. This may cause a short circuit or shortening of lifetime, and may result in formation of fine protrusions, during formation of the translucent electrode.

The 5% decomposition temperature of the resin (A) is preferably 200°C or higher. When the 5% decomposition temperature of the resin (A) is lower than 200°C, the heat resistance is low and heating is insufficient in the process of laminating the translucent electrode. This may make it difficult to lower the resistance value of the electrode.

The type of the resin (A) is not particularly limited, as long as the resin has translucency with respect to light of a predetermined wavelength band, which is emitted from the luminous layer, such as visible light, near infrared rays, or near ultraviolet rays. Thermoplastic resins, and curable resins having a heat curing property, a photo (electromagnetic wave)-curing property due to visible light, ultraviolet rays, infrared rays, or the like, or an electron beam curing property due to electron beam irradiation, for example, are suitably used. Examples of the resins include polycarbonate (PC), polystyrene (PS), polyether, polyester, polyarylate, polyamide, phenol-formaldehyde resin (phenol resin), poly(diethylene glycol bis(allyl carbonate)), acrylonitrile-styrene copolymer (AS resin), methyl methacrylate-styrene copolymer (MS resin), poly-4-methylpentene, norbornene-based polymer, urethane resin, epoxy resin, acrylic resin, and silicone resin. These may be used alone, or two or more types of them may be mixed, as needed, at an arbitrary ratio.

The amount of the resin (A) to be used in the present invention is preferably 5 to 70 mass% in the resin composition for light scattering layer, and more preferably, 10 to 60 mass%. When the amount is less than 5 mass%, the amount of ethylenically unsaturated monomer (D), which is described later, increases in the composition for light scattering layer. Accordingly, the cure shrinkage may be increased, and fine cracking or peeling is more likely to occur in the translucent electrode in some cases. When the amount exceeds 70 mass%, a sufficient etchant resistance cannot be maintained in some cases.

Further, the resin (A) has a double bond and/or a cross-linkable group, which improves the heat resistance and the chemical resistance. Examples of the double bond include an unsaturated group such as a (meth)acrylate group and a maleimide group. As a cross-linkable group, a thermal cross-linkable group, an ultraviolet ray or electron beam cross-linkable group is preferably included. Examples of a thermal cross-linkable site include a hydroxyl group, an epoxy group, an oxetanyl group, an acid (carboxyl) group, and an isocyanate group. Examples of an ultraviolet ray or electron beam cross-linkable site include an epoxy group and an oxetanyl group. One or two or more types of them can be used.

The resin (A) preferably includes an unsaturated group such as a (meth)acrylate group and a maleimide group, and preferably has a double bond equivalent of 400 g/mol to 1600 g/mol. When the double bond equivalent of the resin (A) is less than 400 g/mol, the cure shrinkage of the resin increases, which may cause fine cracking or peeling in the translucent electrode. On the other hand, when the double bond equivalent exceeds 1600 g/mol, the etching resistance may be insufficient due to insufficient cross-linking, or peeling may occur in the light scattering layer or the translucent electrode in the process of solvent cleaning prior to lamination of the organic layer.

As a method of obtaining polyacrylate suitable as the resin (A), for example, it is possible to employ a method in which a functional group in a copolymer obtained by polymerizing an unsaturated monomer component including an ethylenically unsaturated monomer including one or two or more types of functional groups selected from the group consisting of a hydroxyl group, an epoxy group, an acid (carboxyl) group, and an isocyanate group is denatured with an ethylenically unsaturated monomer having a functional group capable of reacting with this functional group.

A combination of a functional group of copolymer and a functional group of ethylenically unsaturated monomer used for denaturation is not particularly limited. Examples of the combination include a combination of a hydroxyl group and an isocyanate group, a combination of a hydroxyl group and an epoxy group, and a combination of an epoxy group and an acid (carboxyl) group. Specific examples of the ethylenically unsaturated monomer are similar to those of the resin (A) of the first resin composition for light scattering layer.

The ratio of ethylenically unsaturated monomer including a cyclic skeleton in a main chain or a side chain is not particularly limited, but is preferably 5 to 50 mass% with respect to 100 mass% in total of the monomer constituting the resin (A). When the amount of ethylenically unsaturated monomer including a cyclic skeleton in a main chain or a side chain is extremely large, it is difficult to control the polymerization, which may make it difficult to obtain a desired molecular weight. On the other hand, when the amount is extremely small, there is a possibility that the etchant resistance becomes insufficient.

Specific examples of ethylenically unsaturated monomers, which can be copolymerized, other than the saturated ethylene monomer including a cyclic skeleton in a main chain or a side chain are similar to those of the resin (A) of the first resin composition for light scattering layer.

The 5% decomposition temperature and the double bond equivalent of the resin (A) can be controlled by the type and composition of ethylenically unsaturated monomer used for copolymerization and denaturation. The mass average molecular weight (Mw) can be control depending on the polymerization conditions such as the type and amount of polymerization initiator

It is possible to impart given physical properties to the resin (A) depending on the type and composition of the ethylenically unsaturated monomer to be used. For example, in the case of imparting a development property to the resin (A), an acid radical, such as a carboxyl group, is introduced to exhibit the alkali solubility. The method of introducing the acid radical and the preferable acid value of the resin (A) are similar to those of the resin (A) of the first resin composition for light scattering layer.

The method of synthesizing the resin (A) is similar to the method of synthesizing the resin (A) in the first resin composition for light scattering layer of the present invention.

<Light Scattering Particles (B)>

The light scattering particles (B) of the present invention produce an effect of scattering light which is guided by total reflection within an organic EL device and extracting the light.
The type of the light scattering particles (B) of the present invention is not limited. The light scattering particles (B) may be organic particles or inorganic particles. Examples of organic particles to be used include polymethyl methacrylate beads, acrylic-styrene copolymer beads, melamine resin beads, polycarbonate beads, polystyrene beads, cross-linked polystyrene beads, polyvinyl chloride beads, and benzoguanamine-melamine-formaldehyde condensate beads. Examples of inorganic particles to be used include $SiO_2$, $ZrO_2$, $TiO_2$, $Al_2O_3$, $In_2O_3$, ZnO, $SnO_2$, and $Sb_2O_3$. Two or more types of them may be used in combination.
In the second resin composition for light scattering layer of the present invention, the refractive index difference between the binder composition including at least the resin (A) and the light scattering particles (B) is 0.1 or more.
When the refractive index difference is 0.1 or more, the light guided by total reflection inside the EL device is scattered at the interface between the binder composition and the light scattering particles (B), which improves the light extraction efficiency. As the refractive index difference increases, the light extraction efficiency is improved.
The refractive index of the translucent substrate is generally about 1.5 and the refractive index of the translucent electrode is generally about 1.8 to 2.0. Accordingly, the refractive index of the binder composition is preferably 1.5 to 2.0. A refractive index of 1.65 or more is particularly desirable, because the refractive index of the binder composition is close to that of the translucent electrode and more light can be guided, and because the wavelength dependence on the light extraction efficiency is small, for example.
The refractive index of the binder composition is determined by the composition ratio of the components to be used. As described later, metallic oxide particles (C), which can be arbitrarily added, function as a refractive index adjustor of the binder composition. In the case of using organic particles, the refractive index of the light scattering particles (B) is generally 1.5 to 1.8. In the case of using inorganic particles, the refractive index of the light scattering particles (B) is generally 1.3 to 2.5. Accordingly, the refractive index difference can be set to be equal to or more than 0.1 by appropriately selecting the binder composition and the light scattering particles (B).
Examples of refractive index values are given below.
As the resin (A), for example, epoxy resin: 1.53 to 1.57, and acrylate resin: 1.49 to 1.59.
As the metallic oxide particles (C), for example, titanium oxide ($TiO_2$): 2.5, zirconium oxide ($ZrO_2$): 2.2, zinc oxide (ZnO): 1.9, and tin oxide ($SnO_2$): 2.0.
The refractive index of the binder composition including the resin (A) and the metallic oxide particles (C) as needed is preferably 1.5 to 2.0.
As the light scattering particles (B), for example, methacrylic acid ester copolymer beads: 1.45 to 1.60, acrylic-styrene copolymer beads: 1.5 to 1.6, melamine resin beads: 1.65, $SiO_2$: 1.45, $ZrO_2$: 2.2, and $TiO_2$: 2.5. Trifluoroethyl methacrylate copolymer beads: 1.46 and $TiO_2$: 2.5, which are capable of increasing the refractive index difference with respect to the binder composition, are preferably used.
The light scattering particles (B) used for the second resin composition for light scattering layer of the present invention have an average particle diameter of 200 nm to 1.0 $\mu$m. When the average particle diameter of the light scattering particles (B) is less than 200 nm, a sufficient scattering effect is not achieved. When the average particle diameter exceeds 1.0 $\mu$m, the surface roughness of the light scattering layer increases, so that film thickness unevenness occurs or protrusions are formed in the translucent electrode, which may cause luminance unevenness or reduction of lifetime. In the case of using inorganic particles, the average particle diameter is preferably 200 nm to 500 nm in terms of transmittance.
The amount of the light scattering particles (B) used in the present invention is preferably 1 to 20 mass% in the resin composition for light scattering layer, and more preferably, 1 to 10 mass%. When the amount is less than 1 mass%, a sufficient scattering effect is not achieved, and when the amount exceeds 20 mass%, particles are liable to aggregate, which increases the surface roughness of the light scattering layer.
In the second resin composition for light scattering layer of the present invention, the binder composition including at least one type of resin (A) may further include other arbitrary components. For example, the binder composition may further include the metallic oxide fine particles (C), the ethylenically unsaturated monomer (D), the silane compound (E), or a photopolymerization initiator.
As the photopolymerization initiator, the oxime ester-based photopolymerization initiator (F) is preferably used.
The above-mentioned arbitrary components can be used in the same amount as that of the first resin composition for light scattering layer of the present invention.
In the second resin composition for light scattering layer of the present invention, the binder composition

including at least one type of resin (A) may include arbitrary components other than the above-mentioned components, as in the first resin composition for light scattering layer of the present invention.

The second resin composition for light scattering layer of the present invention is used for forming the light scattering layer disposed between the translucent electrode and the translucent substrate to improve the light extraction efficiency of the organic EL device.

The use of the second resin composition for light scattering layer of the present invention achieves an organic EL device having a high light extraction efficiency without inducing fine cracking, protrusion, or peeling in the translucent electrode in the process of producing a laminated structure.

"Light Scattering Layer"

The light scattering layer of the present invention is formed using one of the first and second resin compositions for light scattering layer of the present invention described above.

The light scattering layer of the present invention is obtained such that the resin composition for light scattering layer is coated on a transparent substrate, such as glass, and is dried, and the obtained coating film is cured by heating or light irradiation of an ultraviolet ray or an electron beam, for example.

Examples of the coating method include:

methods using a lot, a wire bar, or the like; and
various coating methods such as micro gravure coating, gravure coating, die coating, curtain coating, lip coating, slot coating, or spin coating.

In the case of patterning the light scattering layer on the translucent substrate by using the resin composition for light scattering layer, it is possible to employ 1) a method of directly patterning the light scattering layer on the translucent substrate by a printing method, and 2) a method of patterning the light scattering layer by a photolithography method.

1) Examples of the printing method include a flexographic printing method, a gravure printing method, a gravure offset printing method, an offset printing method, a reverse offset printing method, a screen printing method, a relief-printing method, and an ink jet printing method.
2) In the photolithography method, the resin composition for light scattering layer is used in the form of a photosensitive resin composition. In this case, 2-1) a pattern may be formed by solution development or alkaline development after the resin composition for light scattering layer of the present invention is directly coated on the translucent substrate and is dried. Alternatively, 2-2) a pattern may be formed by solution development or alkaline development after a photosensitive dry film is obtained by coating the resin composition for light scattering layer of the present invention, which is dissolved in a solvent on a film base material (hereinafter referred to as "separate film"), and drying the solvent, and the photosensitive dry film thus obtained is bonded to the translucent substrate to form the light scattering layer by performing adhesion onto the translucent substrate by atmospheric lamination or vacuum lamination and removing air bubbles and the like.

The thickness of the light scattering layer is not particularly limited, but in general, a thickness of 0.5 to 20 μm is preferable.

In the case of applying the light scattering layer of the present invention to the organic EL device, when the wavelength dependence on the refractive index of the light scattering layer is large, there is a problem that a variation in the luminance of each color dot causes deterioration in the white balance. For this reason, the light scattering layer preferably has a small refractive index difference in each wavelength. Specifically, assuming that refractive indexes at wavelengths of 473 nm, 594 nm, and 633 nm, which are measured by a prism coupler, are represented by n (473), n (594), and n (633), respectively, the values of the n (473)/n (594) and n (633)/n (594) are preferably 0.2 to 2.0, more preferably, 0.5 to 1.5, and most preferably, 0.95 to 1.05.

"Organic EL Device"

The organic EL device of the present invention includes a light scattering layer formed using a resin composition for light scattering layer.

The structure of the organic EL device is not particularly limited. As an example of the basic structure, there is employed a bottom emission structure in which a translucent electrode, at least one organic layer (organic EL layer) including a luminous layer, a back electrode, and a TFT substrate are sequentially laminated on a translucent substrate and light is extracted from an anode side. As another example of the basic structure, there is employed a top emission

structure in which a back electrode, at least one organic layer (organic EL layer) including a luminous layer, a translucent electrode, and a sealing layer are sequentially laminated on a TFT substrate and light is extracted from a cathode side. As for these techniques, see "All About Organic EL" written by Junji Kido, Nippon Jitsugyo Publishing Co., Ltd.

(issued in 2003), for example.

The structure of the organic EL device according to an exemplary embodiment of the present invention will be described with reference to the drawings. Fig. 1 is a schematic sectional view of the organic EL device having a bottom emission structure.

An organic EL device 1 according to this exemplary embodiment has a configuration in which a light scattering layer 12, a first electrode (anode, translucent electrode) 1 having translucency, at least one organic layer (organic EL layer) 14 including a luminous layer, and a second electrode (cathode, back electrode) 15 having light reflectivity are sequentially laminated on a translucent substrate 11.

The light scattering layer 12 is a layer formed using the above-described first or second resin composition for light scattering layer of the present invention.

The organic EL device can be used for an organic EL lighting device, an organic EL display device, or the like.

In an active matrix type organic EL display device, a plurality of luminous layers, which emit a plurality of light beams of different colors, is formed in an array in a matrix manner. A TFT substrate on which pixel electrodes including the second electrode (cathode, back electrode) 15, and TFTs (thin-film transistors) serving as switching elements are formed is provided for each dot.

The light scattering layer of the present invention can be formed at an arbitrary position in the organic EL device.

In the case of the bottom emission structure, the following positions can be taken, for example.

(1) In the order from the lowermost layer (the same applied hereinafter), translucent substrate / light scattering layer / translucent electrode / organic EL layer / back electrode,
(2) light scattering layer / translucent substrate / translucent electrode / organic EL layer / back electrode,
(3) light scattering layer / translucent substrate / light scattering layer / translucent electrode / organic EL layer / back electrode.

In the case of the top emission structure, the following positions can be taken, for example.

(4) In the order from the lowermost layer (the same applied hereinafter), substrate / back electrode / organic EL layer / translucent or semi-translucent electrode / light scattering layer / protective substrate,
(5) substrate / back electrode / organic EL layer / translucent or semi-translucent electrode / sealing layer / light scattering layer / protective substrate,
(6) substrate / back electrode / organic EL layer / translucent or semi-translucent electrode / sealing layer / protective substrate / light scattering layer,
(7) substrate / back electrode / organic EL layer / translucent or semi-translucent electrode / light scattering layer / protective substrate / light scattering layer.

Among them, the organic EL device in which the light scattering layer is formed between the translucent substrate and the translucent electrode is preferable in terms of the light extraction efficiency.

In the method of producing the organic EL device having the bottom emission structure, the light scattering layer is formed on the translucent substrate as described above, and the translucent electrode is then formed on the light scattering layer. As the material of the translucent electrode, metal, an alloy, a metallic oxide, an electroconductive compound, or a mixture thereof can be used, for example. A material having a work function of 4 eV or more is preferably used.

Specific examples of the material include:

a conductive metallic oxide such as a tin oxide, a zinc oxide, an indium oxide, and an indium tin oxide (ITO);
metal such as gold, silver, chrome, and nickel;
other inorganic conductive materials such as copper iodide and copper sulfide;
organic conductive materials such as polyaniline, polythiophene, and polypyrole; and
a mixture or laminate thereof.

A conductive metallic oxide is preferably used, and especially, an ITO is preferably used in terms of productivity, high conductivity, and translucency, for example.

To control the injection property of electrons or holes to the organic EL layer while maintaining the translucency,

the translucent electrode can also be formed by laminating an ultrathin metal and an ITO. In this case, the ultrathin metal preferably has a thickness of 0.1 nm to 20 nm from the viewpoint of maintaining the translucency.

Examples of the material of the ultrathin metal include:

alkali metals (for example, Li, Na, and K) and a fluoride thereof;
alkaline earth metals (for example, Mg and Ca) and a fluoride thereof;
gold, silver, lead, aluminum, a sodium-potassium alloy, and a mixed metal including the same;
a lithium-aluminum alloy and a mixed metal including the same;
an LiF/Al alloy and a mixed metal including the same;
a magnesium-silver alloy and a mixed metal including the same; and rare earth metals such as indium and ytterbium.

Among them, a material having a work function of 4 eV or less is preferably used, and aluminum, a lithium-aluminum alloy, and a mixed metal thereof, a magnesium-silver alloy, and a mixed metal thereof are more preferably used, for example.

The film thickness of the translucent electrode can be appropriately selected depending on the material. In general, a film thickness of about 50 nm to 300 nm is preferable.

As a method of forming the translucent electrode, an electron beam method, a sputtering method, a resistance heating deposition method, a chemical reaction method (sol-gel method etc.), and coating of a dissolved material or a dispersed material are employed.

The formed translucent electrode is subjected to etching processing, as needed, to form a pattern. Further, cleaning and other processing may be performed to thereby lower the drive voltage of the device and improve the luminous efficiency. For example, in the case of using an ITO, UV-ozonation or the like is effective.

Then, after the translucent electrode is formed on the surface of the light scattering layer in the manner as described above, the organic EL layer is formed on the surface of the translucent electrode.

The organic EL layer includes a luminous layer, and may further include a hole injection layer, a hole transport layer, an electron injection layer, an electron transport layer, or the like. These layers may have other functions.

The material of the hole injection layer and the hole transport layer are not particularly limited, as long as the material has one of a function of injecting holes from an anode, a function of transporting holes, and a function of blocking electrons injected from a cathode. Specific examples of the material include a carbazole derivative, a triazole derivative, an oxazole derivative, an oxadiazole derivative, an imidazole derivative, a polyarylalkane derivative, a pyrazoline derivative, a pyrazolone derivative, a phenylene diamine derivative, an aryl amine derivative, an amino substituted chalcone derivative, a styrylanthracene derivative, a fluorenone derivative, a hydrazone derivative, a stilbene derivative, a silazane derivative, an aromatic tertiary amine compound, a styrylamine compound, an aromatic dimethylidyne-based compound, a porphyrin-based compound, a polysilane-based compound, a poly(N-vinylcarbazole) derivative, an aniline-based copolymer, and an electrically conductive polymer or oligomer such as a thiophene oligomer and polythiophene.

The material of the luminous layer is not particularly limited, as long as the material can form a layer having a function that allows holes to be injected from the anode, the hole injection layer, or the hole transport layer and allows electrons to be injected from the cathode, the electron injection layer, or the electron transport layer during application of an electric field, a function of moving the injected electric charges, and a function of providing a field for recombining holes and electrons to be emitted.

Examples of the material include:

various metal complexes typified by a metal complex or a rare-earth complex of benzoxazole derivatives, benzimidazole derivatives, benzothiazole derivatives, styrylbenzene derivatives, polyphenyl derivatives, diphenylbutadiene derivatives, tetraphenylbutadiene derivatives, naphthalimide derivatives, coumarin derivatives, perylene derivatives, perinone derivatives, oxadiazole derivatives, aldazine derivatives, pyrrolidine derivatives, cyclopentadiene derivatives, bisstyrylanthracene derivatives, quinacridone derivative, pyrrolopyridine derivatives, thiadiazolopyridine derivatives, cyclopentadiene derivatives, styrylamine derivatives, aromatic dimethylidine compounds, and 8-quinolinol derivatives; and
a polymer compound such as polythiophene, polyphenylene, and polyphenylenevinylene.

Specific examples of the emission material used for the luminuous layer are given below. However, the emission material is not limited to the following specific examples.

Blue light emission can be obtained by using perylene, 2,5,8,11-tetra-t-butyl perylene (abbreviation: TBP), a 9,10-diphenylanthracene derivative, and the like as a guest material, for example. Blue light emission can also be obtained by using styrylarylene derivatives such as 4,4'-bis(2,2-diphenylvinyl)biphenyl (abbreviation: DPVBi), and anthracene derivatives such as 9,10-di-2-naphthylanthracene (abbreviation: DNA) and 9,10-bis(2-naphthyl)-2-tert-butyanthracene (abbreviation: t-BuDNA). Polymers such as poly(9,9-dioctylfluorene) can also be used.

Green light emission can be obtained by using, as a guest material, coumarin-based dyes such as coumarin 30 and coumarin 6, bis[2-(2,4-difluorophenyl)pyridinato]picolinato iridium (abbreviation: FIrpic), bis(2-phenylpyridinato) acetylacetonato iridium (abbreviation: Ir(ppy)(acac)), and the like. Green light emission can also be obtained by using a metal complex such as tris(8-hydroxyquinoline)aluminum (abbreviation: $Alq_3$), BAlq, Zn (BTZ), and bis(2-methyl-8-quinolinolato)chlorogallium (abbreviation: Ga $(mq)_2Cl$). Polymers such as poly(p-phenylenevinylene) can also be used.

Light emission from orange to red is obtained by using, as a guest material, rubrene, 4-(dicyanomethylene)-2-[p-(dimethylamino)styryl]-6-methyl-4H-pyrane (abbreviation: DCM1), 4-(dicyanomethylene)-2-methyl-6-(9-julolidyl) ethynyl-4H-pyrane (abbreviation: DCM2), 4-(dicyanomethylene)-2,6-bis[p-(dimethylamino)styryl]-4H-pyrane (abbreviation: BisDCM), bis[2-(2-thienyl)pyridinato]acetylacetonatoiridium (abbreviation: $Ir(thp)_2(acac)$), bis(2-phenylquinolinato) acetylacetonatoiridium (abbreviation: Ir(pq)(acac)), and the like. Light mission from orange to red is also obtained by using a metal complex such as bis(8-quinolinolato)zinc (abbreviation: $Znq_2$) and bis[2-cinnamoyl-8-quinolinolato]zinc (abbreviation: $Znsq_2$). Polymers such as poly(2,5-dialkoxy-1 ,4-phenylenevinylene) can also be used.

Examples of a structure for emitting white light include: a structure (EP Patent No. 0390551) that defines an energy level of each layer of an organic EL laminate and emits light by using tunnel injection; a white emission element (Japanese Unexamined Patent Application Publication No. 03-230584) which is illustrated as an embodiment of an element that also uses tunnel injection; a luminous layer of a two-layered structure (Japanese Unexamined Patent Application Publication Nos. 02-220390 and 02-216790); a structure in which a luminous layer is divided into a plurality of parts which are formed of materials with different emission wavelengths (Japanese Unexamined Patent Application Publication No. 04-51491); a structure (Japanese Unexamined Patent Application Publication No. 06-207170) in which a blue luminous body (having a fluorescence peak of 380 to 480 nm) and a green luminous body (480 to 580 nm) are laminated and a red fluorescent material is also included; and a structure (Japanese Unexamined Patent Application Publication No. 07-142169) in which a blue luminous layer includes a blue fluorescent dye, a green luminous layer includes a red fluorescent dye, and a green fluorescent material is also included.

The material of each of the electron injection layer and the electron transport layer is not particularly limited, as long as the material has any one of a function of injecting electrons from a cathode, a function of transporting electrons, and a function of blocking holes injected from an anode.

Specific examples of the material include:

various metal complexes as typified by a metal complex of triazole derivatives, oxazole derivatives, oxadiazole derivatives, fluorenone derivatives, anthraquinodimethane derivatives, anthrone derivatives, diphenylquinone derivatives, thiopyran dioxide derivatives, carbodiimide derivatives, fluorenylidenemethane derivatives, distyrylpyrazine derivatives, heterocyclic tetracarboxylic acid anhydride, such as naphthaleneperylene, silole derivatives, phthalocyanine derivatives, or 8-quinolinol derivatives; and a metal complex in which the ligand is metal phthalocyanine, benzoxazole or benzothiazole.

The film thickness of each of the hole injection layer, the hole transport layer, the luminous layer, the electron injection layer, and the electron transport layer is not particularly limited, but is preferably 10 nm to 500 nm in general. Each of the layers may have a single-layer structure, or a multilayer structure composed of a plurality of layers of a homogeneous composition or a heterogeneous composition.

The method of forming these layers are not particularly limited, but methods such as a resistance heating deposition method, an electron beam deposition method, a sputtering method, a molecular lamination method, a coating method (such as a spin coating method, a casting method, and a dip coating method), and an LB (Langmuir Blodgett) method are employed, for example. A resistance heating deposition method and a coating method are preferably employed.

Lastly, a back electrode is formed on the surface of the organic EL layer.

The back electrode serving as an anode supplies electrons to the electron injection layer, the electron transport layer, the luminous layer, and the like, and is selected in consideration of the adhesive properties with respect to adjacent layers, ionization potential, stability, and the like.

The back electrode preferably has light reflectivity.

As the material of the back electrode, a metal, an alloy, a conductive metallic oxide, other conductive compounds, and a mixture thereof can be used.

Specific examples of the material include:

alkali metals (for example, Li, Na, and K) and a fluoride thereof;
alkaline earth metals (for example, Mg and Ca) and a fluoride thereof;
gold, silver, lead, aluminum, a sodium-potassium alloy, and a mixed metal thereof;
a lithium-aluminum alloy and a mixed metal thereof;
an LiF/Al alloy and a mixed metal thereof;

a magnesium-silver alloy and a mixed metal thereof; and
rare earth metals such as indium and ytterbium.

A material having a work function of 4e V or less is preferably used. More preferably, aluminum, a lithium-aluminum alloy, and a mixed metal thereof, and a magnesium-silver alloy and a mixed metal thereof are used, for example.
To control the injection property of electrons or holes to the organic layer while maintaining the translucency, the back electrode can also be formed by laminating the above-mentioned material of the back electrode and an ITO.
The film thickness of the back electrode can be appropriately selected, but is preferably 100 nm to 1 $\mu$m in general. To prepare the back electrode, methods such as an electron beam deposition method, a sputtering method, a resistance heating deposition method, and a coating method are employed. It is possible to deposit a metal alone or deposit two or more components simultaneously. Furthermore, an alloy electrode can be formed by depositing a plurality of metals simultaneously. Moreover, a preliminarily adjusted alloy can be deposited as well.
Examples of the method of producing an organic EL device having a top emission structure include a method in which a back electrode, an organic EL layer, a translucent electrode, and a light scattering layer are sequentially laminated on a substrate such as a TFT substrate. The material and lamination method of the back electrode, the organic EL layer, the translucent electrode, and the light scattering layer are similar to those described in the method of producing a bottom emission structure.
To improve the stability of the organic EL device with respect to the temperature, humidity, atmosphere, or the like, a protective layer may be formed on the surface of the device, or between layers, or coating or sealing may be performed on the entire device with a resin or the like. In the case of coating or sealing the entire device, molten glass or a light curable resin that is cured with light, for example, are preferably used as the material.
A DC current is generally applied to the organic EL device including the light scattering layer of the present invention, but a pulse current or an AC current may also be used. A current value and a voltage value are not particularly limited, as long as the values fall within the range in which element destruction is not caused. In consideration of the power consumption and lifetime of the device, it is desirable to emit light efficiently with as small electric energy as possible.
As a drive system for the organic EL device including the light scattering layer of the present invention, an active matrix system using a pixel switching element such as a TFT, and a passive matrix system using no pixel switching element can be used. As for these drive systems, see "All About Organic EL" written by Junji Kido, Nippon Jitsugyo Publishing Co., Ltd. (issued in 2003), for example.
Light emitted from the organic EL layer by applying a voltage between the translucent electrode and the back electrode of the organic EL device formed as described above is transmitted through the light scattering layer from the translucent electrode, and is further transmitted through the translucent substrate and is extracted. When the light emitted from the organic EL layer passes through the light scattering layer, the light is scattered and the directivity of the light varies, which suppresses the totally-reflected light from being guided.
The organic EL device including the light scattering layer of the present invention can be applied in various forms.
For example, the organic EL device of the present invention can be used as a full-color display device.
Examples of the full-color system include a three-color separation system, a color conversion system, and a color filter system.
In the three-color separation system, a deposition method using a shadow mask, an ink jet method, a printing method, and the like are used. Furthermore, a laser heat transfer method (Laser Induced Thermal Imaging, which is also called an LITI method), which is disclosed in Published Japanese Translation of PCT International Publication for Patent Application, No. 2002-534782 and S. T. Lee, et. al., Proceedings of SID'02, p. 784 (2002), for example, can also be used.
In the color conversion system, a luminous layer that emits blue light is used, and the light is converted into green and red light having a wavelength longer than that of the color of the light emitted from the luminous layer, through a color conversion (CCM) layer in which a fluorescent dye is dispersed.
The color filter system is a method in which an organic EL emission device for emitting white light is used and light beams of three primary colors are extracted through a color filter. In this system, the three primary colors as well as a part of white light is directly extracted and used, which can increase the luminous efficiency of the entire device.
The organic EL device of the present invention may have a micro-cavity structure. The organic EL device has a structure in which a luminous layer is sandwiched between an anode and a cathode, and emitted light causes a multiple interference between the anode and the cathode. In the micro-cavity structure, the multiple interference effect is actively used by appropriately selecting the optical characteristics, such as the reflectance and transmittance of the anode and the cathode, and the film thickness of an organic layer sandwiched between the anode and the cathode, and the emission wavelength extracted from the device is controlled, thereby improving the emission chromaticity. As for the mechanism of the multiple interference effect, see J. Yamada et. al., AM-LCD Digest of Technical
Papers, OD-2, pp. 77 to 80 (2002), for example.
The organic EL device of the present invention may employ a multiphoton emission device structure in which

a plurality of light emitting units including at least one luminous layer is laminated so as to be connected in series through an electric charge generation layer (for example, see Japanese Patent No. 3933591, etc.). According to such a device structure, light emission from a plurality of luminous layers can be obtained at the same time with the same amount of current as that of one unit device. Therefore, the current efficiency and external quantum efficiency corresponding to a multiple of the number of the light emitting units can be obtained.

The organic EL device including the light scattering layer of the present invention can be applied to a flat panel display, such as a wall-hanging television, various types of planar luminous bodies, light sources of a copying machine, a printer, and the like, light sources of a liquid crystal display, a measuring instrument, and the like, a display board, and a marker lamp.

[Examples]

Hereinafter, the present invention will be described in more detail with reference to examples. However, the following examples are not intended to limit the scope of the claim of the present invention. Unless otherwise stated, the term "part" indicates "a part by mass", and "%" indicates "mass%".

First, a description is made of methods for measuring the 5% decomposition temperature of the resin (A), the mass average molecular weight (Mw) of the resin (A) and the silane compound (E), the double bond equivalent of each of the resin (A) and the ethylenically unsaturated monomer (D), the acid value of the resin (A), and the particle diameter of the light scattering particles (B) and the metallic oxide fine particles (C).

(5% Decomposition Temperature)

The 5% decomposition temperature was measured at a rate of temperature increase of 10°C/min under an air flow of 200 ml/min by use of a differential thermal/thermogravimetric simultaneous measurement apparatus EXSTER TG/DTA6300 manufactured by Seiko Instruments Inc., and the temperature at which the mass of a resin sample was 95% before temperature increase was obtained.

(Mass average Molecular Weight (Mw))

The mass average molecular weight (Mw) was measured by a gel permeation chromatography GPC-101 manufactured by Showa Denko K.K. The polystyrene-reduced molecular weight was obtained by using THF (tetrahydrofuran) as a solvent.

(Double Bond Equivalent)

The double bond equivalent is a measure for the amount of double bond included in a molecule. In the case of using compounds having the same molecular weight, as the value of the double bond equivalent decreases, the amount of introduced double bond increases.

The double bond equivalent was calculated by the following formula. [double bond equivalent]=[molecular weight of monomer components having double bond]/[mass ratio of monomer components having double bond to all monomers in molecule]

(Acid Value)

The acid value (JIS acid value) was obtained by the following method.

One gram of sample was dissolved in a titration solvent obtained by mixing xylene and dimethylformamide at a mass ratio of 1:1. By a potentiometric titration method, titration was performed using 0.1 mol/L of potassium hydroxide solution (ethanol was used as a solvent).

With an inflection point on a titration curve as an end point, the acid value was calculated by the following formula based on the titre to the end point of the potassium hydroxide solution.

$$A=(B-C)\times f\times D/S$$

(Symbols in the formula are as follows:

A: an acid value (mg KOH/g); B: loads (mL) of potassium hydroxide solution used in a main test; C: loads (mL) of potassium hydroxide solution used in a blank test (measurement without using any measurement sample); f: a factor of potassium hydroxide solution; D: concentration converted value = 5.611 mg/mL (an equivalent of potassium hydroxide in 1 mL of potassium hydroxide solution of 0.1 mol/L); and S: sample (g))

(Particle Diameter)

The particle diameter was measured by "Nanotrac UPA" manufactured by Nikkiso Co., Ltd. A few drops of the light scattering particle dispersion liquid, the concentration of solids content mass% of which was adjusted to 20%, were dropped into a cell filled with the same solvent as the dispersion liquid, and the concentration was measured when the signal level reached an optimum value.

[Production Examples 1-1 to 1-22, Examples 1-1 to 1-31, Comparative Examples 1-1 to 1-4]

(1-1) Preparation of resin (A) solution

(Production Example 1-1)

Process 1:

In a reaction container including a stirrer, a thermometer, a dropping device, a reflux cooler, and a gas introducing tube, 100 parts of PGMEA (propyleneglycol monomethyl ether acetate) were introduced as a solvent. A nitrogen gas was injected into this container and heated to 80°C. This temperature was held, and a mixture of 5.0 parts of styrene (St), 15.9 parts of cyclohexyl methacrylate (CHMA), 31.7 parts of methacrylic acid (MAA), and 3.0 parts of 2,2'-azobisisobutyronitrile was dropped for one hour and was subjected to polymerization reaction. After completion of dropping, the mixture was further subjected to reaction for three hours at 70°C. After that, a solution obtained by dissolving 0.5 parts of azobisisobutyronitrile into 40 parts of PGMEA was added and continuously stirred at the same temperature for three hours, so that a copolymer was obtained.

Process 2:

Next, dry air was introduced into the reaction container, and 50.0 parts of glycidyl methacrylate (GMA), 37.0 parts of PGMEA, 0.6 parts of dimethylbenzylamine, and 0.1 parts of methoquinone were fed and then stirred for 10 hours at the same temperature. After the solution was cooled to the room temperature, the solution was diluted with PGMEA, so that a resin solution (A1-1) having a solids content of 35 mass% was obtained.

The main reaction conditions (feed composition and reaction temperature) and evaluation results of the obtained resin are shown in Table 1.

(Production Examples 1-2 to 1-10)

Resin solutions (A1-2) to (A1-10) were obtained in the same manner as in Production Example 1-1, except that the reaction conditions (feed composition and reaction temperature) were changed to those shown in Table 1.
Abbreviations in Table 1 are as follows:

PGMEA: propylene glycol monomethyl ether acetate;
DCPMA: dicyclopentanyl methacrylate;
CHMA: cyclohexyl methacrylate;
St: styrene;
M-110: p-cumylphenol ethylene oxide modified acrylate;
HEMA: hydroxyethyl methacrylate;
MAA: methacrylic acid;
GMA: glycidyl methacrylate; and
MMA: methyl methacrylate.

The loadings in Table 1 are represented in units of "part".

(1-2) Preparation of dispersion liquid of light scattering particles (B)

(Production Example 1-11)

Process 1: Production of a dispersant (T1-1)

In a 4-necked flask including a stirrer, a reflux condenser tube, a dry air inlet tube, and a thermometer, 80.0 parts of biphenyl tetracarboxylic acid dianhydride (manufactured by Mitsubishi Chemical Corporation), 250.0 parts of pentaerythritol triacrylate (manufactured by NIPPON KAYAKU Co., Ltd., Product Name: KAYARAD PET-30), 0.16 parts of hydroquinone (manufactured by Wako Pure Chemical Industries, Ltd.), and 141.2 parts of cyclohexanone were fed and heated to 85°C. Next, 1.65 parts of 1,8-diazabicyclo[5.4.0]-7-undecene (manufactured by Tokyo Chemical Industry Co., Ltd.) were added as a catalyst and stirred for eight hours at 85°C. After that, 77.3 parts of glycidyl methacrylate (manufactured by Dow Chemical Japan Ltd.) and 33.9 parts of cyclohexanone were added, and then, 2.65 parts of dimethylbenzylamine (manufactured by Wako Pure Chemical Industries, Ltd.) were added as a catalyst, were stirred for six hours at 85°C, and were cooled to the room temperature, so that the reaction was completed.

The obtained reaction solution was pale yellow, transparent, and had a solids content of 70 mass%. The mass average molecular weight (Mw) of the reaction product was about 3130.

Process 2: Production of dispersion liquid

As a dispersion medium, 84.3 g of methyl isobutyl ketone and 5.7 g of the above-mentioned dispersant (T1-1) were added to 10 g of titanium oxide ($TiO_2$) particles having an average primary particle diameter of 250 nm. Zirconia beads (1.25 mm) were used as media, and dispersion processing was carried out for one hour by use of a dynomill. Thus, a light scattering particle dispersion liquid (B1-1) (titanium oxide particle dispersion) was prepared.

Table 2 shows the composition of the light scattering particle dispersion liquid (B1-1), the dispersion device, the primary particle diameter of particles, the diameter of particles in the dispersion liquid, the content of particles having a particle diameter of 600 nm or more with respect to the total amount of particles in the dispersion liquid, and the coefficient of variation of particles in the dispersion liquid.

(Production Example 1-12)

Under an $N_2$ atmosphere, in a mixed solvent of 58 g of methanol and 32 g of water, 4.5 g of methyl methacrylate (manufactured by Wako Pure Chemical Industries, Ltd.), 5 g of trifluoroethyl methacrylate (manufactured by Wako Pure Chemical Industries, Ltd.), and 0.5 g of allyl methacrylate (manufactured by Wako Pure Chemical Industries, Ltd.) were polymerized for eight hours at 60°C by use of 0.025 g of 2,2'-azobis(2-amidinopropane)dihydrochloride (manufactured by Wako Pure Chemical Industries, Ltd., V-50). After that, 123 g of PGMEA 123 g were added, and methanol and water were removed by stripping. Thus, a light scattering particle dispersion liquid (B1-2) (acrylic resin particle dispersion liquid) was prepared.

Table 2 shows the composition of the light scattering particle dispersion liquid (B1-2), the dispersion device, the primary particle diameter of particles, the diameter of particles in the dispersion liquid, the content of particles having a particle diameter of 600 nm or more with respect to the total amount of particles in the dispersion liquid, and the coefficient of variation of particles in the dispersion liquid.

(Production Example 1-13)

Under an $N_2$ atmosphere, in a mixed solvent of 62 g of methanol and 28 g of water, 4.5 g of methyl methacrylate (manufactured by Wako Pure Chemical Industries, Ltd.), 5 g of trifluoroethyl methacrylate (manufactured by Wako Pure Chemical Industries, Ltd.), and 0.5 g of allyl methacrylate (manufactured by Wako Pure Chemical Industries, Ltd.) were polymerized for eight hours at 60°C by using 0.025 g of 2,2'-azobis(2-amidinopropane)dihydrochloride (V-50, manufactured by Wako Pure Chemical Industries, Ltd.). After that, 119 g of PGMEA were added, and methanol and water were removed by stripping. Thus, a light scattering particle dispersion liquid (B1-3) (acrylic resin particle dispersion liquid) was prepared.

Table 2 shows the composition of the light scattering particle dispersion liquid (B1-3), the dispersion device, the primary particle diameter of particles, the diameter of particles in the dispersion liquid, the content of particles having a particle diameter of 600 nm or more with respect to the total amount of particles in the dispersion liquid, and the coefficient of variation of particles in the dispersion liquid.

(Production Examples 1-14 to 1-18)

Light scattering particle dispersion liquids (B1-4) to (B1-8) were prepared in the same manner as in Process 2 in Production Example 1-11, except that the blended composition and the dispersion device were change to those shown in Table 2 and Table 3.
Evaluation results are shown in Table 2 and Table 3.
Abbreviations in Table 2 and Table 3 are as follows:

Titanium oxide 1: TIPAQUE CR-97 manufactured by Ishihara Sangyo Kaisha, Ltd.;
Titanium oxide 2: TIPAQUE CR-63 manufactured by Ishihara Sangyo Kaisha, Ltd.;
Silica: SEAHOSTAR KE-S30 manufactured by Nippon Shokubai Co., Ltd.; Melamine resin: EPOSTAR S6 manufactured by Nippon Shokubai Co., Ltd.; and
BYK-111: BYK-111 manufactured by BYK Japan KK.

(1-3) Preparation of dispersion liquid of metallic oxide fine particles (C)

(Production Example 1-19)

To 10 g of titanium oxide ($TiO_2$) fine particles having an average primary particle diameter of 15 nm, 84.3 g of PGMEA were added as a dispersion medium, and 5.7 g of dispersant (T1-1) obtained in Process 1 of Production Example 1-11 were added as a dispersant. Two steps of dispersion processing were performed on the solution thus obtained. In a pre-dispersion process, zirconia beads (average diameter: 1.25 mm) were used as media and dispersed by use of a paint shaker for one hour. In a main dispersion process, zirconia beads (average diameter: 0.1 mm) were used as media and dispersed for seven hours by use of a dispersion device UAM-015 manufactured by Kotobuki Industries Co., Ltd. In the manner as described above, a metallic oxide fine particle dispersion liquid (C1-1) (titanium oxide fine particle dispersion liquid) was prepared. The average particle diameter of titanium oxide fine particles in the dispersion liquid was 80 nm.

(1-4) Preparation of silane compound (E)

(Production Example 1-20)

A flask with a condenser tube was prepared as a reaction tank, and a solution was prepared by sufficiently stirring and mixing 100 g of 3-isocyanatopropyltriethoxysilane ("KBE-9007" manufactured by Shin-Etsu Chemical Co., Ltd.) and 50 g of ethanol (manufactured by Kishida Chemical Co., Ltd.), and was subjected to nitrogen substitution. After that, the solution was heated in an oil bath while being stirred, and the temperature of the reaction tank was raised to 60°C. After the temperature of the reaction tank was stabilized at 60°C, the solution was further stirred for eight hours. Completion of the reaction was confirmed by an FT-IR spectrum, and the temperature of the reaction tank was lowered to the room temperature, so that 130 g of (3-carbamate ethyl)propyl triethoxysilane ethanol solution having a solids content of 79 mass% were obtained.
A 100 mL 4-necked flask including a Dimroth-type cooler/condenser, a Dean-Stark apparatus, a stirrer, and a thermometer was prepared by being subjected to sufficient nitrogen substitution. Then, 100 g of (3-carbamate ethyl) propyl triethoxysilane ethanolsolution, which were obtained as described above, 25 mL of ethanol, and 0.06 g of sodium acetate were fed, and 1.3 g of water were added slowly. The solution thus obtained was matured for one hour at a temperature of 30 to 40°C under normal pressure, and was then matured for three hours under a reflux. The solvent was gradually extracted under normal pressure after the maturation, and heating was stopped when the temperature of the tank reached 105°C and the tank was cooled.
The solution thus obtained was filtered and dried for one hour at 120°C under a reduced pressure, so that a silane compound (E1-1), which was a transparent, oil-like product, was obtained. The mass average molecular weight (Mw) was about 5, 500.

(Production Example 1-21)

A flask with a condenser tube was prepared as a reaction tank, and a solution obtained by sufficiently stirring and mixing 100 g of 3-isocyanatopropyltriethoxysilane ("KBE-9007" manufactured by Shin-Etsu Chemical Co., Ltd.) and 100 g parts of 2,8-ethyl-1-tetradecanol was prepared and subjected to nitrogen substitution. After that, the solution was heated in an oil bath while being stirred, and the temperature of the reaction tank was raised to 60°C. After the temperature of the reaction tank was stabilized at 60°C, the solution was further stirred for 10 hours. Completion of the reaction was

confirmed by an FT-IR spectrum, and the temperature of the reaction tank was lowered to the room temperature. Then, the solution was extracted to a container, which was subjected to nitrogen substitution, so that a silane compound (E1-2) was obtained. The mass average molecular weight (Mw) was about 520.

(Production Example 1-22)

A flask with a condenser tube was prepared as a reaction tank, and a solution obtained by sufficiently stirring and mixing 100 g of 3-isocyanatopropyltriethoxysilane ("KBE-9007" manufactured by Shin-Etsu Chemical Co., Ltd.) and 100 g of ethanol (manufactured by Kishida Chemical Co., Ltd.) was prepared and subjected to nitrogen substitution. After that, the solution was heated in an oil bath while being stirred, and the temperature of the reaction tank was raised to 60°C. After the temperature of the reaction tank was stabilized at 60°C, the solution was further stirred for six hours. Confirmation of the reaction was confirmed by an FT-IR spectrum, and the temperature of the reaction tank was lowered to the room temperature. Then, the solution was extracted to a container, which was subjected to nitrogen substitution, so that a silane compound (E1-3) was obtained. The mass average molecular weight (Mw) was about 280.

(1-5) Preparation of a resin composition for light scattering layer

(Example 1-1)

To 15.00 g of the light scattering particle dispersion liquid (B1-1) obtained as described above, 36.86 g of the resin (A1-4) obtained as described above and 48.14 g of organic solvent PGMEA were added and uniformly stirred and mixed. The solution thus obtained was filtered with a filter having a mesh diameter of 5 μm. Thus, a resin composition for light scattering layer was prepared. The mass ratio of the solids in this composition was resin (A1-4) : light scattering particle (B1-1) (including a dispersant for dispersing light scattering particles) = 86 : 14.

Table 4 shows the blended composition.

(Examples 1-2 to 1-31 and Comparative Examples 1-1 to 1-4)

Resin compositions for light scattering layer were obtained in the same manner as in Example 1-1, except that the blended composition was changed to that shown in Table 4.

(Examples 1-32 to 1-91 and Comparative Examples 1-7 to 1-24)

Resin compositions for light scattering layer were obtained in the same manner as in Example 1-1, except that the blended composition was changed to that shown in Tables 5A and 5B, Tables 6A and 6B, and Tables 7A and 7B.

Abbreviations in Tables 5A and 5B, Tables 6A and 6B, and Tables 7A and 7B are as follows:

Heat-reactive compound (G);
MX-43: an alkoxyalkyl group-containing melamine compound "Nikalac MX-43" manufactured by Sanwa Chemical Co., Ltd.;
MX-417: an imino group/methylol group-containing melamine compound "Nikalac MX-417" Sanwa Chemical Co., Ltd.;
SB-401: an alkoxyalkyl group-containing benzoguanamine compound "Nikalac SB-401" manufactured by Sanwa Chemical Co., Ltd.;
BL-60: an imino group/methylol group-containing benzoguanamine compound "Nikalac BL-60" manufactured by Sanwa Chemical Co., Ltd.;
BL-4265: an isocyanate compound "Desmodur BL-4265" manufactured by Bayer AG; and
EPPN-201: an epoxy compound "EPPN-201" manufactured by NIPPON KAYAKU Co., Ltd.

(1-6) Evaluation

The obtained resin compositions for light scattering layer were evaluated by an apparatus or a method as described below.

(A refractive index of a binder composition, and a refractive index difference between the binder composition and the light scattering particles (B))

The binder composition was coated on a PEN (polyethylenenaphthalate) film with a finished film thickness of 2.0 μm by use of a spin coater. Next, the coated substrate thus obtained was held for two minutes on a hot plate which was heated to 110°C. After that, ultraviolet ray exposure was performed with an illuminance of 20 $mW/cm^2$ and an

exposure amount of 50 $mJ/cm^2$ by use of an extra-high pressure mercury lamp. The coated substrate was heated at 200°C for 30 minutes and was then cooled. After that, the refractive index (n1) of the binder composition was measured by an Abbe refractometer in accordance with Japanese Industrial Standard: JISK7142 "plastic refractive index measurement method". The below-mentioned value was used as the refractive index (n2) of the light scattering particles, and the difference between the refractive index (n1) of the binder composition and the refractive index (n2) of the light scattering particles was obtained.

(Refractive Index of Inorganic Particles) A refractive index of a literature value in a bulk.

(Refractive Index of Organic Particles) A theoretical refractive index (nD) calculated by the following formula.

$$\text{theoretical refractive index (nD)} = \Sigma Wm \times nm$$

Reference numerals in the above formula are as follows:

"m" represents the number of a monomer, and is a value equal to or greater than 1 ;
"Wm" represents a refractive index of a honopolymer of an m-th monomer; and
"nm" represents a copolymerization ratio of the m-th monomer (a mass ratio with respect to a total amount of monomer)).

Evaluation was made based on the following criteria.

- The refractive index of the binder composition

  1.65 or more: Good (o),
  Less than 1.65: Fair (Δ)

- The refractive index difference between the binder composition and the light scattering particles (B)

  $0.1 \leq |n1-n2|$: "Good (o)",
  $0.1 > |n1-n2|$: "Poor (×)"

(Visible light transmittance of light scattering layer)

The resin composition for light scattering layer was coated on a glass substrate (glass "EAGLE 2000" manufactured by Corning Incorporated) having a size of 100 mm × 100 mm and a thickness of 0.7 mm, with a finished film thickness of 2.0 μm after heating at 230°C for 20 minutes, by use of a spin coater. Next, the coated substrate thus obtained was held for two minutes on a hot plate, which was heated to 110°C, and ultraviolet ray exposure was performed with an illuminance of 20 $mW/cm^2$ and an exposure amount of 50 $mJ/cm^2$ by use of an extra-high pressure mercury lamp. The coated substrate was heated at 230°C for 20 minutes and was then cooled, and the transmittance of the obtained coating film at a wavelength of 400 nm was measured by use of a microspectrophotometer ("OSP-SP100" manufactured by Olympus Optical Co., Ltd.). Evaluation was made based on the following criteria.

A transmittance of 80% or more: Good (o),
A transmittance of less than 80%: Fair (Δ)

(Heat resistance; Measurement of transmittance after additional baking)

A substrate coated with the resin composition for light scattering layer obtained in the same manner as that prepared for measurement of the transmittance was heated at 300°C for 20 minutes, and was then cooled. After that, the transmittance of the obtained coating film at a wavelength of 400 nm was measured by use of a microspectrophotometer ("OSP-SP100" manufactured by Olympus Optical Co., Ltd.). Evaluation was made based on the following criteria.

A transmittance of 80% or more: Good (o),
A transmittance of less than 80%: Fair (Δ)

(Evaluation of an EL device having a bottom emission structure (light extraction efficiency, emission appearance (dark spot, unevenness), wavelength dependence))

An ITO film having a thickness of 150 nm was formed by a DC sputtering method on the substrate coated with the resin composition for light scattering layer, which was obtained in the same manner as that prepared for measurement of the transmittance, by use of an ITO ceramic target ($In_2O_3$:$SnO_2$=90:10 (mass ratio)). Thus, a translucent electrode (anode) was obtained.

The above-mentioned ITO film was etched using a photoresist, and a pattern was formed with an emission area of 5 mm × 5 mm. After ultrasonic cleaning was carried out, ozone cleaning was carried out by use of a low-pressure ultraviolet ray lamp. Then, organic EL layers were sequentially formed on the surface of the ITO in the following manner by a vacuum evaporation method.

First, CuPc was formed as a hole injection layer with a thickness of 15 nm. Next, α-NPD was formed as a hole transport layer with a thickness of 50 nm. Then, a red luminous layer shown in Table 8 was formed with a thickness of 40 nm, and an electron injection layer shown in Table 8 was formed with a thickness of 30 nm.

After that, Mg and Ag were co-deposited to form MgAg with a thickness of 100 nm. Then, Ag was further formed thereon from the viewpoint of preventing oxidation of MgAg, so that a back electrode (cathode) was obtained.

After the resultant was extracted from the vacuum deposition device, ultraviolet ray-curable epoxy resin was dropped on the cathode electrode side, and a slide glass was overlaid. Then, the epoxy resin was cured by use of a high-pressure ultraviolet ray lamp, so that the device was sealed.

In the same manner as described above, the luminous layer and the electron injection layer shown in Table 8 were used to prepare blue, green, and white emission elements.

Additionally, an EL device was obtained for evaluation by a method similar to that described above, except that a glass substrate having no light scattering layer formed thereon was used as a base material.

To each of the emission elements obtained using the luminous body shown in Table 8, a forward current of 10 $mA/cm^2$ was applied at room temperature, and the emission appearance (dark spot, unevenness) was observed. Further, the front luminance was measured by a spectral radiance meter "CS-2000" manufactured by Konica Minolta Sensing, Inc., and the ratio of improvement of the front luminance of the white emission element was calculated based on the front luminance of the EL device which was prepared using the substrate having no light scattering layer formed thereon. Further, the wavelength dependence of the light scattering layer was evaluated in terms of the difference in front luminance of the emission devices using the red, blue, and green luminous layers shown in Table 8, and the presence or absence of a change in the emission spectrum of the emission device using the white luminous layer. The emission spectrum was measured by MCPD-9800 manufactured by Otsuka Electronics Co., Ltd. Evaluation was made based on the following criteria.

- Emission Appearance (dark spot, unevenness)

  No dark spot or unevenness is observed: Good (o),
  A slight dark spot or unevenness is observed: Fair (Δ),
  A dark spot or unevenness is observed: Poor (×)

- Light Extraction Efficiency

  A ratio of improvement of the front luminance is 1.5-fold or more: Excellent (oo),
  A ratio of improvement of the front luminance is equal to or more than 1.2-fold and less than 1.5-fold: Good (o),
  A ratio of improvement of the front luminance is less than 1.2-fold: Fair (Δ)

- Wavelength Dependence

  A difference between the values of ratios of improvement of the front luminance of red, blue, and green is less than 10%, and the spectrum shape of white is not changed: Good (o),
  A difference between the values of ratios of improvement of the front luminance of red, blue, and green is equal to or more than 10% and less than 20%, and the spectrum shape of white is not changed: Fair (Δ),
  A difference between the values of ratios of improvement of the front luminance of red, blue, and green is equal to or more than 20%, and the spectrum shape of white is changed: Poor (×)

Evaluation results are shown in Table 9.

The deterioration of the emission appearance, or the wavelength dependence was observed in Comparative

Examples 1 to 3 in which particles that do not satisfy the following conditions were used as the light scattering particles (B). The conditions are such that the average diameter of the particles in the resin composition for light scattering layer is 200 nm to 500 nm and the content of particles having a particle diameter of 600 nm or more with respect to the total amount of light scattering particles is 20 vol% or less. In Comparative Example 1-4, the refractive index difference between the binder composition and the light scattering particles (B) was smaller than 0.1, so that the extraction efficiency was low.

In Examples 1-1 to 1-31, the organic EL device as described below was obtained. That is, in the organic EL device, the high light extraction efficiency was high; the emission appearance (dark spot, unevenness) was good; the wavelength dependence on the ratio of improvement of the light extraction efficiency was small; and the need for a complicated process, such as color separation for each color, was eliminated.

As compared with Examples 1-1, 1-4 to 1-10, and 1-19 having a binder refractive index of less than 1.65, in the other examples having a binder refractive index of 1.65 or more, the wavelength dependence was small in each color of white light, red, blue, and green. It has turned out that the wavelength dependence is extremely small when the binder refractive index is 1.65 or more.

Methods for evaluating other physical properties are described blow. (Measurement of adhesive properties with respect to glass and ITO)

The adhesive properties of the coating film of the substrate coated with the resin composition for light scattering layer which was obtained in the same manner as that prepared for measurement of the transmittance were evaluated by an adhesion property (cross-cut method) test in accordance with JISK5600-5-6, and the number of peelings in 25 grids was counted.

As the base material, glass "EAGLE 2000" manufactured by Corning Incorporated and an ITO film manufactured by GEOMATEC Co., Ltd. were used.

Evaluation was made based on the following criteria.

The number of peelings in the grids is 0: Excellent (oo),

The number of peelings in the grids is less than 1 (edge peeling: a level at which an edge of a grid is peeled off): Good (o),

The number of peelings in the grids is 1 to 3: Fair (Δ),

The number of peelings in the grids is greater than 3: Poor (×)

(ITO etchant resistance)

A coating film was formed on an ITO base material formed in the same manner as that prepared for measurement of the transmittance. The obtained substrate coated with the resin composition for light scattering layer was immersed in a solution of nitric acid/hydrochloric acid/water=0.1/1/1 (mass ratio) at 40°C for five minutes, and was washed with pure water and then left for 24 hours. The adhesive properties of the coating film of the obtained substrate were evaluated by an adhesion property (cross-cut method) test in accordance with JIS K5600-5-6, and the number of peelings in 25 grids was counted.

As the base material, an ITO film manufactured by GEOMATEC Co., Ltd. was used.

Evaluation was made based on the following criteria.

The number of peelings in the grids is 0: Excellent (oo),

The number of peelings in the grids is less than 1 (edge peeling: a level at which an edge of a grid is peeled off): Good (o),

The number of peelings in the grids is 1 to 3: Fair (Δ),

The number of peelings in the grids is greater than 3: Poor (×)

(Chemical resistance)

Substrates coated with the resin composition for light scattering layer obtained in the same manner as that prepared for measurement of the transmittance were immersed in acetone or isopropyl alcohol, and were subjected to ultrasonic cleaning for 10 minutes at 25°C. The adhesive properties of the coating film of each of the obtained substrates were evaluated by an adhesion property (cross-cut method) test in accordance with

JIS K5600-5-6, and the number of peelings in 25 grids was counted.

Evaluation was made based on the following criteria.

The number of peelings in the grids is 0: Excellent (oo),

The number of peelings in the grids is less than 1 (edge peeling: a level at which an edge of a grid is peeled off): Good (o),

The number of peelings in the grids is 1 to 3: Fair (Δ),

The number of peelings in the grids is greater than 3: Poor (×)

(Evenness)

The surface roughness of the coating film of the substrate coated with the resin composition for light scattering layer, which was obtained in the same manner as that prepared for measurement of the transmittance, was measured by a stylus film thickness gauge DECTAC-3 manufactured by ULVAC, Inc.

Evaluation was made based on the following criteria.

A surface roughness of less than 100 A: Excellent (oo),

A surface roughness of equal to or more than 100 A and less than 200Å: Good (o),

A surface roughness of 200A to 300 Å: Fair (Δ),

A surface roughness of more than 300 A: Poor (×)

(Development rate)

The resin composition for light scattering layer was coated on a glass substrate with a dried film thickness of 2.0 μm by a spin coating method, and was dried. This coated substrate was exposed to light with 60 mJ/$cm^2$ through a mask pattern by use of a high-pressure mercury lamp. After that, spray development was carried out with a pressure of 0.25 MPa by use of 0.04 mass% of potassium hydroxide aqueous solution (at a developer temperature of 26°C), and the time required for dissolving the coating film and exposing the substrate surface (time for development and dissolution) was measured.

Evaluation was made based on the following criteria.

A development time of less than 20 seconds: Excellent (oo),

A development time of equal to or more than 20 seconds and less than 60 seconds: Good (o),

A development time of equal to or more than 60 seconds: Poor (×)

Evaluation results are shown in Table 10.

As shown in Table 10, in Examples 1-16 to 1-20 and 1-21 to 1-31 in which the silane compound (E) was added, a coating film having excellent adhesive properties, etchant resistance, and chemical resistance was obtained.

<Evaluation of an organic EL device having a top emission structure and an organic EL device having a coating-type structure (light extraction efficiency, emission appearance (dark spot, unevenness))>

(Top emission structure A)

Aluminum was deposited on a glass substrate, which was subjected to ultrasonic cleaning with isopropyl alcohol and dried with dry nitrogen gas, with a thickness of 100 nm by a vacuum evaporation method. After that, an ITO ceramic target ($In_2O_3$:$SnO_2$=90 mass%:10 mass%) was used to form an ITO film with a thickness of 20 nm by a DC sputtering method and was patterned with an emission area of 5 mm × 5 mm. Thus, a back electrode (anode) formed of a laminate of aluminum and ITO was formed.

Then, organic EL layers were sequentially formed on the ITO film in the following manner by a vacuum evaporation method, without extracting them from the vacuum.

First, α-NPD was formed as a hole injection/hole transport layer with a thickness of 40 nm. Next, H1 and Ir-1 shown in Table 11 were formed with a thickness of 30 nm, while the deposition rate was adjusted to 100:6. Then, BAlq was formed as a hole block layer with a thickness of 10 nm. Further, Alq3 was formed as an electron transport layer with a thickness of 20 nm.

Next, magnesium was formed with a thickness of 2 nm by a vacuum evaporation method, and an ITO film was

formed with a thickness of 100 nm by a DC sputtering method using an ITO ceramic target ($In_2O_3$:$SnO_2$=90 mass%:10 mass%). Thus, a translucent electrode (cathode) formed of a laminate of magnesium and ITO was formed.

Then, the peripheral edge portions of the above-mentioned glass substrate and the substrates (substrates for sealing) coated with the resin composition for light scattering layer of Examples 1-16 to 1-31 and Comparative Example 1-4, which were prepared for measurement of the transmittance, were bonded together by use of an epoxy-based light-curable adhesive as a sealant. In this case, the light scattering layer side of each of the substrates coated with the resin composition for light scattering layer and the glass substrate were bonded together. Lastly, UV light was applied from the glass substrate side to cure the adhesive, so that the element was sealed. The element sealed with only the glass substrate was obtained as Comparative Example 1-5.

(Top emission structure B)

An aluminum film having a thickness of 100 nm and a lithium fluoride film having a thickness of 0.5 nm were sequentially formed on a glass substrate, which was subjected to ultrasonic cleaning with isopropyl alcohol and dried with dry nitrogen gas, by a vacuum evaporation method. These films were patterned with an emission area of 5 mm × 5 mm, and a back electrode (cathode) formed of a laminate of aluminum and lithium fluoride was formed.

Then, organic EL layers were sequentially formed on the lithium fluoride film in the following manner by a vacuum evaporation method, without extracting them from the vacuum.

First, Alq3 was formed as an electron transport layer with a thickness of 20 nm. Next, BAlq was formed as a hole block layer with a thickness of 10 nm. Then, H1 and Ir-1 shown in Table 11 were formed with a thickness of 30 nm, while the deposition rate was adjusted to 100:6. Next, $\alpha$-NPD was formed as a hole injection/hole transport layer with a thickness of 40 nm.

Then, an ITO film was formed with a thickness of 150 nm by a DC sputtering method using an ITO ceramic target ($In_2O_3$:$SnO_2$=90 mass%:10 mass%). Thus, a translucent electrode (anode) was obtained.

Then, the peripheral edge portions of the above-mentioned glass substrate and the substrates (substrates for sealing) coated with the resin composition for light scattering layer of Examples 1-16 to 1-31 and Comparative Example 1-4, which were prepared for measurement of the transmittance, were bonded together by use of an epoxy-based light-curable adhesive as a sealant. In this case, the light scattering layer side of each of the substrates coated with the resin composition for light scattering layer and the glass substrate were bonded together. Lastly, UV light was applied from the glass substrate side to cure the adhesive, so that the element was sealed. The element sealed with only the glass substrate was obtained as Comparative Example 1-5.

(Coating-type structure)

An ITO film having a thickness of 150 nm was formed on each of the substrates coated with the resin composition for light scattering layer of Examples 1-16 to 1-31 and Comparative Example 1-4, which were obtained in the same manner as that prepared for measurement of the transmittance, by a DC sputtering method using an ITO ceramic target ($In_2O_3$:$SnO_2$=90 mass%:10 mass%). Thus, a translucent electrode (anode) was obtained.

Next, the ITO film was etched using a photoresist and patterned with an emission area of 5 mm × 5 mm. After that, ultrasonic cleaning was carried out, and then ozone cleaning was carried out by use of a low-pressure ultraviolet ray lamp.

On the glass plate with an ITO electrode subjected to cleaning, PEDOT/PSS (poly(3,4-ethylenedioxy)-2,5-thiophene/polystyrene sulfonic acid (BAYTRON P VP CH8000 manufactured by Bayer AG) was deposited by a spin coating method, and a hole injection layer having a film thickness of 40 nm was obtained. Next, 60 parts by mass of PVK (Poly(9-vinylcarbazole) manufactured by Sigma-Aldrich Corporation), 3 parts by mass of Ir-2 shown in Table 12, and 37 parts by mass of ETM-1 were weighted, and were dissolved into toluene at a concentration of 2.0 mass% as a whole. Thus, a luminous layer having a film thickness of 70 nm was obtained by a spin coating method.

Further, on the luminous layer, a Ca film having a thickness of 20 nm and Al having a thickness of 200 nm were sequentially deposited to form an electrode (cathode), so that an organic EL device was obtained. Lastly, ultraviolet ray-curable epoxy resin was dropped on the cathode side, and a slide glass was overlaid. Then, the epoxy resin was cured by use of a high-pressure ultraviolet ray lamp, so that the element was sealed.

The element in which a glass substrate having no light scattering layer formed thereon was used in place of the substrate coated with the resin composition for light scattering layer was obtained as Comparative Example 1-6.

The emission appearance and luminous efficiency of the obtained emission element were measured by the above-described method.

The results are shown in Table 13.

As shown in Table 13, the same results were obtained in both the top emission structure and the coating-type structure.

<Evaluation as a photosensitive dry film>

The resin composition for light scattering layer used in Examples 1-16 to 1-31 and Comparative Examples 1-1, 1-2, and 1-4 was uniformly coated on a 12 μ PET film (S-12 manufactured by DU PONT-TORAY CO., LTD.) with a film thickness of 2 μm, and was dried for five minutes at 100°C and then cooled to the room temperature. After that, a biaxial orientation polypropylene film (OPP film) was laminated on the side of the resin composition for light scattering layer. Thus, a photosensitive dry film was obtained.

The OPP film was peeled from the photosensitive dry film, and was laminated by vacuum lamination on a glass substrate (glass EAGLE 2000 manufactured by Corning Incorporated). As the vacuum lamination conditions, the heating temperature was 60°C, the vacuum time was 60 seconds, the vacuum ultimate pressure was 2 hPa, the pressure was 0.4 MPa, and the pressurization time was 60 seconds.

Then, ultraviolet ray exposure was performed with an illuminance of 20 $mW/cm^2$ and an exposure amount of 50 $mJ/cm^2$ by use of an extra-high pressure mercury lamp. Further, the obtained substrate was heated at 230°C for 20 minutes and then cooled, so that a light scattering layer was obtained. For the light scattering layer thus obtained, an element was prepared and evaluated in the same manner as described above. Evaluation of the visible light transmittance of the light scattering layer, and the heat resistance (measurement of the transmittance after additional baking), evaluation (light extraction efficiency, emission appearance (dark spot, unevenness), wavelength dependence) of the bottom emission type EL device, measurement of adhesive properties with respect to glass and ITO, and evaluation of the ITO etchant resistance, chemical resistance, and evenness were carried out. The results were the same as those obtained in Examples 1-16 to 1-31 and Comparative Examples 1-1, 1-2, and 1-4.

<Evaluation of resin compositions for light scattering layer obtained by various printing processes>

(a) Reverse Offset Printing

(Reverse offset printing property)

By use of a thin-film printer shown in Fig. 2, the resin compositions for light scattering layer of Examples 1-32 to 1-51 and Comparative Examples 1-7 to 1-12 were printed on a glass substrate by continuous printing of lines with a line width of 100 μm, with a dried coating film thickness of 2 μm, while replacing an anilox roll as needed. Then, each line shape was observed.

Reference numerals in Fig. 2 are as follows:

21: dispenser; 22: doctor; 23: anilox roll; 24: printing cylinder; 25: convex plate; 26: silicone rubber blanket cylinder; 27: substrate; 28: printing table; and 29: coloring composition.

Evaluation was made based on the following criteria.

Good (o): A linear patter can be continuously printed on 30 or more plates. Poor (×): Distortion occurs in a linear pattern after continuous printing of about 30 plates.

(Evenness)

By use of the thin-film printer shown in Fig. 2, the resin compositions for light scattering layer of Examples 1-32 to 1-51 and Comparative Examples 1-7 to 1-12 were printed on a glass substrate, with a finished film thickness of 2 μm after heating at 230°C for 20 minutes, while replacing the anilox roll as needed. Further, a square light scattering layer of 100 mm × 100 mm was formed on the glass substrate. Then, this was held for two minutes on a hot plate which was heated to 110°C.

After that, in Examples 1-32 to 1-45 and Comparative Examples 1-7 to 1-9, ultraviolet ray exposure was carried out with an illuminance of 20 $mW/cm^2$ and an exposure amount of 50 $mJ/cm^2$ by use of an extra-high pressure mercury lamp. The coated substrate was heated at 230°C for 20 minutes, so that a light scattering layer was obtained. In Examples 1-46 to 1-51 and Comparative Examples 1-10 to 1-12, exposure was not performed and the coated substrate was directly heated at 230°C for 20 minutes, so that a light scattering layer was obtained.

For the light scattering layer obtained in each example, a bottom emission type organic EL device was prepared and evaluated in the same manner as described above.

Evaluation results are shown in Table 15.

The other evaluation results are shown in Tables 14 and 15. The other evaluation methods are similar to those of Example 1-1.

(b) Flexographic Printing

(Flexographic printing property)

A flexographic plate (DSF plate) having a line-and-space pattern (line width = 100 μm) was mounted on a second unit of a CI-type 6-color flexographic printer ("SOLOFLEX" (CI-type 6-color printer) manufactured by Windmoeller & Hoelscher KG, and the resin compositions for light scattering layer of Examples 1-53 to 1-71 and Comparative Examples 1-13 to 1-18 were sequentially printed on a glass substrate, with a dried coated film thickness of 2 μm, by use of a 165-line anilox roll (cell capacity of 26.5 $cm^2/m^3$). In this case, whether or not the resin compositions for light scattering layer were continuously transferred from the anilox roll to the plate was determined by visual observation.

Evaluation was made based on the following criteria.

A transfer property is good: Good (o),
**[0389]** A transfer property is poor: Poor (×)

(Evenness)

A flexographic plate (DSF plate) having a square pattern of 100 mm × 100 mm was mounted on the second unit of the CI-type 6-color flexographic printer ("SOLOFLEX" (CI-type 6-color printer) manufactured by Windmoeller & Hoelscher KG), and the resin compositions for light scattering layer of Examples 1-52 to 1-71 and Comparative Examples 1-13 to 1-18 were sequentially printed on a glass substrate, with a finished film thickness of 2.0 μm after heating at 230°C for 20 minutes, by use of the 165-line anilox roll (cell capacity of 26.5 $cm^2/m^3$). Then, this was held for two minutes on a hot plate which was heated to 110°C.
After that, the resin compositions for light scattering layer of Examples 1-52 to 1-65 and Comparative Examples 1-13 to 1-15 were subjected to ultraviolet ray exposure with an illuminance of 20 $mW/cm^2$ and an exposure amount of 50 $mJ/cm^2$ by use of an extra-high pressure mercury lamp. The coated substrate was heated at 230°C for 20 minutes and a light scattering layer was obtained. In the resin compositions for light scattering layer of Examples 1-66 to 1-71 and Comparative Examples 1-16 to 1-18, exposure was not performed and the coated substrate was directly heated at 230°C for 20 minutes, so that a light scattering layer was obtained. For the obtained light scattering layer, a bottom emission type organic EL device was prepared and evaluated in the same manner as described above.

Evaluation results are shown in Table 17.

The other evaluation results are shown in Tables 16 and 17. The other evaluation methods are similar to those of Example 1-1.

(c) Gravure Printing

(Gravure printing property)

The resin compositions for light scattering layer of Examples 1-52 to 1-71 and Comparative Examples 1-13 to 1-18 were printed on a glass substrate by continuous printing of lines with a line width of 100 μm, with a dried coating film thickness of 2 μm, by use of a gravure proof press and an etched plate having a plate depth of 30 micron. Then, each line shape was observed.

Evaluation was made based on the following criteria.

Good (o): A linear patter can be continuously printed on 30 or more plates. Poor (×): Distortion occurs in a linear pattern after continuous printing of about 30 plates.

(Evenness)

The resin composition for light scattering layer of Examples 1-52 to 1-71 and Comparative Examples 1-13 to 1-18 were sequentially printed on a glass substrate with a finished film thickness of 2.0 μm after heating at 230°C for 20 minutes, by use of a gravure proof press and an etched plate having a plate depth of 30 micron. Then, this was held for two minutes on a hot plate which was heated to 110°C.

After that, the resin compositions for light scattering layer of Examples 1-52 to 1-65 and Comparative Examples 1-13 to 1-15 were subjected to ultraviolet ray exposure with an illuminance of 20 mW/cm$^2$ and an exposure amount of 50 mJ/cm$^2$ by use of an extra-high pressure mercury lamp. The coated substrate was heated at 230°C for 20 minutes and a light scattering layer was obtained. In the resin composition for light scattering layer of Examples 1-66 to 1-71 and Comparative Examples 1-15 to 1-18, exposure was not performed and the coated substrate was directly heated at 230°C for 20 minutes, so that a light scattering layer was obtained. For the obtained light scattering layer, a bottom emission type organic EL device was prepared and evaluated in the same manner as described above.

Evaluation results are shown in Table 19.

The other evaluation results are shown in Table 18 and Table 19. The other evaluation methods are similar to those of Example 1-1.

(d) Ink Jet (IJ) Printing

(IJ printing property)

The resin compositions for light scattering layers obtained in Examples 1-72 to 1-91 and Comparative Examples 1-18 to 1-24 were discharged onto a PET (polyethylene terephthalate) substrate by use of an ink jet printer including a piezoelectric head capable of changing the frequencies of 4 to 10 KHz, and the printing state was visually observed. The discharge stability was evaluated based on the following criteria.

Good (o): Continuous printing and intermittent printing can be correctly performed at a predetermined position.

Poor (×): A defect occurs during printing, or printing cannot be performed at a predetermined position.

(Evenness)

The resin compositions for light scattering layers obtained in Examples 1-72 to 1-91 and Comparative Examples 1-19 to 1-24 were sequentially printed on a glass substrate with a finished film thickness of 2.0 μm after heating at 230°C for 20 minutes with a square pattern of 100 mm × 100 mm, by use of an ink jet printer including a piezoelectric head capable of changing the frequencies of 4 to 10 KHz. Then, this was held for two minutes on a hot plate which was heated to 110°C.

After that, in Examples 1-52 to 1-65 and Comparative Examples 1-13 to 1-15, ultraviolet ray exposure was performed with an illuminance of 20 mW/cm$^2$ and an exposure amount of 50 mJ/cm$^2$ by use of an extra-high pressure mercury lamp. The coated substrate was heated at 230°C for 20 minutes and a light scattering layer was obtained. In Examples 1-66 to 1-71 and Comparative Examples 1-16 to 1-18, exposure was not performed and the coated substrate was directly heated at 230°C for 20 minutes, so that a light scattering layer was obtained.

For the obtained light scattering layer, a bottom emission type organic EL device was prepared and evaluated in the same manner as described above.

Evaluation results are shown in Table 21.

The other evaluation results are shown in Table 20 and Table 21. The other evaluation methods are similar to those of Example 1-1.

The results of Examples 1-32 to 1-91 show that the light scattering layer formed using the resin composition for light scattering layer of the present invention can be formed by various printing methods, such as reverse offset printing, flexographic printing, gravure printing, and ink jet printing, and the same results as those obtained by coating and development by a spin coater method were obtained.

[Production Examples 2-1 to 2-17, Examples 2-1 to 2-22, and Comparative Examples 2-1 to 2-6]

(1) Preparation of resin (A)

(Production Example 2-1)

Process 1:

As a solvent, 100 parts of PGMEA was introduced into a reaction container including a stirrer, a thermometer, a dropping device, a reflux cooler, and a gas introducing tube. A nitrogen gas was injected into this container and heated to 80°C. This temperature was held, and a mixture of 5.0 parts of styrene (St), 15.9 parts of cyclohexyl methacrylate (CHMA), 31.7 parts of methacrylic acid (MAA), and 3.0 parts of 2,2'-azobisisobutyronitrile was dropped for one hour and was subjected to polymerization reaction. After completion of dropping, the mixture was further subjected to reaction for three hours at 70°C. After that, a solution obtained by dissolving 0.5 parts of azobisisobutyronitrile into 40 parts of PGMEA was added and continuously stirred at the same temperature for three hours, so that a copolymer was obtained.

Process 2:

Next, dry air was introduced into the reaction container, and 50.0 parts of glycidyl methacrylate (GMA), 37.0 parts of PGMEA, 0.6 parts of dimethylbenzylamine, and 0.1 parts of methoquinone were fed and then stirred for 10 hours at the same temperature. After the solution was cooled to the room temperature, the solution was diluted with PGMEA, so that a resin solution (A2-1) having a solids content of 40 mass% was obtained.
The main reaction conditions (feed composition and reaction temperature) and evaluation results of the obtained resin are shown in Table 22.

(Production Examples 2-2 to 2-10)

Resin solutions (A2-1) to (A2-10) were obtained in the same manner as in Production Example 2-1, except that the reaction conditions (feed composition and reaction temperature) were changed to those shown in Table 22.
Abbreviations in Table 22 are as follows:

PGMEA: propylene glycol monomethyl ether acetate;
DCPMA: dicyclopentanyl methacrylate;
CHMA: cyclohexyl methacrylate;
St: styrene;
M-110: para-cumylphenol ethylene oxide modified acrylate;
HEMA: hydroxyethyl methacrylate;
MAA: methacrylic acid;
GMA: glycidyl methacrylate; and
MMA: methyl methacrylate.

The loadings in Table 22 are represented in units of "part".

(2-2) Preparation of dispersion liquid of light scattering particles (B)

(Production Example 2-11)

To 10 g of titanium oxide ($TiO_2$) particles having an average primary particle diameter of 250 nm, 87 g of methyl isobutyl ketone were added as a dispersion medium, and 4 g of BYK-111 (manufactured by BYK-Chemie Japan K.K.) were added as a dispersant. Further, dispersion processing was performed with a paint shaker for one hour by use of zirconia beads (1.25 mm) as media. Thus, a light scattering particle dispersion liquid (B2-1)

(titanium oxide particle dispersion liquid) was prepared. The average particle diameter was 413 nm.

(Production Example 2-12)

To 10 g of melamine/formaldehyde condensate particles ("Epostar S6" manufactured by Nippon Shokubai Co., Ltd.) having an average primary particle diameter of 300 to 600 nm, 87 g of methyl isobutyl ketone were added as a

dispersion medium, and 4 g of BYK-111 (manufactured by BYK-Chemie Japan K.K.) were added as a dispersant. Further, dispersion processing was performed with a paint shaker for one hour by use of zirconia beads (1.25 mm) as media. Thus, a light scattering particle dispersion liquid (B2-2)

(melamine resin particle dispersion liquid) was prepared. The average particle diameter was 488 nm.

(Production Example 2-13)

Under an $N_2$ atmosphere, in a mixed solvent of 58 g of methanol and 32 g of water, 4.5 g of methyl methacrylate (manufactured by Wako Pure Chemical Industries, Ltd.), 5 g of trifluoroethyl methacrylate (manufactured by Wako Pure Chemical Industries, Ltd.), and 0.5 g of allyl methacrylate (manufactured by Wako Pure Chemical Industries, Ltd.) were polymerized at 60°C by use of 0.025 g of 2,2'-azobis(2-amidinopropane)dihydrochloride (V-50 manufactured by Wako Pure Chemical Industries, Ltd.). After that, the product was filtered and acrylic resin particles were obtained. To 10 g of acrylic resin particles thus obtained, 90 g of methyl isobutyl ketone were added as a dispersion medium, and dispersion processing was performed with a paint shaker for one hour by use of zirconia beads (1.25 mm) as media. Thus, a light scattering particle dispersion liquid (B2-3) (acrylic resin particle dispersion liquid) was obtained. The average particle diameter was 420 nm.

(2-3) Preparation of dispersion liquid of metallic oxide fine particles (C)

(Production Example 2-14)

To 10 g of titanium oxide ($TiO_2$) fine particles having an average primary particle diameter of 15 nm, 87 g of methyl isobutyl ketone were added as a dispersion medium, and 4 g of BYK-111 (manufactured by BYK-Chemie Japan K.K.) were added as a dispersant. Two steps of dispersion processing were performed on the solution thus obtained. In a pre-dispersion process, zirconia beads (average diameter: 1.25 mm) were used as media and dispersed by use of a paint shaker for one hour. In a main dispersion process, zirconia beads (average diameter: 0.1 mm) were used as media and dispersed for seven hours by use of a dispersion device UAM-015 manufactured by Kotobuki Industries Co., Ltd. In the manner as described above, a metallic oxide fine particle dispersion liquid (C1-1) (titanium oxide fine particle dispersion liquid) was prepared. The average particle diameter of titanium oxide fine particles in the dispersion liquid was 80 nm.

(2-4) Preparation of silane compound (E)

(Production Example 2-15)

A flask with a condenser tube was prepared as a reaction tank, and a solution obtained by sufficiently stirring and mixing 100 g of 3-isocyanatopropyltriethoxysilane ("KBE-9007" manufactured by Shin-Etsu Chemical Co., Ltd.) and 50 g of ethanol (manufactured by Kishida Chemical Co., Ltd.) was prepared and subjected to nitrogen substitution. After that, the solution was heated in an oil bath while being stirred, and the temperature of the reaction tank was raised to 60°C. After the temperature of the reaction tank was stabilized at 60°C, the solution was stirred for eight hours. Completion of the reaction was confirmed by an FT-IR spectrum, and the temperature of the reaction tank was lowered to the room temperature, so that 130 g of (3-carbamate ethyl)propyl trimethoxysilane ethanol solution having a solids content of 79 mass% were obtained.

A 100 mL 4-necked flask including a Dimroth-type cooler/condenser, a Dean-Stark apparatus, a stirrer, and a thermometer was prepared by being subjected to sufficient nitrogen substitution. Then, 100 g of (3-carbamate ethyl) propyl trimethoxysilane ethanolsolution, which were obtained as described above, 25 mL of ethanol, and 0.06 g of sodium acetate were fed, and 1.3 g of water were added slowly. The solution thus obtained was matured for one hour at a temperature of 30 to 40°C under normal pressure, and was then matured for three hours under a reflux. The solvent was gradually extracted under normal pressure after the maturation, and heating was stopped when the temperature of the tank reached 105°C and the tank was cooled. The solution thus obtained was filtered and dried for one hour at 120°C under a reduced pressure, so that a silane compound (E2-1), which was a transparent, oil-like product, was obtained. The mass average molecular weight (Mw) was about 5, 500.

(Production Example 2-16)

A flask with a condenser tube was prepared as a reaction tank, and a solution obtained by sufficiently stirring and mixing 100g of 3-isocyanatopropyltriethoxysilane ("KBE-9007" manufactured by Shin-Etsu Chemical Co., Ltd.) and

100g parts of 2,8-ethyl-1-tetradecanol was prepared and subjected to nitrogen substitution. After that, the solution was heated in an oil bath while being stirred, and the temperature of the reaction tank was raised to 60°C. After the temperature of the reaction tank was stabilized at 60°C, the solution was further stirred for 10 hours. Completion of the reaction was confirmed by an FT-IR spectrum, and the temperature of the reaction tank was lowered to the room temperature. Then, the solution was extracted to a container, which was subjected to nitrogen substitution, so that a silane compound (E2-2) was obtained. The mass average molecular weight (Mw) was about 520.

(Production Example 2-17)

A flaks with a condenser tube was prepared as a reaction tank, and a solution obtained by sufficiently stirring and mixing 100 g of 3-isocyanatopropyltriethoxysilane ("KBE-9007" manufactured by Shin-Etsu Chemical Co., Ltd.) and 100g of ethanol (manufactured by Kishida Chemical Co., Ltd.) was prepared and subjected to nitrogen substitution. After that, the solution was heated in an oil bath while being stirred, and the temperature of the reaction tank was raised to 60°C. After the temperature of the reaction tank was stabilized at 60°C, the solution was further stirred for six hours. Completion of the reaction was confirmed by an FT-IR spectrum, and the temperature of the reaction tank was lowered to the room temperature. Then, the solution was extracted to a container, which was subjected to nitrogen substitution, so that a silane compound (E2-3) was obtained. The mass average molecular weight (Mw) was about 280.

(2-5) Preparation of a resin composition for light scattering layer

(Example 2-1)

To 15.00 g of the light scattering particle dispersion liquid (B2-1) obtained as described above, 24.71 g of the resin (A2-1) obtained as described above and 2.25 g of ethylene unsaturated monomer (D2-1) (Viscoat 802 manufactured by Osaka Organic Chemical Industry Ltd.), and 51.63 g of organic solvent PGMEA were added and uniformly stirred and mixed. The solution thus obtained was filtered with a filter having a mesh diameter of 5 μm. Thus, a resin composition for light scattering layer was prepared. The mass ratio of the solids in this composition was resin (A2-1) : light scattering particles (B2-1)(including a dispersant for dispersing light scattering particles) : ethylene unsaturated monomer (D2-1) = 71 : 14 : 15.

(Examples 2-2 to 2-22 and Comparative Examples 2-1 to 2-6)

Resin compositions for light scattering layer were obtained in the same manner as in Example 2-1, except that the blended composition was changed to that shown in Table 23-1 and Table 23-2.
Abbreviations in Table 23-1 and Table 23-2 are as follows:

V#802: Viscoat #802 manufactured by Osaka Organic Chemical Industry Ltd.;
DPCA60: KAYARAD DPCA60 manufactured by Sartomer Inc.;
M402: Aronix M402 manufactured by Toagosei Co., Ltd.;
KBM-573: KBM-573 manufactured by Shin-Etsu Chemical Co. , Ltd.;
Irg907: IRGACURE 907 manufactured by BASF;
OXE01: IRGACURE OXE01 manufactured by BASF;
OXE02: IRGACURE OXE02 manufactured by BASF; and
BYK330: BYK330 manufactured by BYK Japan KK.

(2-6) Evaluation

The obtained resin compositions for light scattering layer were evaluated by an apparatus or a method as described below.

(A refractive index of a binder composition, and a refractive index difference between the binder composition and the light scattering particles (B))

The binder composition was coated on a PEN film with a finished film thickness of 2.0 μm by use of a spin coater. Next, the coated substrate thus obtained was held for two minutes on a hot plate which was heated to 110°C. After that, ultraviolet ray exposure was performed with an illuminance of 20 $mW/cm^2$ and an exposure amount of 50 $mJ/cm^2$ by use of an extra-high pressure mercury lamp. The coated substrate was heated at 200°C for 30 minutes and was then cooled. After that, the refractive index (n1) of the binder composition was measured by an Abbe refractometer

in accordance with Japanese Industrial Standard: JISK7142 "plastic refractive index measurement method". Further, the difference between the refractive index (n1) of the binder composition and the refractive index (n2) of the light scattering particles was obtained. Evaluation was made based on the following criteria.

- The refractive index difference between the binder composition and the light scattering particles (B)

  0.1≤|n1-n2|: "Good (o)",
  0.1>|n1-n2|: "Poor (×)"

(Visible light transmittance of light scattering layer)

The resin composition for light scattering layer was coated on a glass substrate (glass "EAGLE 2000" manufactured by Corning Incorporated) having a size of 100 mm × 100 mm and a thickness of 0.7 mm, with a finished film thickness of 2.0 μm after heating at 230°C for 20 minutes, by use of a spin coater. Next, the coated substrate thus obtained was held for two minutes on a hot plate, which was heated to 110°C, and ultraviolet ray exposure was performed with an illuminance of 20 $mW/cm^2$ and an exposure amount of 50 $mJ/cm^2$ by use of an extra-high pressure mercury lamp. The coated substrate was heated at 230°C for 20 minutes and was then cooled, and the transmittance of the obtained coating film at a wavelength of 400 nm was measured by use of a microspectrophotometer ("OSP-SP100" manufactured by Olympus Optical Co., Ltd.). Evaluation was made based on the following criteria.
A transmittance of 80% or more: Good (o),
**[0427]** A transmittance of less than 80%: Fair (Δ)

(Heat resistance; Measurement of transmittance after additional baking)

A substrate coated with the resin composition for light scattering layer obtained in the same manner as that prepared for measurement of the transmittance was heated at 300°C for 20 minutes, and was then cooled. After that, the transmittance of the obtained coating film at a wavelength of 400 nm was measured by use of a microspectrophotometer ("OSP-SP100" manufactured by Olympus Optical Co., Ltd.). Evaluation was made based on the following criteria.
A transmittance of 80% or more: Good (o),
**[0430]** A transmittance of less than 80%: Fair (Δ)

(Measurement of adhesive properties with respect to glass and ITO)

The adhesive properties of the coating film of the substrate coated with the resin composition for light scattering layer which was obtained in the same manner as that prepared for measurement of the transmittance were evaluated by an adhesion property (cross-cut method) test in accordance with JISK5600-5-6, and the number of peelings in 25 grids was counted.
As the base material, glass "EAGLE 2000" manufactured by Corning Incorporated and an ITO film manufactured by GEOMATEC Co., Ltd. were used.

Evaluation was made based on the following criteria.

The number of peelings in the grids is 0: Excellent (oo),
**[0434]** The number of peelings in the grids is less than 1 (edge peeling: a level at which an edge of a grid is peeled off): Good (o),
**[0435]** The number of peelings in the grids is 1 to 3: Fair (Δ),
**[0436]** The number of peelings in the grids is greater than 3: Poor (×)

(ITO etchant resistance)

A coating film was formed on an ITO base material formed in the same manner as that prepared for measurement of the transmittance. The obtained substrate coated with the resin composition for light scattering layer was immersed in a solution of nitric acid/hydrochloric acid/water=0.1/1/1 (mass ratio) at 40°C for five minutes, and was washed with pure water and then left for 24 hours. The adhesive properties of the coating film of the obtained substrate were evaluated by an adhesion property (cross-cut method) test in accordance with JIS K5600-5-6, and the number of peelings in 25 grids was counted.
As the base material, an ITO film manufactured by GEOMATEC Co., Ltd. was used.

Evaluation was made based on the following criteria.

The number of peelings in the grids is 0: Excellent (oo),
**[0440]** The number of peelings in the grids is less than 1 (edge peeling: a level at which an edge of a grid is peeled off): Good (o),
**[0441]** The number of peelings in the grids is 1 to 3: Fair (Δ),
**[0442]** The number of peelings in the grids is greater than 3: Poor (×)

(Chemical resistance)

Substrates coated with the resin composition for light scattering layer obtained in the same manner as that prepared for measurement of the transmittance were immersed in acetone or isopropyl alcohol, and were subjected to ultrasonic cleaning for 10 minutes at 25°C. The adhesive properties of the coating film of each of the obtained substrates were evaluated by an adhesion property (cross-cut method) test in accordance with JIS K5600-5-6, and the number of peelings in 25 grids was counted.

Evaluation was made based on the following criteria.

The number of peelings in the grids is 0: Excellent (oo),
**[0445]** The number of peelings in the grids is less than 1 (edge peeling: a level at which an edge of a grid is peeled off): Good (o),
**[0446]** The number of peelings in the grids is 1 to 3: Fair (Δ),
**[0447]** The number of peelings in the grids is greater than 3: Poor (×)

(Evenness)

The surface roughness of the coating film of the substrate coated with the resin composition for light scattering layer, which was obtained in the same manner as that prepared for measurement of the transmittance, was measured by a stylus film thickness gauge DECTAC-3 manufactured by ULVAC, Inc.

Evaluation was made based on the following criteria.

A surface roughness of less than 100 Å: Excellent (oo),
**[0450]** A surface roughness of equal to or more than 100 Å and less than 200Å: Good (o),
**[0451]** A surface roughness of 200Å to 300 Å: Fair (Δ),
**[0452]** A surface roughness of more than 300 Å: Poor (×)

(Development rate)

The resin composition for light scattering layer was coated on a glass substrate with a dried film thickness of 2.0 μm by a spin coating method, and this coated substrate was subjected to exposure at 60 mJ/$cm^2$ through a mask pattern by use of a high-pressure mercury lamp. After that, spray development was carried out with a pressure of 0.25 MPa by use of 0.04 mass% of potassium hydroxide aqueous solution (at a developer temperature of 26°C), and the time required for dissolving the coating film and exposing the substrate surface (time for development and dissolution) was measured.

Evaluation was made based on the following criteria.

A development time of less than 20 seconds: Excellent (oo),
**[0455]** A development time of equal to or more than 20 seconds and less than 60 seconds: Good (o),
**[0456]** A development time of equal to or more than 60 seconds: Poor (×)

(Evaluation of an EL device (light extraction efficiency, emission appearance (dark spot, unevenness)))

An ITO film having a thickness of 150 nm was formed by a DC sputtering method on the substrate coated with the resin composition for light scattering layer, which was obtained in the same manner as that prepared for measurement of the transmittance, by use of an ITO ceramic target ($In_2O_3$:$SnO_2$=90:10 (mass ratio)). Thus, a translucent electrode (anode) was obtained.

The above-mentioned ITO film was etched using a photoresist, and a pattern was formed with an emission area of 5 mm × 5 mm. After ultrasonic cleaning was carried out, ozone cleaning was carried out by use of a low-pressure ultraviolet ray lamp. Then, organic EL layers were sequentially formed on the surface of the ITO in the following manner by a vacuum evaporation method.

First, CuPc was formed as a hole injection layer with a thickness of 15 nm. Next, α-NPD was formed as a hole transport layer with a thickness of 50 nm. Then, Alq3 was formed as an electron transporting luminous layer with a thickness of 140 nm.

After that, Mg and Ag were co-deposited to form MgAg with a thickness of 100 nm. Then, Ag was further formed thereon from the viewpoint of preventing oxidation of MgAg, so that a back electrode (cathode) was obtained.

After the resultant was extracted from the vacuum deposition device, ultraviolet ray-curable epoxy resin was dropped on the cathode electrode side, and a slide glass was overlaid. Then, the epoxy resin was cured by use of a high-pressure ultraviolet ray lamp, so that the element was sealed.

To the obtained EL device, a forward current of 10 $mA/cm^2$ was applied at room temperature, and the emission appearance (dark spot, unevenness) was observed. Further, the front luminance was measured by a spectral radiance meter "CS-2000" manufactured by Konica Minolta Sensing, Inc., and the ratio of improvement of the front luminance was calculated based on the front luminance of the EL device which was prepared using the substrate having no light scattering layer formed thereon. Evaluation was made based on the following criteria.

- Emission Appearance (dark spot, unevenness)

No dark spot or unevenness is observed: Good (o),

A slight dark spot or unevenness is observed: Fair (Δ),

A dark spot or unevenness is observed: Poor (×)

- Light Extraction Efficiency

A ratio of improvement of the front luminance is 1.5-fold or more: Excellent (oo),

A ratio of improvement of the front luminance is equal to or more than 1.2-fold and less than 1.5-fold: Good (o),

A ratio of improvement of the front luminance is less than 1.2-fold: Fair (Δ)-

Evaluation results are shown in Table 24-1 and Table 24-2.

Any one of the characteristics was poor in Comparative Examples 2-1 to 2-6. However, in Examples 2-1 to 2-22, an organic EL device having a high light extraction efficiency and a satisfactory emission appearance (with no dark spot and no unevenness) was achieved.

[Table 1]

| Resin solution | | | A1-1 | A1-2 | A1-3 | A1-4 | A1-5 | A1-6 | A1-7 | A1-8 | A1-9 | A1-10 |
|---|---|---|---|---|---|---|---|---|---|---|---|---|
| Solvent | | PGMEA | 100.0 | 100.0 | 100.0 | 100.0 | 100.0 | 100.0 | 100.0 | 100.0 | 100.0 | 100.0 |
| Process 1 | Cyclic skeleton | indene | | | | | | 40.0 | | | | |
| | | DCPMA | | | | | | | 24.0 | | | |
| | | CHMA | 15.9 | 54.4 | 54.4 | 31.3 | | | | | 31.3 | 31.3 |
| | | St | 5.0 | 10.0 | 10.0 | 10.0 | | | | 25.0 | 10.0 | 10.0 |
| | | M-110 | | | | | | | | 30.0 | | |
| | Reactive group | HEMA | | 15.0 | 15.0 | 10.0 | 15.0 | | 15.0 | | 10.0 | 10.0 |
| | | MAA | 31.7 | 9.7 | 9.7 | 20.3 | 36.6 | 46.4 | 36.6 | | 20.3 | 20.3 |
| | | GMA | | | | | | | | 30.0 | | |
| | Other | MMA | | | | | 24.0 | 120.0 | | | | |
| | | 2,2'-azobisisobutyronitrile | 3.0 | 3.0 | 3.0 | 9.5 | 3.0 | 5.0 | 3.0 | 4.0 | 17.0 | 1.8 |
| | adding after mixing | 2,2'-azobisisobutyronitrile | 0.5 | 0.5 | 0.5 | 0.5 | 0.5 | 0.5 | 0.5 | 0.2 | 0.5 | 0.2 |
| | | PGMEA | 40.0 | 40.0 | 40.0 | 40.0 | 40.0 | 72.0 | 40.0 | 40.0 | 40.0 | 40.0 |
| Process 2 | Modifed monomer | GMA | 50.0 | 10.0 | 8.0 | 30.0 | 30.0 | 45.0 | 30.0 | | 30.0 | 30.0 |
| | Other | dimethylbenzylamine | 0.6 | 0.6 | | 0.6 | | 1.0 | 0.6 | | 0.6 | 0.6 |
| | | methoquinone | 0.1 | 0.1 | | 0.1 | | 0.1 | 0.1 | | 0.1 | 0.1 |
| | | PGMEA | 37.0 | 37.0 | | 37.0 | | 100.0 | 37.0 | | 37.0 | 37.0 |
| Reaction temperature (°C) | | | 80 | 80 | | 80 | | 90 | 80 | | 80 | 80 |
| 5% decomposition temperature (°C) | | | 200°Cor more | 200°Cor more | 200°Cor more | 200°Cor more | 200°Cor more | 200°Cor more | 200°Cor more | 200°Cor more | 200°Cor more | 200°Cor more |
| Mass average molecular weight (MW) | | | 18000 | 18000 | 18000 | 6000 | 18000 | 12000 | 15000 | 15000 | 3500 | 30000 |
| Double bond equivalent | | | 292 | 1409 | 1725 | 481 | 500 | 794 | 500 | - | 480 | 480 |
| Acid value | | | - | 24 | 33 | 14 | 114 | 50 | 114 | - | 14 | 14 |

[Table 2]

| Light scattering particles (B) | B1-1 | | B1-2 | | B1-3 | | B1-4 | |
|---|---|---|---|---|---|---|---|---|
| Primary particle diameter | 250nm | | 420nm | | 500nm | | 250-350nm | |
| particle type/ loads | titanium oxide 1 | 10.0% | acrylic resin | 10.0% | acrylic resin | 10.0% | silica | 10.0% |
| dispersion medium/ loads | methyl isobutyl ketone | 84.3% | PGMEA | 90.0% | PGMEA | 90.0% | methyl isobutyl ketone | 84.3% |
| dispersant/ loads | T-1 | 5.7% | - | - | - | | T-1 | 5.7% |
| dispersion device | dynomill | | - | | - | | dynomill | |
| average particle diameter | 426nm | | 420nm | | 500nm | | 382nm | |
| 600nm or more vol% | 12% | | 6% | | 9% | | 19% | |
| coefficient of variation | 22% | | 9% | | 10% | | 36% | |

[Table 3]

| Light scattering particles (B) | B1-5 | | B1-6 | | B1-7 | | B1-8 | |
|---|---|---|---|---|---|---|---|---|
| Primary particle diameter | 210nm | | 210nm | | 300-600nm | | 250nm | |
| particle type/ loads | titanium oxide 2 | 10.0% | titanium oxide 2 | 10.0% | melamine resin | 10.0% | titanium oxide 1 | 10.0% |
| dispersion medium/ loads | methyl isobutyl ketone | 84.3% | methyl isobutyl ketone | 87.2% | methyl isobutyl ketone | 86.0% | methyl isobutyl ketone | 86.0% |
| dispersant/ loads | T-1 | 5.7% | T-1 | 2.8% | BYK-111 | 4.0% | BYK-111 | 4.0% |
| dispersion device | dynomill | | paint shaker | | paint shaker | | paint shaker | |
| average particle diameter | 220nm | | 250nm | | 512nm | | 413nm | |
| 600nm or more vol% | 19% | | 26% | | 40% | | 30% | |
| coefficient of variation | 32% | | 35% | | 37% | | 42% | |

[Table 4]

| | Resin (A) | | Light scattering particles(B) | | Metallic oxide fine particles(C) | | Ethylenically unsaturated monomer(D) | | Silane compound(E) | | | Photopolymerization initiator(F) | | Leveling agent | Solids content | Solvent ratio | | |
|---|---|---|---|---|---|---|---|---|---|---|---|---|---|---|---|---|---|---|
| | Type | Loads (Note 1) | Type | Loads (Note 1, 2) | Type (Note 2) | Loads (Note 1) | Type | Loads (Note 1) | Type | Molecular weight | Loads (Note 1) | Type | Loads (Note 1) | BYK330 | | PGMEA | methyl isobutyl ketone | cyclohexanone |
| Example 1-1 | A1-4 | 86.0% | B1-1 | 14.0% | - | - | - | - | - | - | - | - | - | - | 15.0% | 84.8% | 14.9% | 0.3% |
| Example 1-2 | A1-4 | 40.0% | B1-2 | 10.0% | C1-1 | 50.0% | - | - | - | - | - | - | - | - | 15.0% | 98.9% | 0.0% | 1.1% |
| Example 1-3 | A1-4 | 40.0% | B1-3 | 10.0% | C1-1 | 50.0% | | | | | | | | | 15.0% | 98.9% | 0.0% | 1.1% |
| Example 1-4 | A1-4 | 86.0% | B1-4 | 14.0% | - | - | - | - | - | - | - | - | - | - | 15.0% | 84.8% | 14.9% | 0.3% |
| Example 1-5 | A1-4 | 86.0% | B1-5 | 14.0% | | | | | | | | | | | 15.0% | 84.8% | 14.9% | 0.3% |
| Example 1-6 | A1-1 | 71.0% | B1-1 | 14.0% | - | - | V#802 | 15.0% | - | - | - | - | - | - | 15.0% | 84.8% | 14.9% | 0.3% |
| Example 1-7 | A1-2 | 71.0% | B1-1 | 14.0% | - | - | V#802 | 15.0% | - | - | - | - | - | - | 15.0% | 84.8% | 14.9% | 0.3% |
| Example 1-8 | A1-3 | 71.0% | B1-1 | 14.0% | - | - | V#802 | 15.0% | - | - | - | - | - | - | 15.0% | 84.8% | 14.9% | 0.3% |
| Example 1-9 | A1-4 | 31.0% | B1-1 | 14.0% | C1-1 | 40.0% | DPCA60 | 15.0% | - | - | - | - | - | - | 15.0% | 83.9% | 14.9% | 1.2% |
| Example 1-10 | A1-4 | 26.0% | B1-1 | 14.0% | C1-1 | 45.0% | M402 | 15.0% | - | - | - | - | - | - | 15.0% | 83.8% | 14.9% | 1.3% |
| Example 1-11 | A1-4 | 21.0% | B1-1 | 14.0% | C1-1 | 50.0% | V#802 | 15.0% | - | - | - | - | - | - | 15.0% | 83.7% | 14.9% | 1.4% |
| Example 1-12 | A1-5 | 21.0% | B1-1 | 14.0% | C1-1 | 50.0% | V#802 | 15.0% | - | - | - | - | - | - | 15.0% | 83.7% | 14.9% | 1.4% |
| Example 1-13 | A1-6 | 21.0% | B1-1 | 14.0% | C1-1 | 50.0% | V#802 | 15.0% | - | - | - | - | - | - | 15.0% | 83.7% | 14.9% | 1.4% |
| Example 1-14 | A1-7 | 21.0% | B1-1 | 14.0% | C1-1 | 50.0% | V#802 | 15.0% | - | - | - | - | - | - | 15.0% | 83.7% | 14.9% | 1.4% |
| Example 1-15 | A1-8 | 21.0% | B1-1 | 14.0% | C1-1 | 50.0% | V#802 | 15.0% | - | - | - | - | - | - | 15.0% | 83.7% | 14.9% | 1.4% |
| Example 1-16 | A1-7 | 6.9% | B1-1 | 10.0% | C1-1 | 50.0% | V#802 | 15.0% | E1-1 | 5500 | 15.0% | Irg907 | 3.0% | 0.1% | 15.0% | 88.1% | 10.6% | 1.3% |
| Example 1-17 | A1-7 | 6.9% | B1-1 | 10.0% | C1-1 | 50.0% | V#802 | 15.0% | E1-2 | 520 | 2.5% | Irg907 | 3.0% | 0.1% | 15.0% | 88.1% | 10.6% | 1.3% |
| Example 1-18 | A1-7 | 6.9% | B1-1 | 10.0% | C1-1 | 50.0% | V#802 | 15.0% | E1-2 | 520 | 15.0% | Irg907 | 3.0% | 0.1% | 15.0% | 88.1% | 10.6% | 1.3% |
| Example 1-19 | A1-7 | 2.9% | B1-1 | 10.0% | | | V#802 | 15.0% | E1-2 | 520 | 55.0% | Irg907 | 3.0% | 0.1% | 15.0% | 89.2% | 10.6% | 0.2% |
| Example 1-20 | A1-7 | 6.9% | B1-1 | 10.0% | C1-1 | 50.0% | V#802 | 15.0% | E1-3 | 280 | 15.0% | Irg907 | 3.0% | 0.1% | 15.0% | 88.1% | 10.6% | 1.3% |
| Example 1-21 | A1-7 | 6.9% | B1-1 | 10.0% | C1-1 | 50.0% | V#802 | 15.0% | KBM-573 | | 15.0% | Irg907 | 3.0% | 0.1% | 15.0% | 88.1% | 10.6% | 1.3% |
| Example 1-22 | A1-7 | 6.9% | B1-2 | 10.0% | C1-1 | 50.0% | V#802 | 15.0% | E1-2 | 520 | 15.0% | Irg907 | 3.0% | 0.1% | 15.0% | 98.9% | 0.0% | 1.1% |
| Example 1-23 | A1-7 | 6.9% | B1-2 | 10.0% | C1-1 | 50.0% | V#802 | 15.0% | E1-2 | 520 | 15.0% | Irg907 | 3.0% | 0.1% | 15.0% | 98.9% | 0.0% | 1.1% |
| Example 1-24 | A1-9 | 6.9% | B1-2 | 10.0% | C1-1 | 50.0% | V#802 | 15.0% | E1-2 | 520 | 15.0% | Irg907 | 3.0% | 0.1% | 15.0% | 98.9% | 0.0% | 1.1% |
| Example 1-25 | A1-10 | 6.9% | B1-2 | 10.0% | C1-1 | 50.0% | V#802 | 15.0% | E1-2 | 520 | 15.0% | Irg907 | 3.0% | 0.1% | 15.0% | 98.9% | 0.0% | 1.1% |
| Example 1-26 | A1-7 | 6.9% | B1-1 | 10.0% | C1-1 | 50.0% | V#802 | 15.0% | E1-2 | 520 | 15.0% | OXE-01 | 3.0% | 0.1% | 15.0% | 88.1% | 10.6% | 1.3% |
| Example 1-27 | A1-7 | 6.9% | B1-1 | 10.0% | C1-1 | 50.0% | V#802 | 15.0% | E1-2 | 520 | 15.0% | OXE-02 | 3.0% | 0.1% | 15.0% | 88.1% | 10.6% | 1.3% |
| Example 1-28 | A1-7 | 6.9% | B1-1 | 7.0% | C1-1 | 50.0% | V#802 | 15.0% | E1-2 | 520 | 15.0% | OXE-02 | 3.0% | 0.1% | 15.0% | 91.3% | 7.4% | 1.2% |
| Example 1-29 | A1-7 | 6.9% | B1-1 | 20.0% | C1-1 | 50.0% | V#802 | 15.0% | E1-2 | 520 | 15.0% | OXE-02 | 3.0% | 0.1% | 15.0% | 77.2% | 21.3% | 1.5% |
| Example 1-30 | A1-7 | 6.9% | B1-1 | 7.0% | C1-1 | 50.0% | V#802 | 15.0% | E1-2 | 520 | 15.0% | OXE-01 | 3.0% | 0.1% | 15.0% | 91.3% | 7.4% | 1.2% |
| Example 1-31 | A1-7 | 6.9% | B1-1 | 20.0% | C1-1 | 50.0% | V#802 | 15.0% | E1-2 | 520 | 15.0% | OXE-01 | 3.0% | 0.1% | 15.0% | 77.2% | 21.3% | 1.5% |
| Comparative Example 1-1 | A1-7 | 6.9% | B1-6 | 10.0% | C1-1 | 50.0% | V#802 | 15.0% | E1-2 | 520 | 15.0% | Irg907 | 3.0% | 0.1% | 15.0% | 88.1% | 10.6% | 1.3% |
| Comparative Example 1-2 | A1-7 | 6.9% | B1-7 | 10.0% | C1-1 | 50.0% | V#802 | 15.0% | E1-2 | 520 | 15.0% | Irg907 | 3.0% | 0.1% | 15.0% | 88.1% | 10.6% | 1.3% |
| Comparative Example 1-3 | A1-7 | 21.0% | B1-8 | 14.0% | C1-1 | 50.0% | V#802 | 15.0% | - | - | - | - | - | - | 15.0% | 83.7% | 14.9% | 1.4% |
| Comparative Example 1-4 | A1-7 | 56.9% | B1-2 | 10.0% | - | - | V#802 | 15.0% | E1-2 | 520 | 15.0% | Irg907 | 3.0% | 0.1% | 15.0% | 100.0% | 0.0% | 0.0% |

Note 1) representing a ratio in solids of a resin
Note 2) representing a total of fine particles and

V#802 : Viscoat #802 manufactured by Osaka Organic Chemical Industry Ltd.
DPCA60 : KAYARAD DPCA60 manufactured by Sartomer Inc.
M402 : Aronix M402 manufactured by Toagosei Co., Ltd.
KBM-57: : KBM-573 manufactured by Shin-Etsu Chemical Co. , Ltd.

Irg907 : IRGACURE 907 manufactured by BASF
OXE-01 : IRGACURE OXE01 manufactured by BASF
OXE-02 : IRGACURE OXE02 manufactured by BASF
BYK330 : BYK330 manufactured by BYK Japan KK.

[Table 5A]

| | Resin (A) | | Light scattering particles(B) | | Metallic oxide fine particles(C) | | Ethylenically unsaturated | | silane compound(E) | | | photopolymerization initiator(F) | | Heat-reactive compound(G) | | leveling agent | Solids content |
|---|---|---|---|---|---|---|---|---|---|---|---|---|---|---|---|---|---|
| | Type | Loads (Note 1) | Type | Loads (Note 1,2) | Type (Note 2) | Loads (Note 1) | Type | Loads (Note 1) | Type | Molecular weight | Loads (Note 1) | Type | Loads (Note 1) | Type | Loads (Note 1) | BYK330 | |
| Example 1-32 | A-7 | 6.0% | B-1 | 10.0% | C-1 | 50.0% | V#802 | 15.0% | E-1 | 5500 | 15.0% | Irg907 | 3.0% | | | 1.0% | 15.0% |
| Example 1-33 | A-7 | 6.0% | B-1 | 10.0% | C-1 | 50.0% | V#802 | 15.0% | E-2 | 520 | 2.5% | Irg907 | 3.0% | | | 1.0% | 15.0% |
| Example 1-34 | A-7 | 6.0% | B-1 | 10.0% | C-1 | 50.0% | V#802 | 15.0% | E-2 | 520 | 15.0% | Irg907 | 3.0% | | | 1.0% | 15.0% |
| Example 1-35 | A-7 | 2.0% | B-1 | 10.0% | | | V#802 | 15.0% | E-2 | 520 | 55.0% | Irg907 | 3.0% | | | 1.0% | 15.0% |
| Example 1-36 | A-7 | 6.0% | B-1 | 10.0% | C-1 | 50.0% | V#802 | 15.0% | E-3 | 280 | 15.0% | Irg907 | 3.0% | | | 1.0% | 15.0% |
| Example 1-37 | A-7 | 6.0% | B-1 | 10.0% | C-1 | 50.0% | V#802 | 15.0% | KBM-573 | | 15.0% | Irg907 | 3.0% | | | 1.0% | 15.0% |
| Example 1-38 | A-7 | 6.0% | B-2 | 10.0% | C-1 | 50.0% | V#802 | 15.0% | E-2 | 520 | 15.0% | Irg907 | 3.0% | | | 1.0% | 15.0% |
| Example 1-39 | A-7 | 6.0% | B-2 | 10.0% | C-1 | 50.0% | V#802 | 15.0% | E-2 | 520 | 15.0% | Irg907 | 3.0% | | | 1.0% | 15.0% |
| Example 1-40 | A-9 | 6.0% | B-2 | 10.0% | C-1 | 50.0% | V#802 | 15.0% | E-2 | 520 | 15.0% | Irg907 | 3.0% | | | 1.0% | 15.0% |
| Example 1-41 | A-10 | 6.0% | B-2 | 10.0% | C-1 | 50.0% | V#802 | 15.0% | E-2 | 520 | 15.0% | Irg907 | 3.0% | | | 1.0% | 15.0% |
| Example 1-42 | A-7 | 6.0% | B-1 | 10.0% | C-1 | 50.0% | V#802 | 15.0% | E-2 | 520 | 15.0% | OXE-01 | 3.0% | | | 1.0% | 15.0% |
| Example 1-43 | A-7 | 6.0% | B-1 | 10.0% | C-1 | 50.0% | V#802 | 15.0% | E-2 | 520 | 15.0% | OXE-02 | 3.0% | | | 1.0% | 15.0% |
| Example 1-44 | A-7 | 6.0% | B-1 | 7.0% | C-1 | 50.0% | V#802 | 15.0% | E-2 | 520 | 15.0% | OXE-02 | 3.0% | | | 1.0% | 15.0% |
| Example 1-45 | A-7 | 6.0% | B-1 | 20.0% | C-1 | 50.0% | V#802 | 15.0% | E-2 | 520 | 15.0% | OXE-02 | 3.0% | | | 1.0% | 15.0% |
| Example 1-46 | A-7 | 7.0% | B-2 | 10.0% | C-1 | 50.0% | | | E-2 | 520 | 15.0% | | | MX-43 | 17.0% | 1.0% | 15.0% |
| Example 1-47 | A-7 | 7.0% | B-2 | 10.0% | C-1 | 50.0% | | | E-2 | 520 | 15.0% | | | MX-417 | 17.0% | 1.0% | 15.0% |
| Example 1-48 | A-7 | 7.0% | B-2 | 10.0% | C-1 | 50.0% | | | E-2 | 520 | 15.0% | | | SB-401 | 17.0% | 1.0% | 15.0% |
| Example 1-49 | A-7 | 7.0% | B-2 | 10.0% | C-1 | 50.0% | | | E-2 | 520 | 15.0% | | | BL-60 | 17.0% | 1.0% | 15.0% |
| Example 1-50 | A-7 | 7.0% | B-2 | 10.0% | C-1 | 50.0% | | | E-2 | 520 | 15.0% | | | BL-4265 | 17.0% | 1.0% | 15.0% |
| Example 1-51 | A-7 | 7.0% | B-2 | 10.0% | C-1 | 50.0% | | | E-2 | 520 | 15.0% | | | EPPN-201 | 17.0% | 1.0% | 15.0% |
| Comparative Example 1-7 | A-7 | 6.9% | B-6 | 10.0% | C-1 | 50.0% | V#802 | 15.0% | E-2 | 520 | 15.0% | Irg907 | 3.0% | | | 1.0% | 15.0% |
| Comparative Example 1-8 | A-7 | 6.9% | B-7 | 10.0% | C-1 | 50.0% | V#802 | 15.0% | E-2 | 520 | 15.0% | Irg907 | 3.0% | | | 1.0% | 15.0% |
| Comparative Example 1-9 | A-7 | 56.9% | B-2 | 10.0% | - | - | V#802 | 15.0% | E-2 | 520 | 15.0% | Irg907 | 3.0% | | | 1.0% | 15.0% |
| Comparative Example 1-10 | A-7 | 7.0% | B-6 | 10.0% | C-1 | 50.0% | | | E-2 | 520 | 15.0% | | | MX-43 | 17.0% | 1.0% | 15.0% |
| Comparative Example 1-11 | A-7 | 7.0% | B-6 | 10.0% | C-1 | 50.0% | | | E-2 | 520 | 15.0% | | | BL-4265 | 17.0% | 1.0% | 15.0% |
| Comparative Example 1-12 | A-7 | 7.0% | B-6 | 10.0% | C-1 | 50.0% | | | E-2 | 520 | 15.0% | | | EPPN-201 | 17.0% | 1.0% | 15.0% |

Note 1)representing a ratio in solids of a resin composition
Note 2)representing a total of fine particles and dispersed res

V#802 :Viscoat #802 manufactured by Osaka Organic Chemica
DPCA60 :KAYARAD DPCA60 manufactured by Sartomer Inc.
M402 :Aronix M402 manufactured by Toagosei Co., Ltd.
KBM-573 :KBM-573 manufactured by Shin-Etsu Chemical Co. , L

Irg907 : IRGACURE 907 manufactured by BASF
OXE-01 : IRGACURE OXE01 manufactured by BASF
OXE-02 : IRGACURE OXE02 manufactured by BASF
BYK330 : BYK330 manufactured by BYK Japan KK.

[Table 5B]

| | Solvent ratio | | |
|---|---|---|---|
| | PGMEA | methyl isobutyl ketone | cyclohexanone |
| Example 1-32 | 88.1% | 10.6% | 1.3% |
| Example 1-33 | 88.1% | 10.6% | 1.3% |
| Example 1-34 | 88.1% | 10.6% | 1.3% |
| Example 1-35 | 89.2% | 10.6% | 0.2% |
| Example 1-36 | 88.1% | 10.6% | 1.3% |
| Example 1-37 | 88.1% | 10.6% | 1.3% |
| Example 1-38 | 98.9% | 0.0% | 1.1% |
| Example 1-39 | 98.9% | 0.0% | 1.1% |
| Example 1-40 | 98.9% | 0.0% | 1.1% |
| Example 1-41 | 98.9% | 0.0% | 1.1% |
| Example 1-42 | 88.1% | 10.6% | 1.3% |
| Example 1-43 | 88.1% | 10.6% | 1.3% |
| Example 1-44 | 91.3% | 7.4% | 1.2% |
| Example 1-45 | 77.2% | 21.3% | 1.5% |
| Example 1-46 | 88.1% | 10.6% | 1.3% |
| Example 1-47 | 88.1% | 10.6% | 1.3% |
| Example 1-48 | 88.1% | 10.6% | 1.3% |
| Example 1-49 | 88.1% | 10.6% | 1.3% |
| Example 1-50 | 88.1% | 10.6% | 1.3% |
| Example 1-51 | 88.1% | 10.6% | 1.3% |
| Comparative Example 1-7 | 88.1% | 10.6% | 1.3% |
| Comparative Example 1-8 | 88.1% | 10.6% | 1.3% |
| Comparative Example 1-9 | 100.0% | 0.0% | 0.0% |
| Comparative Example 1-10 | 88.1% | 10.6% | 1.3% |
| Comparative Example 1-11 | 88.1% | 10.6% | 1.3% |
| Comparative Example 1-12 | 88.1% | 10.6% | 1.3% |

[Table 6A]

| | Resin (A) | | Light scattering particles(B) | | Metallic oxide fine particles(C) | | Ethylenically unsaturated | | silane compound(E) | | | photopolymerization initiator(F) | | Heat-reactive compound(G) | | leveling agent | Solids content |
|---|---|---|---|---|---|---|---|---|---|---|---|---|---|---|---|---|---|
| | Type | Loads (Note 1) | Type | Loads (Note 1,2) | Type (Note 2) | Loads (Note 1) | Type | Loads (Note 1) | Type | Molecular weight | Loads (Note 1) | Type | Loads (Note 1) | Type | Loads (Note 1) | BYK330 | |
| Example 1-52 | A-7 | 6.9% | B-1 | 10.0% | C-1 | 50.0% | V#802 | 15.0% | E-1 | 5500 | 15.0% | Irg907 | 3.0% | | | 0.1% | 21.3% |
| Example 1-53 | A-7 | 6.9% | B-1 | 10.0% | C-1 | 50.0% | V#802 | 15.0% | E-2 | 520 | 2.5% | Irg907 | 3.0% | | | 0.1% | 21.3% |
| Example 1-54 | A-7 | 6.9% | B-1 | 10.0% | C-1 | 50.0% | V#802 | 15.0% | E-2 | 520 | 15.0% | Irg907 | 3.0% | | | 0.1% | 21.3% |
| Example 1-55 | A-7 | 2.9% | B-1 | 10.0% | | | V#802 | 15.0% | E-2 | 520 | 55.0% | Irg907 | 3.0% | | | 0.1% | 21.3% |
| Example 1-56 | A-7 | 6.9% | B-1 | 10.0% | C-1 | 50.0% | V#802 | 15.0% | E-3 | 280 | 15.0% | Irg907 | 3.0% | | | 0.1% | 21.3% |
| Example 1-57 | A-7 | 6.9% | B-1 | 10.0% | C-1 | 50.0% | V#802 | 15.0% | KBM-573 | | 15.0% | Irg907 | 3.0% | | | 0.1% | 21.3% |
| Example 1-58 | A-7 | 6.9% | B-2 | 10.0% | C-1 | 50.0% | V#802 | 15.0% | E-2 | 520 | 15.0% | Irg907 | 3.0% | | | 0.1% | 21.3% |
| Example 1-59 | A-7 | 6.9% | B-2 | 10.0% | C-1 | 50.0% | V#802 | 15.0% | E-2 | 520 | 15.0% | Irg907 | 3.0% | | | 0.1% | 21.3% |
| Example 1-60 | A-9 | 6.9% | B-2 | 10.0% | C-1 | 50.0% | V#802 | 15.0% | E-2 | 520 | 15.0% | Irg907 | 3.0% | | | 0.1% | 21.3% |
| Example 1-61 | A-10 | 6.9% | B-2 | 10.0% | C-1 | 50.0% | V#802 | 15.0% | E-2 | 520 | 15.0% | Irg907 | 3.0% | | | 0.1% | 21.3% |
| Example 1-62 | A-7 | 6.9% | B-1 | 10.0% | C-1 | 50.0% | V#802 | 15.0% | E-2 | 520 | 15.0% | OXE-01 | 3.0% | | | 0.1% | 21.3% |
| Example 1-63 | A-7 | 6.9% | B-1 | 10.0% | C-1 | 50.0% | V#802 | 15.0% | E-2 | 520 | 15.0% | OXE-02 | 3.0% | | | 0.1% | 21.3% |
| Example 1-64 | A-7 | 6.9% | B-1 | 7.0% | C-1 | 50.0% | V#802 | 15.0% | E-2 | 520 | 15.0% | OXE-02 | 3.0% | | | 0.1% | 21.3% |
| Example 1-65 | A-7 | 6.9% | B-1 | 20.0% | C-1 | 50.0% | V#802 | 15.0% | E-2 | 520 | 15.0% | OXE-02 | 3.0% | | | 0.1% | 21.3% |
| Example 1-66 | A-7 | 6.9% | B-2 | 10.0% | C-1 | 50.0% | | | E-2 | 520 | 15.0% | | | MX-43 | 18.0% | 0.1% | 21.3% |
| Example 1-67 | A-7 | 6.9% | B-2 | 10.0% | C-1 | 50.0% | | | E-2 | 520 | 15.0% | | | MX-417 | 18.0% | 0.1% | 21.3% |
| Example 1-68 | A-7 | 6.9% | B-2 | 10.0% | C-1 | 50.0% | | | E-2 | 520 | 15.0% | | | SB-401 | 18.0% | 0.1% | 21.3% |
| Example 1-69 | A-7 | 6.9% | B-2 | 10.0% | C-1 | 50.0% | | | E-2 | 520 | 15.0% | | | BL-60 | 18.0% | 0.1% | 21.3% |
| Example 1-70 | A-7 | 6.9% | B-2 | 10.0% | C-1 | 50.0% | | | E-2 | 520 | 15.0% | | | BL-4265 | 18.0% | 0.1% | 21.3% |
| Example 1-71 | A-7 | 6.9% | B-2 | 10.0% | C-1 | 50.0% | | | E-2 | 520 | 15.0% | | | EPPN-201 | 18.0% | 0.1% | 21.3% |
| Comparative Example 1-13 | A-7 | 6.9% | B-6 | 10.0% | C-1 | 50.0% | V#802 | 15.0% | E-2 | 520 | 15.0% | Irg907 | 3.0% | | | 0.1% | 21.3% |
| Comparative Example 1-14 | A-7 | 6.9% | B-7 | 10.0% | C-1 | 50.0% | V#802 | 15.0% | E-2 | 520 | 15.0% | Irg907 | 3.0% | | | 0.1% | 21.3% |
| Comparative Example 1-15 | A-7 | 6.9% | B-2 | 10.0% | - | - | V#802 | 15.0% | E-2 | 520 | 15.0% | Irg907 | 3.0% | | | 0.1% | 21.3% |
| Comparative Example 1-16 | A-7 | 6.9% | B-6 | 10.0% | C-1 | 50.0% | | | E-2 | 520 | 15.0% | | | MX-43 | 18.0% | 1.0% | 21.3% |
| Comparative Example 1-17 | A-7 | 6.9% | B-6 | 10.0% | C-1 | 50.0% | | | E-2 | 520 | 15.0% | | | BL-4265 | 18.0% | 1.0% | 21.3% |
| Comparative Example 1-18 | A-7 | 6.9% | B-6 | 10.0% | C-1 | 50.0% | | | E-2 | 520 | 15.0% | | | EPPN-201 | 18.0% | 1.0% | 21.3% |

Note 1)representing a ratio in solids of a resin composition
Note 2)representing a total of fine particles and dispersed res

V#802 : Viscoat #802 manufactured by Osaka Organic Chemic
DPCA60 : KAYARAD DPCA60 manufactured by Sartomer Inc.
M402 : Aronix M402 manufactured by Toagosei Co., Ltd.
KBM-573 : KBM-573 manufactured by Shin-Etsu Chemical Co., L

Irg907 : IRGACURE 907 manufactured by BASF
OXE-01 : IRGACURE OXE01 manufactured by BASF
OXE-02 : IRGACURE OXE02 manufactured by BASF
BYK330 : BYK330 manufactured by BYK Japan KK.

[Table 6B]

| | Solvent ratio | | |
|---|---|---|---|
| | PGMEA | methyl isobutyl ketone | cyclohexanone |
| Example 1-52 | 87.9% | 11.7% | 1.4% |
| Example 1-53 | 87.9% | 11.7% | 1.4% |
| Example 1-54 | 87.9% | 11.7% | 1.4% |
| Example 1-55 | 89.1% | 11.7% | 0.2% |
| Example 1-56 | 87.9% | 11.7% | 1.4% |
| Example 1-57 | 87.9% | 11.7% | 1.4% |
| Example 1-58 | 100.0% | 0.0% | 0.0% |
| Example 1-59 | 100.0% | 0.0% | 0.0% |
| Example 1-60 | 100.0% | 0.0% | 0.0% |
| Example 1-61 | 100.0% | 0.0% | 0.0% |
| Example 1-62 | 87.9% | 11.7% | 1.4% |
| Example 1-63 | 87.9% | 11.7% | 1.4% |
| Example 1-64 | 91.2% | 8.2% | 1.4% |
| Example 1-65 | 77.1% | 23.5% | 1.7% |
| Example 1-66 | 87.9% | 11.7% | 1.4% |
| Example 1-67 | 87.9% | 11.7% | 1.4% |
| Example 1-68 | 87.9% | 11.7% | 1.4% |
| Example 1-69 | 87.9% | 11.7% | 1.4% |
| Example 1-70 | 87.9% | 11.7% | 1.4% |
| Example 1-71 | 87.9% | 11.7% | 1.4% |
| Comparative Example 1-13 | 87.9% | 11.7% | 1.4% |
| Comparative Example 1-14 | 87.9% | 11.7% | 1.4% |
| Comparative Example 1-15 | 100.0% | 0.0% | 0.0% |
| Comparative Example 1-16 | 87.9% | 11.7% | 1.4% |
| Comparative Example 1-17 | 87.9% | 11.7% | 1.4% |
| Comparative Example 1-18 | 87.9% | 11.7% | 1.4% |

[Table 7A]

| | Resin (A) | | Light scattering particles (B) | | Metallic oxide fine particles (C) | | Ethylenically unsaturated | | silane compound (E) | | | photopolymerization initiator (F) | | Heat-reactive compound (G) | | leveling agent | Solids content |
|---|---|---|---|---|---|---|---|---|---|---|---|---|---|---|---|---|---|
| | Type | Loads (Note 1) | Type | Loads (Note 1,2) | Type (Note 2) | Loads (Note 1) | Type | Loads (Note 1) | Type | Molecular weight | Loads (Note 1) | Type | Loads (Note 1) | Type | Loads (Note 1) | BYK330 | |
| Example 1-72 | A-7 | 6.9% | B-1 | 10.0% | C-1 | 50.0% | V#802 | 15.0% | E-1 | 5500 | 15.0% | Irg907 | 3.0% | | | 0.1% | 15.0% |
| Example 1-73 | A-7 | 6.9% | B-1 | 10.0% | C-1 | 50.0% | V#802 | 15.0% | E-2 | 520 | 2.5% | Irg907 | 3.0% | | | 0.1% | 15.0% |
| Example 1-74 | A-7 | 6.9% | B-1 | 10.0% | C-1 | 50.0% | V#802 | 15.0% | E-2 | 520 | 15.0% | Irg907 | 3.0% | | | 0.1% | 15.0% |
| Example 1-75 | A-7 | 2.9% | B-1 | 10.0% | | | V#802 | 15.0% | E-2 | 520 | 55.0% | Irg907 | 3.0% | | | 0.1% | 15.0% |
| Example 1-76 | A-7 | 6.9% | B-1 | 10.0% | C-1 | 50.0% | V#802 | 15.0% | E-3 | 280 | 15.0% | Irg907 | 3.0% | | | 0.1% | 15.0% |
| Example 1-77 | A-7 | 6.9% | B-1 | 10.0% | C-1 | 50.0% | V#802 | 15.0% | KBM-573 | | 15.0% | Irg907 | 3.0% | | | 0.1% | 15.0% |
| Example 1-78 | A-7 | 6.9% | B-2 | 10.0% | C-1 | 50.0% | V#802 | 15.0% | E-2 | 520 | 15.0% | Irg907 | 3.0% | | | 0.1% | 15.0% |
| Example 1-79 | A-7 | 6.9% | B-2 | 10.0% | C-1 | 50.0% | V#802 | 15.0% | E-2 | 520 | 15.0% | Irg907 | 3.0% | | | 0.1% | 15.0% |
| Example 1-80 | A-9 | 6.9% | B-2 | 10.0% | C-1 | 50.0% | V#802 | 15.0% | E-2 | 520 | 15.0% | Irg907 | 3.0% | | | 0.1% | 15.0% |
| Example 1-81 | A-10 | 6.9% | B-2 | 10.0% | C-1 | 50.0% | V#802 | 15.0% | E-2 | 520 | 15.0% | Irg907 | 3.0% | | | 0.1% | 15.0% |
| Example 1-82 | A-7 | 6.9% | B-1 | 10.0% | C-1 | 50.0% | V#802 | 15.0% | E-2 | 520 | 15.0% | OXE-01 | 3.0% | | | 0.1% | 15.0% |
| Example 1-83 | A-7 | 6.9% | B-1 | 10.0% | C-1 | 50.0% | V#802 | 15.0% | E-2 | 520 | 15.0% | OXE-02 | 3.0% | | | 0.1% | 15.0% |
| Example 1-84 | A-7 | 6.9% | B-1 | 7.0% | C-1 | 50.0% | V#802 | 15.0% | E-2 | 520 | 15.0% | OXE-02 | 3.0% | | | 0.1% | 15.0% |
| Example 1-85 | A-7 | 6.9% | B-1 | 20.0% | C-1 | 50.0% | V#802 | 15.0% | E-2 | 520 | 15.0% | OXE-02 | 3.0% | | | 0.1% | 15.0% |
| Example 1-86 | A-7 | 6.9% | B-2 | 10.0% | C-1 | 50.0% | | | E-2 | 520 | 15.0% | | | MX-43 | 18.0% | 0.1% | 15.0% |
| Example 1-87 | A-7 | 6.9% | B-2 | 10.0% | C-1 | 50.0% | | | E-2 | 520 | 15.0% | | | MX-417 | 18.0% | 0.1% | 15.0% |
| Example 1-88 | A-7 | 6.9% | B-2 | 10.0% | C-1 | 50.0% | | | E-2 | 520 | 15.0% | | | SB-401 | 18.0% | 0.1% | 15.0% |
| Example 1-89 | A-7 | 6.9% | B-2 | 10.0% | C-1 | 50.0% | | | E-2 | 520 | 15.0% | | | BL-60 | 18.0% | 0.1% | 15.0% |
| Example 1-90 | A-7 | 6.9% | B-2 | 10.0% | C-1 | 50.0% | | | E-2 | 520 | 15.0% | | | BL-4265 | 18.0% | 0.1% | 15.0% |
| Example 1-91 | A-7 | 6.9% | B-2 | 10.0% | C-1 | 50.0% | | | E-2 | 520 | 15.0% | | | EPPN-201 | 18.0% | 0.1% | 15.0% |
| Comparative Example 1-19 | A-7 | 6.9% | B-6 | 10.0% | C-1 | 50.0% | V#802 | 15.0% | E-2 | 520 | 15.0% | Irg907 | 3.0% | | | 0.1% | 15.0% |
| Comparative Example 1-20 | A-7 | 6.9% | B-7 | 10.0% | C-1 | 50.0% | V#802 | 15.0% | E-2 | 520 | 15.0% | Irg907 | 3.0% | | | 0.1% | 15.0% |
| Comparative Example 1-21 | A-7 | 6.9% | B-2 | 10.0% | - | - | V#802 | 15.0% | E-2 | 520 | 15.0% | Irg907 | 3.0% | | | 0.1% | 15.0% |
| Comparative Example 1-22 | A-7 | 6.9% | B-6 | 10.0% | C-1 | 50.0% | | | E-2 | 520 | 15.0% | | | MX-43 | 18.0% | 1.0% | 15.0% |
| Comparative Example 1-23 | A-7 | 6.9% | B-6 | 10.0% | C-1 | 50.0% | | | E-2 | 520 | 15.0% | | | BL-4265 | 18.0% | 1.0% | 15.0% |
| Comparative Example 1-24 | A-7 | 6.9% | B-6 | 10.0% | C-1 | 50.0% | | | E-2 | 520 | 15.0% | | | EPPN-201 | 18.0% | 1.0% | 15.0% |

Note 1)representing a ratio in solids of a resin composition
Note 2)representing a total of fine particles and dispersed res

V#802 :Viscoat #802 manufactured by Osaka Organic Chemica
DPCA60 :KAYARAD DPCA60 manufactured by Sartomer Inc.
M402 :Aronix M402 manufactured by Toagosei Co., Ltd.
KBM-573 :KBM-573 manufactured by Shin-Etsu Chemical Co., L

Irg907 : IRGACURE 907 manufactured by BASF
OXE-01 : IRGACURE OXE01 manufactured by BASF
OXE-02 : IRGACURE OXE02 manufactured by BASF
BYK330 : BYK330 manufactured by BYK Japan KK.

[Table 7B]

| | Solvent ratio | | | | |
|---|---|---|---|---|---|
| | PGMEA | methyl isobutyl ketone | cyclohexanone | CBAc | 1,3BGDA |
| Example 1-72 | 80.6% | 10.6% | 1.3% | 0.0% | 7.5% |
| Example 1-73 | 80.6% | 10.6% | 1.3% | 0.0% | 7.5% |
| Example 1-74 | 80.6% | 10.6% | 1.3% | 0.0% | 7.5% |
| Example 1-75 | 81.7% | 10.6% | 0.2% | 0.0% | 7.5% |
| Example 1-76 | 80.6% | 10.6% | 1.3% | 0.0% | 7.5% |
| Example 1-77 | 80.6% | 10.6% | 1.3% | 0.0% | 7.5% |
| Example 1-78 | 91.4% | 0.0% | 1.1% | 0.0% | 7.5% |
| Example 1-79 | 91.4% | 0.0% | 1.1% | 0.0% | 7.5% |
| Example 1-80 | 91.4% | 0.0% | 1.1% | 0.0% | 7.5% |
| Example 1-81 | 91.4% | 0.0% | 1.1% | 0.0% | 7.5% |
| Example 1-82 | 80.6% | 10.6% | 1.3% | 0.0% | 7.5% |
| Example 1-83 | 80.6% | 10.6% | 1.3% | 0.0% | 7.5% |
| Example 1-84 | 83.8% | 7.4% | 1.2% | 0.0% | 7.5% |
| Example 1-85 | 69.7% | 21.3% | 1.5% | 0.0% | 7.5% |
| Example 1-86 | 80.6% | 10.6% | 1.3% | 7.5% | 0.0% |
| Example 1-87 | 80.6% | 10.6% | 1.3% | 7.5% | 0.0% |
| Example 1-88 | 80.6% | 10.6% | 1.3% | 7.5% | 0.0% |
| Example 1-89 | 80.6% | 10.6% | 1.3% | 7.5% | 0.0% |
| Example 1-90 | 80.6% | 10.6% | 1.3% | 7.5% | 0.0% |
| Example 1-91 | 80.6% | 10.6% | 1.3% | 7.5% | 0.0% |
| Comparative Example 1-19 | 80.6% | 10.6% | 1.3% | 0.0% | 7.5% |
| Comparative Example 1-20 | 80.6% | 10.6% | 1.3% | 0.0% | 7.5% |
| Comparative Example 1-21 | 92.5% | 0.0% | 0.0% | 0.0% | 7.5% |
| Comparative Example 1-22 | 80.6% | 10.6% | 1.3% | 7.5% | 0.0% |
| Comparative Example 1-23 | 80.6% | 10.6% | 1.3% | 7.5% | 0.0% |
| Comparative Example 1-24 | 80.6% | 10.6% | 1.3% | 7.5% | 0.0% |

[Table 8]

| | Luminous layer | | Electron injection layer |
|---|---|---|---|
| | Structure of luminous body compound | Thickness | |
| Red | 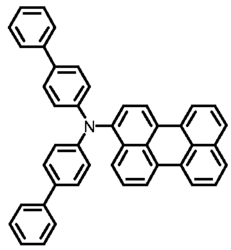 | 40nm | tris(8-hydroxyquinoline)aluminum complex<br><br>(Alq3) |

(continued)

| | Luminous layer | | Electron injection layer |
|---|---|---|---|
| | Structure of luminous body compound | Thickness | |
| Blue | 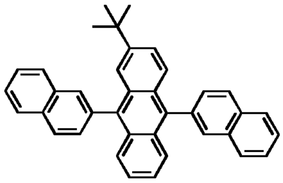 | 40nm | 2,2', 2"-(1,3,5-benzenetriyl)tris[1-phenyl-1H-benzimidazole] (TPBI) |
| Green | 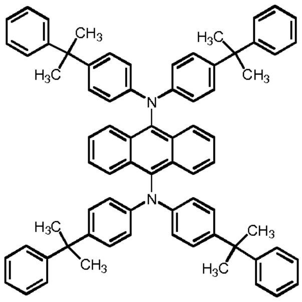 | 40nm | Alq3 |
| White | laminated in order of red/blue/α-NPD/green= 20nm/40nm/5nm/20nm | | Alq3 |

[Table 9]

| | Binder refractive index | Refractive index difference | Transmittance | Heat resistance (Transmittance) | Evaluation of EL device | | |
|---|---|---|---|---|---|---|---|
| | | | | | Extraction efficiency | Emission appearance | Wavelength dependence |
| Example 1-1 | Δ | o | o | o | oo | o | Δ |
| Example 1-2 | o | o | o | o | oo | o | o |
| Example 1-3 | o | o | o | o | oo | o | o |
| Example 1-4 | Δ | o | o | o | oo | o | Δ |
| Example 1-5 | Δ | o | o | o | o | o | o |
| Example 1-6 | Δ | o | o | o | o | Δ | Δ |
| Example 1-7 | Δ | o | o | o | oo | o | Δ |
| Example 1-8 | Δ | o | o | o | o | Δ | Δ |
| Example 1-9 | Δ | o | o | o | oo | o | Δ |
| Example 1-10 | Δ | o | o | o | oo | o | Δ |
| Example 1-11 | o | o | o | o | oo | o | o |
| Example 1-12 | o | o | o | o | oo | o | o |
| Example 1-13 | o | o | o | o | oo | o | o |
| Example 1-14 | o | o | o | o | oo | o | o |
| Example 1-15 | o | o | o | Δ | o | Δ | o |
| Example 1-16 | o | o | o | o | oo | o | o |
| Example 1-17 | o | o | o | o | oo | o | o |
| Example 1-18 | o | o | o | o | oo | o | o |
| Example 1-19 | Δ | o | Δ | Δ | oo | o | Δ |
| Example 1-20 | o | o | o | o | oo | o | o |
| Example 1-21 | o | o | o | o | oo | o | o |
| Example 1-22 | o | o | o | o | oo | o | o |
| Example 1-23 | o | o | o | o | oo | o | o |

(continued)

| | Binder refractive index | Refractive index difference | Transmittance | Heat resistance (Transmittance) | Evaluation of EL device | | |
|---|---|---|---|---|---|---|---|
| | | | | | Extraction efficiency | Emission appearance | Wavelength dependence |
| Example 1-24 | o | o | o | o | o | o | o |
| Example 1-25 | o | o | Δ | Δ | o | o | o |
| Example 1-26 | o | o | o | o | oo | o | o |
| Example 1-27 | o | o | o | o | oo | o | o |
| Example 1-28 | o | o | o | o | o | o | o |
| Example 1-29 | o | o | o | o | oo | o | o |
| Example 1-30 | o | o | o | o | o | o | o |
| Example 1-31 | o | o | o | o | oo | o | o |
| Comparative Example 1-1 | o | o | o | o | o | Δ | x |
| Comparative Example 1-2 | o | o | o | o | Δ | x | x |
| Comparative Example 1-3 | o | o | o | o | o | Δ | x |
| Comparative Example 1-4 | Δ | x | o | o | Δ | o | Δ |

[Table 10]

| | Adhesive properties | | Etchant resistance (ITO adhesion) | Chemical resistance | | Evenness | Decelopment rate |
|---|---|---|---|---|---|---|---|
| | glass | ITO | | acetone | IPA | | |
| Example 1-1 | Δ | x | Δ | Δ | Δ | oo | x |
| Example 1-2 | Δ | x | Δ | Δ | Δ | oo | x |
| Example 1-3 | Δ | x | Δ | Δ | Δ | oo | x |
| Example 1-4 | Δ | x | Δ | Δ | Δ | oo | x |
| Example 1-5 | Δ | x | Δ | Δ | Δ | oo | x |
| Example 1-6 | o | Δ | o | o | o | oo | x |
| Example 1-7 | o | o | o | o | o | oo | Δ |
| Example 1-8 | o | Δ | Δ | Δ | Δ | oo | o |
| Example 1-9 | Δ | Δ | o | Δ | Δ | oo | Δ |
| Example 1-10 | o | o | o | o | o | oo | Δ |
| Example 1-11 | o | o | o | o | o | oo | Δ |
| Example 1-12 | o | o | Δ | o | o | oo | o |
| Example 1-13 | o | o | o | o | o | oo | o |
| Example 1-14 | o | o | o | o | o | oo | o |
| Example 1-15 | o | Δ | Δ | o | o | Δ | x |
| Example 1-16 | oo | o | o | o | o | o | o |
| Example 1-17 | o | oo | oo | oo | oo | oo | o |
| Example 1-18 | oo | oo | oo | oo | oo | oo | o |
| Example 1-19 | oo | o | o | oo | oo | Δ | x |
| Example 1-20 | oo | oo | oo | oo | oo | oo | o |
| Example 1-21 | o | Δ | o | o | oo | oo | o |
| Example 1-22 | oo | oo | oo | oo | oo | oo | o |
| Example 1-23 | oo | oo | oo | oo | oo | oo | o |
| Example 1-24 | Δ | Δ | Δ | Δ | Δ | Δ | Δ |
| Example 1-25 | o | o | o | o | o | Δ | Δ |
| Example 1-26 | oo | oo | oo | oo | oo | oo | o |
| Example 1-27 | oo | oo | oo | oo | oo | oo | o |
| Example 1-28 | oo | oo | oo | oo | oo | oo | o |
| Example 1-29 | oo | oo | oo | oo | oo | o | o |
| Example 1-30 | oo | oo | oo | oo | oo | oo | o |
| Example 1-31 | oo | oo | oo | oo | oo | o | o |
| Comparative Example 1-1 | oo | oo | oo | oo | oo | x | o |
| Comparative Example 1-2 | oo | oo | oo | oo | oo | x | o |

(continued)

| | Adhesive properties | | Etchant resistance (ITO adhesion) | Chemical resistance | | Evenness | Decelopment rate |
|---|---|---|---|---|---|---|---|
| | glass | ITO | | acetone | IPA | | |
| Comparative Example 1-3 | Δ | x | Δ | Δ | Δ | x | o |
| Comparative Example 1-4 | oo | oo | oo | oo | oo | oo | o |

[Table 11]

| | Luminous layer |
|---|---|
| | Structure of luminous body compound |
| Ir-1 | 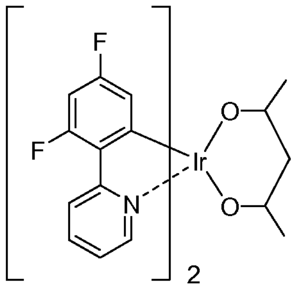 |
| H1 | 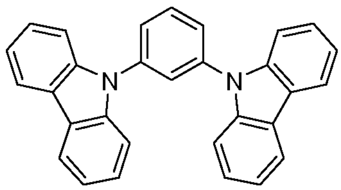 |

[Table 12]

| | Luminous layer |
|---|---|
| | Structure of luminous body compound |
| Ir-2 | 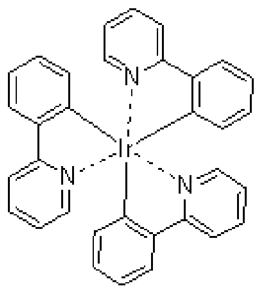 |
| ET M-1 | 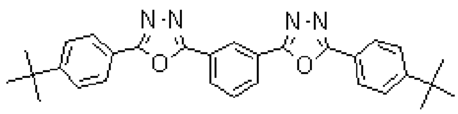 |

[Table 13]

| | Top emission type A | | | Top emission type B | | | Coating type | |
|---|---|---|---|---|---|---|---|---|
| | Evaluation of emission device | | | Evaluation of emission device | | | Evaluation of emission device | |
| | Extraction efficiency | Emission appearance | | Extraction efficiency | Emission appearance | | Extraction efficiency | Emission appearance |
| Example 1-1 | oo | o | Example 1-1 | oo | o | Example 1-1 | oo | o |
| Example 1-2 | oo | o | Example 1-2 | oo | o | Example 1-2 | oo | o |
| Example 1-3 | oo | o | Example 1-3 | oo | o | Example 1-3 | oo | o |
| Example 1-4 | oo | o | Example 1-4 | oo | o | Example 1-4 | oo | o |
| Example 1-5 | o | o | Example 1-5 | o | o | Example 1-5 | o | o |
| Example 1-6 | o | △ | Example 1-6 | o | △ | Example 1-6 | o | △ |
| Example 1-7 | oo | o | Example 1-7 | oo | o | Example 1-7 | oo | o |
| Example 1-8 | o | △ | Example 1-8 | o | △ | Example 1-8 | o | △ |
| Example 1-9 | oo | o | Example 1-9 | oo | o | Example 1-9 | oo | o |
| Example 1-10 | oo | o | Example 1-10 | oo | o | Example 1-10 | oo | o |
| Example 1-11 | oo | o | Example 1-11 | oo | o | Example 1-11 | oo | o |
| Example 1-12 | oo | o | Example 1-12 | oo | o | Example 1-12 | oo | o |
| Example 1-13 | oo | o | Example 1-13 | oo | o | Example 1-13 | oo | o |
| Example 1-14 | oo | o | Example 1-14 | oo | o | Example 1-14 | oo | o |
| Example 1-15 | o | △ | Example 1-15 | o | △ | Example 1-15 | o | △ |
| Example 1-16 | oo | o | Example 1-16 | oo | o | Example 1-16 | oo | o |
| Example 1-17 | oo | o | Example 1-17 | oo | o | Example 1-17 | oo | o |
| Example 1-18 | oo | o | Example 1-18 | oo | o | Example 1-18 | oo | o |
| Example 1-19 | oo | o | Example 1-19 | oo | o | Example 1-19 | oo | o |
| Example 1-20 | oo | o | Example 1-20 | oo | o | Example 1-20 | oo | o |
| Example 1-21 | oo | o | Example 1-21 | oo | o | Example 1-21 | oo | o |
| Example 1-22 | oo | o | Example 1-22 | oo | o | Example 1-22 | oo | o |

(continued)

| Top emission type A | | | Top emission type B | | | Coating type | | |
|---|---|---|---|---|---|---|---|---|
| | Evaluation of emission device | | | Evaluation of emission device | | | Evaluation of emission device | |
| | Extraction efficiency | Emission appearance | | Extraction efficiency | Emission appearance | | Extraction efficiency | Emission appearance |
| Example 1-23 | oo | o | Example 1-23 | oo | o | Example 1-23 | oo | o |
| Example 1-24 | o | o | Example 1-24 | o | o | Example 1-24 | o | o |
| Example 1-25 | o | o | Example 1-25 | o | o | Example 1-25 | o | o |
| Example 1-26 | oo | o | Example 1-26 | oo | o | Example 1-26 | oo | o |
| Example 1-27 | oo | o | Example 1-27 | oo | o | Example 1-27 | oo | o |
| Example 1-28 | o | o | Example 1-28 | o | o | Example 1-28 | o | o |
| Example 1-29 | oo | o | Example 1-29 | oo | o | Example 1-29 | oo | o |
| Example 1-30 | o | o | Example 1-30 | o | o | Example 1-30 | o | o |
| Example 1-31 | oo | o | Example 1-31 | oo | o | Example 1-31 | oo | o |
| Comparative Example 1-4 | o | Δ | Comparative Example 1-4 | o | Δ | Comparative Example 1-4 | o | Δ |
| Comparative Example 1-5 | Δ | x | Comparative Example 1-5 | Δ | x | Comparative Example 1-5 | Δ | x |

[Table 14]

| Reverse offset | Binder refractive index | Refractive index difference | Transmittance | Heat resistance (Transmittance) | Evaluation of emission device | | |
|---|---|---|---|---|---|---|---|
| | | | | | Extraction efficiency | Emission appearance | Wavelength dependence |
| Example 1-32 | o | o | o | o | oo | o | o |
| Example 1-33 | o | o | o | o | oo | o | o |
| Example 1-34 | o | o | o | o | oo | o | o |
| Example 1-35 | Δ | o | Δ | Δ | oo | o | Δ |
| Example 1-36 | o | o | o | o | oo | o | o |
| Example 1-37 | o | o | o | o | oo | o | o |
| Example 1-38 | o | o | o | o | oo | o | o |
| Example 1-39 | o | o | o | o | oo | o | o |
| Example 1-40 | o | o | o | o | o | o | o |
| Example 1-41 | o | o | Δ | Δ | o | o | o |
| Example 1-42 | o | o | o | o | oo | o | o |
| Example 1-43 | o | o | o | o | oo | o | o |
| Example 1-44 | o | o | o | o | o | o | o |
| Example 1-45 | o | o | o | o | oo | o | o |
| Example 1-46 | o | o | o | o | oo | o | o |
| Example 1-47 | o | o | o | o | oo | o | o |
| Example 1-48 | o | o | o | o | oo | o | o |
| Example 1-49 | o | o | o | o | oo | o | o |
| Example 1-50 | o | o | o | o | oo | o | o |
| Example 1-51 | o | o | o | o | oo | o | o |
| Comparative Example 1-7 | o | o | o | o | o | Δ | x |
| Comparative Example 1-8 | o | o | o | o | Δ | x | x |

(continued)

| Reverse offset | Binder refractive index | Refractive index difference | Transmittance | Heat resistance (Transmittance) | Evaluation of emission device | | |
|---|---|---|---|---|---|---|---|
| | | | | | Extraction efficiency | Emission appearance | Wavelength dependence |
| Comparative Example 1-9 | Δ | x | o | o | Δ | o | Δ |
| Comparative Example 1-10 | o | o | o | o | o | Δ | x |
| Comparative Example 1-11 | o | o | o | o | o | Δ | x |
| Comparative Example 1-12 | o | o | o | o | o | Δ | x |

[Table 15]

| Reverse offset | Adhesive properties | | Etchant resistance (ITO adhesion) | Chemical resistance | | Evenness | Printability |
|---|---|---|---|---|---|---|---|
| | glass | ITO | | acetone | IPA | | Reverse offset |
| Example 1-32 | oo | o | o | o | o | o | o |
| Example 1-33 | o | oo | oo | oo | oo | oo | o |
| Example 1-34 | oo | oo | oo | oo | oo | oo | o |
| Example 1-35 | oo | o | o | oo | oo | Δ | o |
| Example 1-36 | oo | oo | oo | oo | oo | oo | o |
| Example 1-37 | o | Δ | o | o | oo | oo | o |
| Example 1-38 | oo | oo | oo | oo | oo | oo | o |
| Example 1-39 | oo | oo | oo | oo | oo | oo | o |
| Example 1-40 | Δ | Δ | Δ | Δ | Δ | Δ | o |
| Example 1-41 | o | o | o | o | o | Δ | o |
| Example 1-42 | oo | oo | oo | oo | oo | oo | o |
| Example 1-43 | oo | oo | oo | oo | oo | oo | o |
| Example 1-44 | oo | oo | oo | oo | oo | oo | o |
| Example 1-45 | oo | oo | oo | oo | oo | o | o |
| Example 1-46 | oo | oo | oo | oo | oo | oo | o |
| Example 1-47 | oo | oo | oo | oo | oo | oo | o |
| Example 1-48 | oo | oo | oo | oo | oo | oo | o |
| Example 1-49 | oo | oo | oo | oo | oo | oo | o |
| Example 1-50 | oo | oo | oo | oo | oo | oo | o |
| Example 1-51 | oo | oo | oo | oo | oo | oo | o |
| Comparative Example 1-7 | oo | oo | oo | oo | oo | x | o |
| Comparative Example 1-8 | oo | oo | oo | oo | oo | x | o |
| Comparative Example 1-9 | oo | oo | oo | oo | oo | oo | o |
| Comparative Example 1-10 | oo | oo | oo | oo | oo | x | o |
| Comparative Example 1-11 | oo | oo | oo | oo | oo | x | o |
| Comparative Example 1-12 | oo | oo | oo | oo | oo | x | o |

[Table 16]

| Flexographic system | Binder refractive index | Refractive index difference | Transmittance | Heat resistance (Transmittance) | Evaluation of emission device | | |
|---|---|---|---|---|---|---|---|
| | | | | | Extraction efficiency | Emission appearance | Wavelength dependence |
| Example 1-52 | o | o | o | o | oo | o | o |
| Example 1-53 | o | o | o | o | oo | o | o |
| Example 1-54 | o | o | o | o | oo | o | o |
| Example 1-55 | Δ | o | Δ | Δ | oo | o | Δ |
| Example 1-56 | o | o | o | o | oo | o | o |
| Example 1-57 | o | o | o | o | oo | o | o |
| Example 1-58 | o | o | o | o | oo | o | o |
| Example 1-59 | o | o | o | o | oo | o | o |
| Example 1-60 | o | o | o | o | o | o | o |
| Example 1-61 | o | o | Δ | Δ | o | o | o |
| Example 1-62 | o | o | o | o | oo | o | o |
| Example 1-63 | o | o | o | o | oo | o | o |
| Example 1-64 | o | o | o | o | o | o | o |
| Example 1-65 | o | o | o | o | oo | o | o |
| Example 1-66 | o | o | o | o | oo | o | o |
| Example 1-67 | o | o | o | o | oo | o | o |
| Example 1-68 | o | o | o | o | oo | o | o |
| Example 1-69 | o | o | o | o | oo | o | o |
| Example 1-70 | o | o | o | o | oo | o | o |
| Example 1-71 | o | o | o | o | oo | o | o |
| Comparative Example 1-13 | o | o | o | o | o | Δ | x |
| Comparative Example 1-14 | o | o | o | o | Δ | x | x |

(continued)

| Flexographic system | Binder refractive index | Refractive index difference | Transmittance | Heat resistance (Transmittance) | Evaluation of emission device | | |
|---|---|---|---|---|---|---|---|
| | | | | | Extraction efficiency | Emission appearance | Wavelength dependence |
| Comparative Example 1-15 | Δ | x | o | o | Δ | o | Δ |
| Comparative Example 1-16 | o | o | o | o | o | Δ | x |
| Comparative Example 1-17 | o | o | o | o | o | Δ | x |
| Comparative Example 1-18 | o | o | o | o | o | Δ | x |

[Table 17]

| Flexographic system | Adhesive properties | | Etchant resistance (ITO adhesion) | Chemical resistance | | Evenness | Printability |
|---|---|---|---|---|---|---|---|
| | glass | ITO | | acetone | IPA | | Flexographic printing |
| Example 1-52 | oo | o | o | o | o | o | o |
| Example 1-53 | o | oo | oo | oo | oo | oo | o |
| Example 1-54 | oo | oo | oo | oo | oo | oo | o |
| Example 1-55 | oo | o | o | oo | oo | Δ | o |
| Example 1-56 | oo | oo | oo | oo | oo | oo | o |
| Example 1-57 | o | Δ | o | o | oo | oo | o |
| Example 1-58 | oo | oo | oo | oo | oo | oo | o |
| Example 1-59 | oo | oo | oo | oo | oo | oo | o |
| Example 1-60 | Δ | Δ | Δ | Δ | Δ | Δ | o |
| Example 1-61 | o | o | o | o | o | Δ | o |
| Example 1-62 | oo | oo | oo | oo | oo | oo | o |
| Example 1-63 | oo | oo | oo | oo | oo | oo | o |
| Example 1-64 | oo | oo | oo | oo | oo | oo | o |
| Example 1-65 | oo | oo | oo | oo | oo | o | o |
| Example 1-66 | oo | oo | oo | oo | oo | oo | o |
| Example 1-67 | oo | oo | oo | oo | oo | oo | o |
| Example 1-68 | oo | oo | oo | oo | oo | oo | o |
| Example 1-69 | oo | oo | oo | oo | oo | oo | o |
| Example 1-70 | oo | oo | oo | oo | oo | oo | o |
| Example 1-71 | oo | oo | oo | oo | oo | oo | o |
| Comparative Example 1-13 | oo | oo | oo | oo | oo | x | o |
| Comparative Example 1-14 | oo | oo | oo | oo | oo | x | o |
| Comparative Example 1-15 | oo | oo | oo | oo | oo | oo | o |
| Comparative Example 1-16 | oo | oo | oo | oo | oo | x | o |
| Comparative Example 1-17 | oo | oo | oo | oo | oo | x | o |
| Comparative Example 1-18 | oo | oo | oo | oo | oo | x | o |

[Table 18]

| Gravure system | Binder refractive index | Refractive index difference | Transmittance | Heat resistance (Transmittance) | Evaluation of emission device | | |
|---|---|---|---|---|---|---|---|
| | | | | | Extraction efficiency | Emission appearance | Wavelength dependence |
| Example 1-52 | o | o | o | o | oo | o | o |
| Example 1-53 | o | o | o | o | oo | o | o |
| Example 1-54 | o | o | o | o | oo | o | o |
| Example 1-55 | Δ | o | Δ | Δ | oo | o | Δ |
| Example 1-56 | o | o | o | o | oo | o | o |
| Example 1-57 | o | o | o | o | oo | o | o |
| Example 1-58 | o | o | o | o | oo | o | o |
| Example 1-59 | o | o | o | o | oo | o | o |
| Example 1-60 | o | o | o | o | o | o | o |
| Example 1-61 | o | o | Δ | Δ | o | o | o |
| Example 1-62 | o | o | o | o | oo | o | o |
| Example 1-63 | o | o | o | o | oo | o | o |
| Example 1-64 | o | o | o | o | o | o | o |
| Example 1-65 | o | o | o | o | oo | o | o |
| Example 1-66 | o | o | o | o | oo | o | o |
| Example 1-67 | o | o | o | o | oo | o | o |
| Example 1-68 | o | o | o | o | oo | o | o |
| Example 1-69 | o | o | o | o | oo | o | o |
| Example 1-70 | o | o | o | o | oo | o | o |
| Example 1-71 | o | o | o | o | oo | o | o |
| Comparative Example 1-13 | o | o | o | o | o | Δ | x |
| Comparative Example 1-14 | o | o | o | o | Δ | x | x |

(continued)

| Gravure system | Binder refractive index | Refractive index difference | Transmittance | Heat resistance (Transmittance) | Evaluation of emission device | | |
|---|---|---|---|---|---|---|---|
| | | | | | Extraction efficiency | Emission appearance | Wavelength dependence |
| Comparative Example 1-15 | Δ | x | o | o | Δ | o | Δ |
| Comparative Example 1-16 | o | o | o | o | o | Δ | x |
| Comparative Example 1-17 | o | o | o | o | o | Δ | x |
| Comparative Example 1-18 | o | o | o | o | o | Δ | x |

[Table 19]

| Gravure system | Adhesive properties | | Etchant resistance (ITO adhesion) | Chemical resistance | | Evenness | Printability |
|---|---|---|---|---|---|---|---|
| | glass | ITO | | acetone | IPA | | Gravure printing |
| Example 1-52 | oo | o | o | o | o | o | o |
| Example 1-53 | o | oo | oo | oo | oo | oo | o |
| Example 1-54 | oo | oo | oo | oo | oo | oo | o |
| Example 1-55 | oo | o | o | oo | oo | Δ | o |
| Example 1-56 | oo | oo | oo | oo | oo | oo | o |
| Example 1-57 | o | Δ | o | o | oo | oo | o |
| Example 1-58 | oo | oo | oo | oo | oo | oo | o |
| Example 1-59 | oo | oo | oo | oo | oo | oo | o |
| Example 1-60 | Δ | Δ | Δ | Δ | Δ | Δ | o |
| Example 1-61 | o | o | o | o | o | Δ | o |
| Example 1-62 | oo | oo | oo | oo | oo | oo | o |
| Example 1-63 | oo | oo | oo | oo | oo | oo | o |
| Example 1-64 | oo | oo | oo | oo | oo | oo | o |
| Example 1-65 | oo | oo | oo | oo | oo | o | o |
| Example 1-66 | oo | oo | oo | oo | oo | oo | o |
| Example 1-67 | oo | oo | oo | oo | oo | oo | o |
| Example 1-68 | oo | oo | oo | oo | oo | oo | o |
| Example 1-69 | oo | oo | oo | oo | oo | oo | o |
| Example 1-70 | oo | oo | oo | oo | oo | oo | o |
| Example 1-71 | oo | oo | oo | oo | oo | oo | o |
| Comparative Example 1-13 | oo | oo | oo | oo | oo | x | o |
| Comparative Example 1-14 | oo | oo | oo | oo | oo | x | o |
| Comparative Example 1-15 | oo | oo | oo | oo | oo | oo | o |
| Comparative Example 1-16 | oo | oo | oo | oo | oo | x | o |
| Comparative Example 1-17 | oo | oo | oo | oo | oo | x | o |
| Comparative Example 1-18 | oo | oo | oo | oo | oo | x | o |

[Table 20]

| | Binder refractive index | Refractive index difference | Transmittance | Heat resistance (Transmittance) | Evaluation of emission device | | |
|---|---|---|---|---|---|---|---|
| | | | | | Extraction efficiency | Emission appearance | Wavelength dependence |
| Example 1-72 | o | o | o | o | oo | o | o |
| Example 1-73 | o | o | o | o | oo | o | o |
| Example 1-74 | o | o | o | o | oo | o | o |
| Example 1-75 | Δ | o | Δ | Δ | oo | o | Δ |
| Example 1-76 | o | o | o | o | oo | o | o |
| Example 1-77 | o | o | o | o | oo | o | o |
| Example 1-78 | o | o | o | o | oo | o | o |
| Example 1-79 | o | o | o | o | oo | o | o |
| Example 1-80 | o | o | o | o | o | o | o |
| Example 1-81 | o | o | Δ | Δ | o | o | o |
| Example 1-82 | o | o | o | o | oo | o | o |
| Example 1-83 | o | o | o | o | oo | o | o |
| Example 1-84 | o | o | o | o | o | o | o |
| Example 1-85 | o | o | o | o | oo | o | o |
| Example 1-86 | o | o | o | o | oo | o | o |
| Example 1-87 | o | o | o | o | oo | o | o |
| Example 1-88 | o | o | o | o | oo | o | o |
| Example 1-89 | o | o | o | o | oo | o | o |
| Example 1-90 | o | o | o | o | oo | o | o |
| Example 1-91 | o | o | o | o | oo | o | o |
| Comparative Example 1-19 | o | o | o | o | o | Δ | x |
| Comparative Example 1-20 | o | o | o | o | Δ | x | x |

(continued)

| | Binder refractive index | Refractive index difference | Transmittance | Heat resistance (Transmittance) | Evaluation of emission device | | |
|---|---|---|---|---|---|---|---|
| | | | | | Extraction efficiency | Emission appearance | Wavelength dependence |
| Comparative Example 1-21 | Δ | x | o | o | Δ | o | Δ |
| Comparative Example 1-22 | o | o | o | o | o | Δ | x |
| Comparative Example 1-23 | o | o | o | o | o | Δ | x |
| Comparative Example 1-24 | o | o | o | o | o | Δ | x |

[Table 21]

| | Adhesive properties | | Etchant resistance (ITO | Chemical resistance | | Evenness | Printability |
|---|---|---|---|---|---|---|---|
| | glass | ITO | | acetone | IPA | | IJ Printing |
| Example 1-72 | oo | o | o | o | o | o | o |
| Example 1-73 | o | oo | oo | oo | oo | oo | o |
| Example 1-74 | oo | oo | oo | oo | oo | oo | o |
| Example 1-75 | oo | o | o | oo | oo | Δ | o |
| Example 1-76 | oo | oo | oo | oo | oo | oo | o |
| Example 1-77 | o | Δ | o | o | oo | oo | o |
| Example 1-78 | oo | oo | oo | oo | oo | oo | o |
| Example 1-79 | oo | oo | oo | oo | oo | oo | o |
| Example 1-80 | Δ | Δ | Δ | Δ | Δ | Δ | o |
| Example 1-81 | o | o | o | o | o | Δ | o |
| Example 1-82 | oo | oo | oo | oo | oo | oo | o |
| Example 1-83 | oo | oo | oo | oo | oo | oo | o |
| Example 1-84 | oo | oo | oo | oo | oo | oo | o |
| Example 1-85 | oo | oo | oo | oo | oo | o | o |
| Example 1-86 | oo | oo | oo | oo | oo | oo | o |
| Example 1-87 | oo | oo | oo | oo | oo | oo | o |
| Example 1-88 | oo | oo | oo | oo | oo | oo | o |
| Example 1-89 | oo | oo | oo | oo | oo | oo | o |
| Example 1-90 | oo | oo | oo | oo | oo | oo | o |
| Example 1-91 | oo | oo | oo | oo | oo | oo | o |
| Comparative Example 1-19 | oo | oo | oo | oo | oo | x | o |
| Comparative Example 1-20 | oo | oo | oo | oo | oo | x | o |
| Comparative Example 1-21 | oo | oo | oo | oo | oo | oo | o |
| Comparative Example 1-22 | oo | oo | oo | oo | oo | x | o |
| Comparative Example 1-23 | oo | oo | oo | oo | oo | x | o |
| Comparative Example 1-24 | oo | oo | oo | oo | oo | x | o |

[Table 22]

| Resin solution | | | A2-1 | A2-2 | A2-3 | A2-4 | A2-5 | A2-6 | A2-7 | A2-8 | A2-9 | A2-10 |
|---|---|---|---|---|---|---|---|---|---|---|---|---|
| Solvent | | PGMEA | 100.0 | 100.0 | 100.0 | 100.0 | 100.0 | 100.0 | 100.0 | 100.0 | 100.0 | 100.0 |
| Process 1 | cyclic skeleton | indene | | | | | | 40.0 | | | | |
| | | DCPMA | | | | | | | 24.0 | | | |
| | | CHMA | 15.9 | 54.4 | 54.4 | 31.3 | | | | | 31.3 | 31.3 |
| | | St | 5.0 | 10.0 | 10.0 | 10.0 | | | | 25.0 | 10.0 | 10.0 |
| | | M-110 | | | | | | | | 30.0 | | |
| | reaction group | HEMA | | 15.0 | 15.0 | 10.0 | 15.0 | | 15.0 | | 10.0 | 10.0 |
| | | MAA | 31.7 | 9.7 | 9.7 | 20.3 | 36.6 | 46.4 | 36.6 | | 20.3 | 20.3 |
| | | GMA | | | | | | | | 30.0 | | |
| | Other | MMA | | | | | 24.0 | 120.0 | | | | |
| | | 2,2'-azobisisobutyronitrile | 3.0 | 3.0 | 3.0 | 9.5 | 3.0 | 5.0 | 3.0 | 4.0 | 17.0 | 1.8 |
| | adding after mixing | 2,2'-azobisisobutyronitrile | 0.5 | 0.5 | 0.5 | 0.5 | 0.5 | 0.5 | 0.5 | 0.2 | 0.5 | 0.2 |
| | | PGMEA | 40.0 | 40.0 | 40.0 | 40.0 | 40.0 | 72.0 | 40.0 | 40.0 | 40.0 | 40.0 |
| Process 2 | modified monomer | GMA | 50.0 | 10.0 | 8.0 | 30.0 | 30.0 | 45.0 | 30.0 | | 30.0 | 30.0 |
| | Other | dimethylbenzylamine | 0.6 | 0.6 | | 0.6 | | 1.0 | 0.6 | | 0.6 | 0.6 |
| | | methoquinone | 0.1 | 0.1 | | 0.1 | | 0.1 | 0.1 | | 0.1 | 0.1 |
| | | PGMEA | 37.0 | 37.0 | | 37.0 | | 100.0 | 37.0 | | 37.0 | 37.0 |
| Reaction temperature (°C) | | | 80 | 80 | | 80 | | 90 | 80 | | 80 | 80 |
| 5% decomposition temperature (°C) | | | 200°Cor more | 200°Cor more | 200°Cor more | 200°Cor more | 200°Cor more | 200°Cor more | 200°Cor more | 200°Cor more | 200°Cor more | 200°Cor more |
| Mass average molecular weight(MW) | | | 18000 | 18000 | 18000 | 6000 | 18000 | 12000 | 15000 | 15000 | 3500 | 30000 |
| Double bond equivalent | | | 292 | 1409 | 1725 | 481 | 500 | 794 | 500 | - | 480 | 480 |
| Acid value | | | - | 24 | 33 | 14 | 114 | 50 | 114 | - | 14 | 14 |

[Table 23-1]

| | Resin (A) | | Light scattering particles (B) | | metallic oxide fine particles (C) | | ethylenically unsaturated monomer (D) | |
|---|---|---|---|---|---|---|---|---|
| | Type | Loads (Note 1) | Type | Loads (Note 1) | Type | Loads (Note 1) | Type | Loads (Note 1) |
| Example 2-1 | A2-1 | 71.0% | B2-1 (Note 2) | 14.0% | - | - | V#802 | 15.0% |
| Example 2-2 | A2-2 | 71.0% | B2-1 (Note 2) | 14.0% | - | - | V#802 | 15.0% |
| Example 2-3 | A2-3 | 71.0% | B2-1 (Note 2) | 14.0% | - | - | V#802 | 15.0% |
| Example 2-4 | A2-4 | 86.0% | B2-1 (Note 2) | 14.0% | - | - | - | - |
| Example 2-5 | A2-4 | 71.0% | B2-1 (Note 2) | 14.0% | - | - | DPCA60 | 15.0% |
| Example 2-6 | A2-4 | 71.0% | B2-1 (Note 2) | 14.0% | - | - | M402 | 15.0% |
| Example 2-7 | A2-4 | 71.0% | B2-1 (Note 2) | 14.0% | - | - | V#802 | 15.0% |
| Example 2-8 | A2-5 | 71.0% | B2-1 (Note 2) | 14.0% | - | - | V#802 | 15.0% |
| Example 2-9 | A2-6 | 71.0% | B2-1 (Note 2) | 14.0% | - | - | V#802 | 15.0% |
| Example 2-10 | A2-7 | 71.0% | B2-1 (Note 2) | 14.0% | - | - | V#802 | 15.0% |
| Example 2-11 | A2-8 | 71.0% | B2-1 (Note 2) | 14.0% | - | - | V#802 | 15.0% |
| Example 2-12 | A2-7 | 52.9% | B2-1 (Note 2) | 14.0% | - | - | V#802 | 15.0% |
| Example 2-13 | A2-7 | 52.9% | B2-1 (Note 2) | 14.0% | - | - | V#802 | 15.0% |
| Example 2-14 | A2-7 | 52.9% | B2-1 (Note 2) | 14.0% | - | - | V#802 | 15.0% |
| Example 2-15 | A2-7 | 2.9% | B2-1 (Note 2) | 14.0% | - | - | V#802 | 15.0% |
| Example 2-16 | A2-7 | 52.9% | B2-1 (Note 2) | 14.0% | | | V#802 | 15.0% |
| Example 2-17 | A2-7 | 52.9% | B2-1 (Note 2) | 14.0% | - | - | V#802 | 15.0% |
| Example 2-18 | A2-7 | 31.8% | B2-2 (Note 2) | 35.1% | - | - | V#802 | 15.0% |
| Example 2-19 | A2-7 | 11.9% | B2-3 | 10.0% | C2-1 (Note 2) | 45.0% | V#802 | 15.0% |
| Example 2-20 | A2-7 | 11.9% | B2-3 | 10.0% | C2-1 (Note 2) | 45.0% | V#802 | 15.0% |

(continued)

| | Resin (A) | | Light scattering particles (B) | | metallic oxide fine particles (C) | | ethylenically unsaturated monomer (D) | |
|---|---|---|---|---|---|---|---|---|
| | Type | Loads (Note 1) | Type | Loads (Note 1) | Type | Loads (Note 1) | Type | Loads (Note 1) |
| Example 2-21 | A2-7 | 52.9% | B2-1 (Note 2) | 10.0% | - | - | V#802 | 15.0% |
| Example 2-22 | A2-7 | 52.9% | B2-1 (Note 2) | 10.0% | - | - | V#802 | 15.0% |
| Comparative Example 2-1 | A2-7 | 85.0% | - | - | - | - | V#802 | 15.0% |
| Comparative Example 2-2 | A2-7 | 82.0% | - | - | - | - | V#802 | 15.0% |
| Comparative Example 2-3 | A2-7 | 75.0% | B 2-3 | 10.0% | - | - | V#802 | 15.0% |
| Comparative Example 2-4 | A2-7 | 56.9% | B2-3 | 10.0% | - | - | V#802 | 15.0% |
| Comparative Example 2-5 | A2-9 | 71.0% | B2-1 (Note 2) | 14.0% | - | - | V#802 | 15.0% |
| Comparative Example 2-6 | A2-10 | 71.0% | B2-1 (Note 2) | 14.0% | - | - | V#802 | 15.0% |
| Note 1) repersenting a ratio of solids in a resin component<br>Note 2)representing a total of scattered fine particles and dispersed resin | | | | | | | | |

[Table 23-2]

| | Silane compound (E) | | | Photopolymerization initiator(F) | | Levening agent | Solids content | Solvent ratio | |
|---|---|---|---|---|---|---|---|---|---|
| | Type | Molecular amount | Loads (Note 1) | Type | Loads (Note 1) | BYK330 | | PGMEA | methyl isobutyl ketone |
| Example 2-1 | - | - | - | - | - | - | 15.0% | 84.8% | 15.2% |
| Example 2-2 | - | - | - | - | - | - | 15.0% | 84.8% | 15.2% |
| Example 2-3 | - | - | - | - | - | - | 15.0% | 84.8% | 15.2% |
| Example 2-4 | - | - | - | - | - | - | 15.0% | 84.8% | 15.2% |
| Example 2-5 | - | - | - | - | - | - | 15.0% | 84.8% | 15.2% |
| Example 2-6 | - | - | - | - | - | - | 15.0% | 84.8% | 15.2% |
| Example 2-7 | - | - | - | - | - | - | 15.0% | 84.8% | 15.2% |
| Example 2-8 | - | - | - | - | - | - | 15.0% | 84.8% | 15.2% |
| Example 2-9 | - | - | - | - | - | - | 15.0% | 84.8% | 15.2% |
| Example 2-10 | - | - | - | - | - | - | 15.0% | 84.8% | 15.2% |
| Example 2-11 | - | - | - | - | - | - | 15.0% | 84.8% | 15.2% |

(continued)

| | Silane compound (E) | | | Photopolymerization initiator(F) | | Levening agent | Solids content | Solvent ratio | |
|---|---|---|---|---|---|---|---|---|---|
| | Type | Molecular amount | Loads (Note 1) | Type | Loads (Note 1) | BYK330 | | PGMEA | methyl isobutyl ketone |
| Example 2-12 | E2-1 | 5500 | 15.0% | Irg907 | 3.0% | 0.1 % | 15.0% | 84.8% | 15.2% |
| Example 2-13 | E2-2 | 520 | 2.5% | Irg907 | 3.0% | 0.1% | 15.0% | 84.8% | 15.2% |
| Example 2-14 | E2-2 | 520 | 15.0% | Irg907 | 3.0% | 0.1% | 15.0% | 84.8% | 15.2% |
| Example 2-15 | E2-2 | 520 | 55.0% | Irg907 | 3.0% | 0.1% | 15.0% | 84.8% | 15.2% |
| Example 2-16 | E2-3 | 280 | 15.0% | Irg907 | 3.0% | 0.1% | 15.0% | 84.8% | 15.2% |
| Example 2-17 | KBM-573 | | 15.0% | Irg907 | 3.0% | 0.1% | 15.0% | 84.8% | 15.2% |
| Example 2-18 | E2-2 | 520 | 15.0% | Irg907 | 3.0% | 0.1% | 15.0% | 62.0% | 38.0% |
| Example 2-19 | E2-2 | 520 | 15.0% | Irg907 | 3.0% | 0.1% | 15.0% | 35.3% | 64.7% |
| Example 2-20 | E2-2 | 520 | 15.0% | Irg907 | 3.0% | 0.1% | 15.0% | 35.3% | 64.7% |
| Example 2-21 | E2-2 | 520 | 15.0% | OXE-01 | 3.0% | 0.1% | 15.0% | 89.2% | 10.8% |
| Example 2-22 | E2-2 | 520 | 15.0% | OXE-02 | 3.0% | 0.1% | 15.0% | 89.2% | 10.8% |
| Comparative Example 2-1 | - | - | - | - | - | - | 15.0% | 100.0% | 0.0% |
| Comparative Example 2-2 | E2-2 | 520 | 15.0% | Irg907 | 3.0% | 0.1% | 15.0% | 100.0% | 0.0% |
| Comparative Example 2-3 | - | - | - | - | - | - | 15.0% | 84.1% | 15.9% |
| Comparative Example 2-4 | E2-2 | 520 | 15.0% | Irg907 | 3.0% | 0.1% | 15.0% | 84.1% | 15.9% |
| Comparative Example 2-5 | - | - | - | - | - | - | 15.0% | 84.8% | 15.2% |
| Comparative Example 2-6 | - | - | - | - | - | - | 15.0% | 84.8% | 15.2% |
| Note 1) repersenting a ratio of solids in a resin component<br>Note 2)representing a total of scattered fine particles and dispersed resin | | | | | | | | | |

[Table 24-1]

| | Refractive index difference | Transmittance | Heat resistance (Transmittance) | Adhesive properties | | Etchant resistance (ITO adhesion) |
|---|---|---|---|---|---|---|
| | | | | glass | ITO | |
| Example 2-1 | o | o | o | o | Δ | o |
| Example 2-2 | o | o | o | o | o | o |
| Example 2-3 | o | o | o | o | Δ | Δ |
| Example 2-4 | o | o | o | Δ | x | Δ |
| Example 2-5 | o | o | o | Δ | Δ | o |
| Example 2-6 | o | o | o | o | o | o |
| Example 2-7 | o | o | o | o | o | o |
| Example 2-8 | o | o | o | o | o | Δ |
| Example 2-9 | o | o | o | o | o | o |
| Example 2-10 | o | o | o | o | o | o |
| Example 2-11 | o | o | x | o | Δ | Δ |
| Example 2-12 | o | o | o | oo | o | o |
| Example 2-13 | o | o | o | o | oo | oo |
| Example 2-14 | o | o | o | oo | oo | oo |
| Example 2-15 | o | x | x | oo | o | o |
| Example 2-16 | o | o | o | oo | oo | oo |
| Example 2-17 | o | o | o | o | Δ | o |
| Example 2-18 | o | o | o | oo | oo | oo |
| Example 2-19 | o | o | o | oo | oo | oo |
| Example 2-20 | o | o | o | oo | oo | oo |
| Example 2-21 | o | o | o | oo | oo | oo |
| Example 2-22 | o | o | o | oo | oo | oo |
| Comparative Example 2-1 | x | o | o | o | o | o |
| Comparative Example 2-2 | x | o | o | oo | oo | oo |
| Comparative Example 2-3 | x | o | o | o | o | o |
| Comparative Example 2-4 | x | o | o | oo | oo | oo |
| Comparative Example 2-5 | o | o | o | x | x | x |
| Comparative Example 2-6 | o | x | x | o | Δ | o |

[Table 24-2]

| | Chemical resistance | | Evenness | Development rate | Evaluation of emission device | |
|---|---|---|---|---|---|---|
| | acetone | IPA | | | Extraction efficiency | Emission appearance |
| Example 2-1 | o | o | oo | o | o | Δ |
| Example 2-2 | o | o | oo | Δ | oo | o |
| Example 2-3 | Δ | Δ | oo | o | o | Δ |
| Example 2-4 | Δ | Δ | oo | x | oo | o |
| Example 2-5 | Δ | Δ | oo | Δ | oo | o |
| Example 2-6 | o | o | oo | Δ | oo | o |
| Example 2-7 | o | o | oo | Δ | oo | o |
| Example 2-8 | o | o | oo | o | oo | o |
| Example 2-9 | o | o | oo | o | oo | o |
| Example 2-10 | o | o | oo | o | oo | o |
| Example 2-11 | o | o | Δ | o | o | Δ |
| Example 2-12 | o | o | o | o | oo | o |
| Example 2-13 | oo | oo | oo | o | oo | o |
| Example 2-14 | oo | oo | oo | o | oo | o |
| Example 2-15 | oo | oo | x | x | oo | o |
| Example 2-16 | oo | oo | oo | o | oo | o |
| Example 2-17 | o | oo | oo | o | oo | o |
| Example 2-18 | oo | oo | oo | o | oo | o |
| Example 2-19 | oo | oo | oo | o | oo | o |
| Example 2-20 | oo | oo | oo | o | oo | o |
| Example 2-21 | oo | oo | oo | o | oo | o |
| Example 2-22 | oo | oo | oo | o | oo | o |
| Comparative Example 2-1 | o | o | oo | o | Δ | o |
| Comparative Example 2-2 | oo | oo | oo | o | Δ | o |
| Comparative Example 2-3 | o | o | oo | o | Δ | o |
| Comparative Example 2-4 | oo | oo | oo | o | Δ | o |
| Comparative Example 2-5 | x | x | Δ | Δ | unmeasurable | unmeasurable |
| Comparative Example 2-6 | Δ | o | x | Δ | Δ | x |

From the invention thus described, it will be obvious that the embodiments of the invention may be varied in many ways. Such variations are not to be regarded as a departure from the spirit and scope of the invention, and all such modifications as would be obvious to one skilled in the art are intended for inclusion within the scope of the following claims.

**Claims**

1. A resin composition for light scattering layer for use in forming a light scattering layer of an organic electroluminescence device, comprising:

    a binder composition including at least one type of resin (A); and
    light scattering particles (B), wherein
    the light scattering particles (B) have an average particle diameter of 200 nm to 500 nm in the resin composition for light scattering layer, and have a content of 20 vol% or less of particles with a particle diameter of 600 nm or more with respect to a total amount of the light scattering particles (B), and
    a refractive index difference between the binder composition and the light scattering particles (B) is 0.1 or more.

2. A resin composition for light scattering layer for use in forming a light scattering layer of an organic electroluminescence device, comprising:

    a binder composition including at least one type of resin (A); and
    light scattering particles (B), wherein
    the resin (A) includes a double bond and/or a cross-linkable group, and has a mass average molecular weight (Mw) of equal to or more than 5000 and less than 20000,
    the light scattering particles (B) have an average particle diameter of 200 nm to 1.0 μm in the resin composition for light scattering layer, and
    a refractive index between the binder composition and the light scattering particles (B) is 0.1 or more.

3. The resin composition for light scattering layer according to Claim 1 or 2, wherein the binder composition has a refractive index of 1.65 or more.

4. The resin composition for light scattering layer according to Claim 1 or 2, wherein the binder composition further includes metallic oxide fine particles (C) having an average primary particle diameter of 100 nm or less.

5. The resin composition for light scattering layer according to Claim 4, wherein the metallic oxide fine particles (C) include at least one type of metallic oxide fine particles selected from the group consisting of $ZrO_2$ and $TiO_2$.

6. The resin composition for light scattering layer according to Claim 1 or 2, wherein the light scattering particles (B) have a coefficient of variation of 30% or less.

7. The resin composition for light scattering layer according to Claim 1 or 2, wherein the resin (A) has a double bond equivalent of 400 g/mol to 1600 g/mol.

8. The resin composition for light scattering layer according to Claim 1 or 2, wherein the resin (A) includes a cyclic skeleton in a main chain and/or a side chain.

9. The resin composition for light scattering layer according to Claim 1 or 2, wherein the resin (A) includes an alkali-soluble group.

10. The resin composition for light scattering layer according to Claim 1 or 2, wherein the binder composition further includes an ethylenically unsaturated monomer (D) having a double bond equivalent of 80 g/mol to 140 g/mol.

11. The resin composition for light scattering layer according to Claim 1 or 2, wherein the binder composition further includes a silane compound (E) represented by the following general formula (1), the silane compound (E) including one of a urethane skeleton and an amide skeleton :

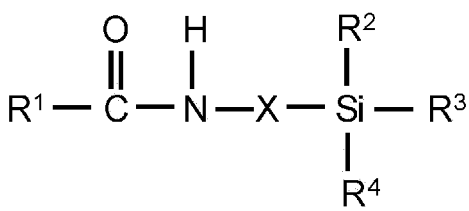

(1)

wherein in the general formula (1):

- $R^1$ represents one of an alkoxy group having a carbon number of 1 to 20, an aryloxy group having a carbon number of 6 to 20, an alkyl group having a carbon number of 1 to 20, an aryl group having a carbon number of 6 to 20, an aralkyl group having a carbon number of 7 to 30, and an alkaryl group having a carbon number of 7 to 30;
- X represents one of an alkylene group having a carbon number of 1 to 20, an arylene group having a carbon number of 1 to 20, and an alkoxylene group having a carbon number of 1 to 20; and
- $R^2$, $R^3$, and $R^4$ are independent from each other and represent one of an alkoxy group having a carbon number of 1 to 20, an aryloxy group having a carbon number of 6 to 20, an alkyl group having a carbon number of 1 to 20, an aryl group having a carbon number of 6 to 20, an aralkyl group having a carbon number of 7 to 30, an alkaryl group having a carbon number of 7 to 30, a siloxane group including a substituent, a halogen atom, a hydroxy group, and a hydrogen atom.

**12.** The resin composition for light scattering layer according to Claim 11, wherein the silane compound (E) has a mass average molecular weight (Mw) of equal to or more than 200 and less than 5000, and has a content of equal to or more than 3 mass% and less than 50 mass% in 100% by mass of total solids of the resin composition for light scattering layer.

**13.** The resin composition for light scattering layer according to Claim 1 or 2, wherein the binder composition further includes an oxime ester-based photopolymerization initiator (F).

**14.** A light scattering layer formed using a resin composition for light scattering layer according to Claim 1 or 2.

**15.** An organic electroluminescence device including a light scattering layer according to Claim 14.

**16.** The organic electroluminescence device according to Claim 15, wherein the organic electroluminescence device is one of a lighting device and a display device.

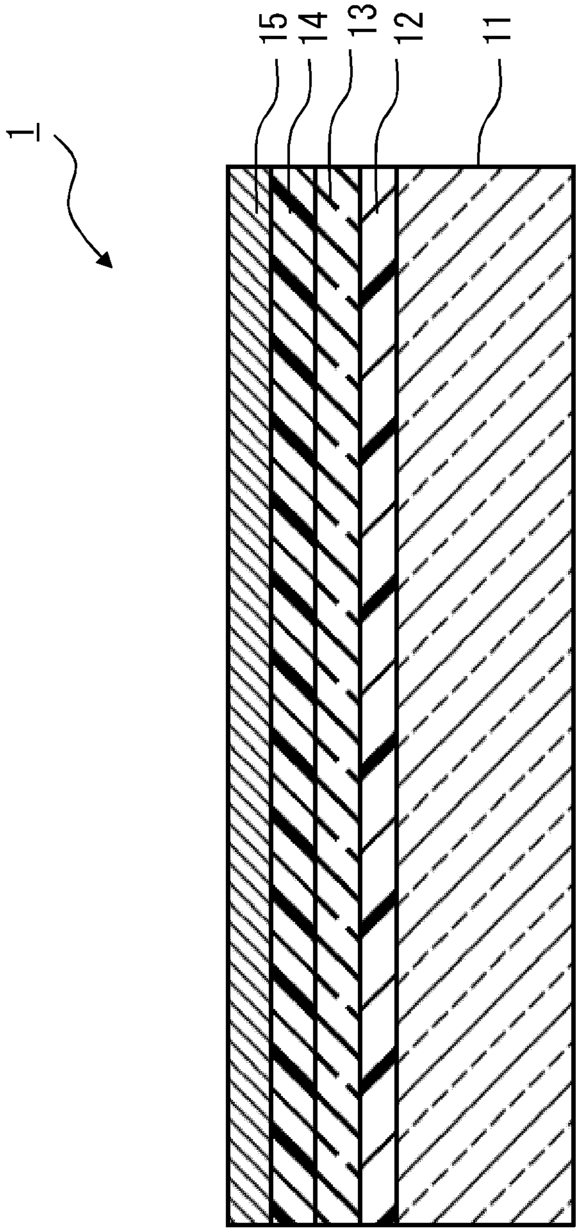


Fig. 1

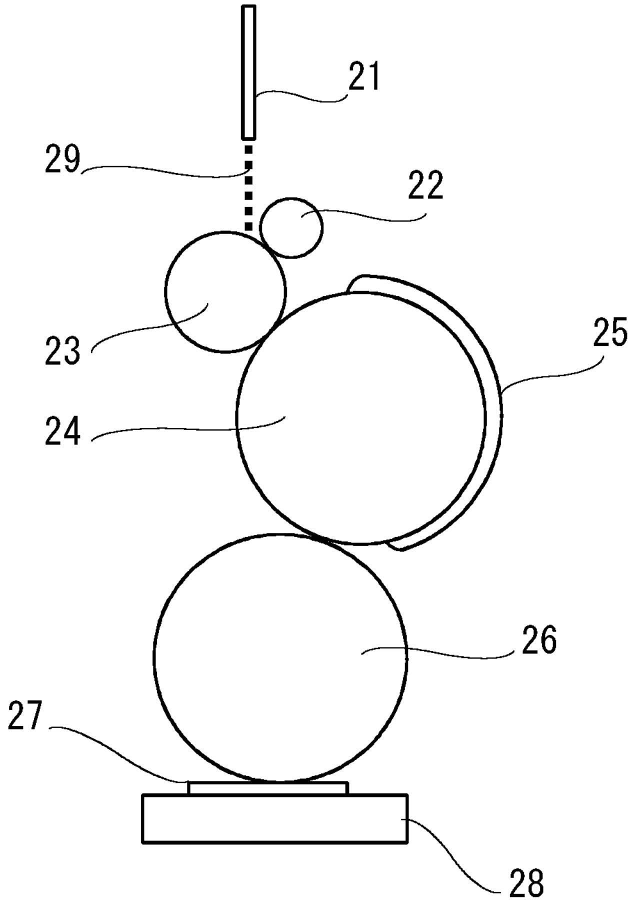


Fig. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012132439 A
- JP 2004296429 A
- JP 2005190931 A
- JP 2009 A
- JP 110930 A
- JP 2004 A
- JP 296429 A
- JP 2009110930 A
- JP 2007109575 A
- EP 0390551 A
- JP 2220390 A
- JP 2216790 A
- JP 4051491 A
- JP 6207170 A
- JP 7142169 A
- JP 3933591 B